(19) Europäisches Patentamt
European Patent Office
Office européen des brevets

(11) **EP 2 278 047 A1**

(12) **EUROPEAN PATENT APPLICATION**

(43) Date of publication:
**26.01.2011 Bulletin 2011/04**

(51) Int Cl.:
*C23C 16/54* (2006.01)        *C23C 16/50* (2006.01)
*H01J 37/32* (2006.01)        *B65H 23/24* (2006.01)

(21) Application number: **10166425.8**

(22) Date of filing: **17.08.2006**

(84) Designated Contracting States:
**DE FR GB**

(30) Priority: **31.08.2005   JP 2005251013**
             **31.08.2005   JP 2005251014**
             **15.12.2005   JP 2005361625**

(62) Document number(s) of the earlier application(s) in accordance with Art. 76 EPC:
**06796496.5 / 1 921 180**

(27) Previously filed application:
**17.08.2006 PCT/JP2006/316139**

(71) Applicant: **Konica Minolta Holdings, Inc.**
**Tokyo 100-0005 (JP)**

(72) Inventors:
• **Ozaki, Koji**
  **Hino-shi Tokyo 191-8511 (JP)**
• **Fukuda, Kazuhiro**
  **Hino-shi Tokyo 191-8511 (JP)**
• **Arita, Hiroaki**
  **Hino-shi Tokyo 191-8511 (JP)**

(74) Representative: **Henkel, Feiler & Hänzel**
**Patentanwälte**
**Maximiliansplatz 21**
**80333 München (DE)**

Remarks:
This application was filed on 17-06-2010 as a divisional application to the application mentioned under INID code 62.

(54) **Plasma discharge treatment apparatus, and method of manufacturing gas barrier film**

(57)     Provide is a method of preparing a highly-functional film capable of reducing surface failure and of improving the yield, and a manufacturing apparatus thereof. This is a plasma discharge treatment apparatus to plasma-discharge-treat for the surface of a substrate conveyed between a winder and an unwinder at atmospheric pressure or approximately atmospheric pressure, and is a plasma discharge treatment apparatus by which the substrate is conveyed with no contact by only nip roller separating the discharge section from outside. Provided is a method of preparing a gas barrier film exhibiting high gas barrier, together with reduction of surface failure (crack failure) during gas barrier thin layer formation. The surface on the gas barrier thin layer side of the gas barrier film has a curvature radius of at least 75 mm during conveyance, and the surface on the opposite side has a curvature radius of at least 37.5 mm.

FIG. 3

EP 2 278 047 A1

**Description**

**TECHNICAL FIELD**

The present invention relates to a plasma discharge treatment method and an apparatus thereof to form a thin layer first on the substrate via plasma discharge treatment and to conduct a substrate surface-modifying treatment, and specifically to a plasma discharge treatment method and a plasma discharge treatment apparatus suitable for preparing highly-functional film substrates utilized for displays such as a liquid crystal display, an organic electroluminescence display, a plasma display and so forth by forming a thin layer specifically on a long length substrate film and conducting a surface-modifying treatment with no performance degradation generated by defects caused by surface scratches and pressure. Further, the present invention relates to a method of manufacturing a gas barrier film exhibiting high gas barrier, together with reduction of surface failure (crack failure) during gas barrier thin layer formation in preparation of the gas barrier film obtained by forming a gas barrier thin layer on a substrate film among the highly-functional films employing a plasma discharge treatment method.

**BACKGROUND**

The prior art relating to a plasma discharge treatment method and a plasma discharge treatment apparatus (and the configuration) suitable for preparing the highly-functional film substrate will be first described.

In recent years, displays such as a liquid crystal image display device display, an organic electroluminescence display, a plasma display and so forth have become large-sized, supplying a large amount of such the highly-functional film at low cost into the market has been demanded since a consumption amount of the highly-functional film has increased, and these films have become diversified.

In a conventional method, a substrate film is first prepare to arrange a stock roll, and this stock roll is rolled out to form desired thin layers on the substrate film. Further, after conducting a surface treatment, repetitive conveyance of the substrate is made in the production line in the case of formation of a multilayered highly-functional film. As to a plasma discharge treatment apparatus, a number of guide rollers are usually installed in the production line, and rollers such as dancer rollers and EPC rollers are brought into contact with the film forming surface and the substrate surface-modified surface (refer to Patent Document 1, for example). In this case, fine scratches caused by the foregoing contact are generated, whereby the yield is presently lowered.

Next, a gas barrier film possessing gas barrier thin layers provided on the substrate film and a preparation method thereof will be secondly described.

The gas barrier film comprising a thin layer made of metal oxide such as aluminum oxide, magnesium oxide or silicon oxide provided on the surface of a plastic substrate or film has been widely utilized for packaging application in order to pack goods for the purpose of separation from various gases such as water vapor, oxygen and so forth, and to prevent quality degradation in food products, industrial goods, medicines and so forth. The gas barrier film is further utilized for other applications of liquid crystal display elements, solar batteries, organic electroluminescence (EL) substrates and so forth.

Aluminum foils have been widely utilized as the packaging material in such the fields, but in addition to a problem of disposal after use, it is not basically transparent, and there is another problem such that no content can be observed from the outside. In the case of display material for which transparency is demanded, no aluminum foils can be employed.

On the other hand, a resin film made of a vinylidene chloride resin or a copolymer resin formed from vinylidene chloride and another polymer, or a material exhibiting gas barrier obtained by coating a vinylidene chloride based resin onto a polypropylene resin, a polyester resin or a polyamide resin has been widely utilized as the packaging material, but there presently appears a problem in view of environmental conservation since chlorine based gas is generated in the course of incineration disposal. However, gas barrier ability has been insufficient yet, and can not be applied for fields demanding a high level of gas barrier.

Film substrates such as transparent plastic films in place of a heavy and fragile glass substrate which is difficult to be large-sized are being employed for the transparent resin film applied specifically for a liquid crystal display element, an organic electroluminescence (hereinafter, referred to also as organic EL) element and so forth, since not only a high degree of freedom in long duration reliability as well as shape is demanded, but also possibility of curvature display is demanded in addition to recent demand of reduction in size, together with a larger size trend. Examples in which a polymer film is utilized as a substrate for an organic EL element are disclosed in Japanese Patent O.P.I. Publication No. 2-251429 and Japanese Patent O.P.I. Publication No. 2-251429, for example.

However, there is a problem such that a film substrate such as a transparent plastic film exhibits inferior gas barrier to that of a glass substrate. When a substrate exhibiting inferior gas barrier is employed as a substrate for an organic EL element, an organic layer is degraded because of permeation of water vapor and the air, resulting in deterioration of emission characteristics, durability and so forth. Further, when a polymer substrate is employed as a substrate for electronic devices, also produced is a problem such that oxygen permeates the polymer substrate, and penetrates into the inside of the electronic device to diffuse it, whereby the device is deteriorated, and a vacuum degree desired in the inside of the device can not be maintained.

In order to solve such the problem, it is known that a metal oxide thin film is formed on a film substrate to prepare a gas barrier film substrate. A method of evaporating silicon oxide onto a plastic film as a gas barrier film utilized for a packaging material and a liquid crystal display element is disclosed (refer to Patent Document 2, for example), and a method of evaporating aluminum oxide is disclosed (refer to Patent Document 3, for example), but presently, any of them can not produce a value better than a water vapor barrier level of 2 $g/m^2/day$ (JIS K 7129: 240 °C and 90%RH) or a oxygen barrier level of 2 $ml/m^2/day/atm$ (JIS K 7129: 240 °C and 90%RH). Recently, a water vapor barrier level of $10^{-3}$ $g/m^2/day$ as barrier performance to a film substrate has increasingly been demanded, since organic EL displays with higher gas barrier together with large-sized liquid crystal displays, high-definition displays and so forth are developed.

As a method to satisfy the demand of such the high water vapor barrier, disclosed is a gas barrier film prepared by alternately laminating a dense ceramic layer, and a flexible polymer layer exhibiting relaxation against impact from the outside (refer to Patent Document 4, for example).

However, when gas barrier thin layers composed of an adhesion layer, a ceramic layer and a protective layer, for example, are multilayered on a flexible plastic film, cracks and fracture of thin layers tend to be generated during conveyance in the case of a low flexible layer comparatively brittle against stress among the formed layers. The reason is as follows. When a plastic film on which a gas barrier layer exhibiting the foregoing comparatively brittle property is conveyed, and a support roller (referred to also as a guide roller) by which the plastic film is supported and conveyed is a roller having small curvature radius (R) (that is, a roller having a small diameter), the plastic film brought into contact with this roller undergoes tensile stress and compression. As the result, cracks and fracture of the thin layer are generated in comparatively brittle gas barrier layers formed on the plastic film, whereby it is clearly confirmed that the gas barrier property largely drops. Thus, prompt attention and improvement have presently been demanded.

Patent Document 1: Japanese Patent O.P.I. Publication No. 2003-171770
Patent Document 2: Japanese Patent Examined Publication No. 53-12953 (Examples)
Patent Document 3: Japanese Patent O.P.I. Publication No. 58-217344 (Examples)
Patent Document 4: U.S. Patent No. 6,268,695 specification (claims 1, and 2-54 through 3-26)

## DISCLOSURE OF THE INVENTION PROBLEMS TO BE SOLVED BY THE INVENTION

Concerning the first object described above, conventional production of highly-functional films produces some problems such as cost mass-production, quality and so forth since a number of guide rollers brought into contact with the film forming surface and the surface-modified surface are used, and it is in the present situation that simplification of the production system, increase of the yield, cost reduction and improvement of quality are to be demanded.

The present invention is made on the basis of the above-described situation. The first object of the present invention is to provide a method of preparing a highly-functional film via plasma discharge treatment and a manufacturing apparatus, capable of reducing surface failure originated by generation of fine scratches caused by being in contact with the substrate surface, of improving the yield, and of reducing cost by simplifying the production system so as to give a minimum number of rollers brought into contact with the film forming surface and the surface-modified surface in preparation of the highly-functional films.

Further, the second object of the present invention has been made on the basis of the second background, and is to provide a method of preparing a gas barrier film exhibiting high gas barrier, together with reduction of surface failure (crack failure) during gas barrier thin layer formation.

## MEANS TO SOLVE THE PROBLEMS

In this way, as for a method of preparing a high-function film via surface treatment of a substrate, a plasma discharge treatment apparatus capable of reducing the surface failure, together with a method of preparing a gas barrier film exhibiting reduction of the surface failure is provided via the present invention.

The first object of the present invention is accomplished by the following structures 1 - 10, and the second object of the present invention is also accomplished by the following structures 11 - 15.

(Structure 1) A plasma discharge treatment apparatus by which a surface of a substrate continuously conveyed between a winder (roll-up shaft) and an unwinder (roll-out shaft) is plasma-discharge-treated at atmospheric pressure or approximately atmospheric pressure, comprising two facing electrodes, at least one of which is a cylindrical electrode; at least two nip rollers fitted with the cylindrical electrode as a back-up roller; a discharge section formed between the two nip rollers and also between the two facing electrodes; a device of supplying a reactive gas at atmospheric pressure or approximately atmospheric pressure, fitted into the discharge section; a device of emitting an exhaust gas after treatment; and a device of applying a voltage between the two facing electrodes, the plasma discharge treatment apparatus comprising the steps of: supplying a reactive gas with the device of supplying the reactive gas in the discharge section; applying a voltage between the two facing electrodes to generate plasma discharge; and conducting a plasma discharge treatment onto a substrate surface passing through the discharge section, being brought into contact with the cylindrical electrode, wherein rollers brought into contact with the treated substrate surface, and provided between the winder and the unwinder consist of nip rollers provided on the cylindrical electrode.

(Structure 2) The plasma discharge treatment apparatus of Structure 1, wherein a cleaning roller is placed outside a region constituting the discharge section so as to be brought into contact with the cylindrical electrode.

(Structure 3) The plasma discharge treatment apparatus of Structure 1 or 2, further comprising an EPC (edge position control) sensor.

(Structure 4) The plasma discharge treatment apparatus of any one of Structures 1 - 3, comprising the winder and the unwinder capable of serving oppositely as a unwinder and a winder, respectively, of conveying the substrate in a reverse direction, and of continuously conducting plasma discharge treatment in a reciprocating manner by rolling out the rolled-up substrate again without removing the substrate.

(Structure 5) The plasma discharge treatment apparatus of any one of Structures 1 - 4, wherein the winder and the unwinder are directly torque-controlled.

(Structure 6) The plasma discharge treatment apparatus of any one of Structures 1 - 5, wherein a residual heat zone is provided before introducing the substrate into the discharge section.

(Structure 7) A plasma discharge treatment apparatus by which a surface of a continuously conveyed substrate is plasma-discharge-treated at atmospheric pressure or approximately atmospheric pressure, comprising a pair of facing electrodes and a discharge section formed between the facing electrodes, the plasma discharge treatment apparatus also comprising a turned-back conveyance device by which after the substrate passes through the discharge section while the substrate is brought into contact with one electrode of the facing electrodes to conduct plasma discharge treatment in the discharge section, the substrate is conveyed into the discharge section again while the substrate is brought into contact with the other electrode of the facing electrodes to conduct plasma discharge treatment; a device of supplying a reactive gas to the substrate passing through the discharge section in a reciprocating manner at atmospheric pressure or approximately atmospheric pressure; a device of emitting an exhaust gas after treatment; and a device of applying a voltage between the facing electrodes to generate plasma discharge, wherein the turned-back conveyance device is composed of a non-contact conveyance system supporting a continuously running web by blowing gas from a blowing outlet.

(Structure 8) A plasma discharge treatment apparatus by which a surface of a continuously conveyed substrate is plasma-discharge-treated at atmospheric pressure or approximately atmospheric pressure, comprising a plurality of pairs of facing electrodes and a plurality of discharge sections each formed between the facing electrodes each, the plasma discharge treatment apparatus also comprising a plurality of turned-back conveyance devices each by which after the substrate passes through each of the discharge sections while the substrate is brought into contact with one electrode of the facing electrodes each to conduct plasma discharge treatment in a plurality of the discharge sections, the substrate is conveyed into each of the discharge sections again while the substrate is brought into contact with the other electrode of the facing electrodes each to conduct plasma discharge treatment; each device of supplying a reactive gas into a space sandwiched by the substrate passing through each of the discharge sections in a reciprocating manner at atmospheric pressure or approximately atmospheric pressure; each device of emitting an exhaust gas after treatment; and each device of applying a voltage between the facing electrodes each to generate plasma discharge, wherein each of the turned-back conveyance devices is composed of a non-contact conveyance system supporting a continuously running web by blowing gas from a blowing outlet.

(Structure 9) A plasma discharge treatment apparatus by which a surface of a continuously conveyed substrate is plasma-discharge-treated at atmospheric pressure or approximately atmospheric pressure, equipped with a pair of facing electrodes and a discharge section formed between the facing electrodes, the plasma discharge treatment apparatus also comprising a turned-back conveyance device by which after the substrate passes through the discharge section while the substrate is brought into contact with one electrode of the facing electrodes to conduct plasma discharge treatment in the discharge section, the substrate is conveyed into the discharge section again while the substrate is brought into contact with the other electrode of the facing electrodes to conduct plasma discharge treatment; a device of supplying a reactive gas into a space sandwiched by the substrate passing through the discharge section in a reciprocating manner at atmospheric pressure or approximately atmospheric pressure; a device of emitting an exhaust gas after treatment; and a device of applying a voltage between the facing electrodes to generate plasma discharge, wherein the turned-back conveyance device is composed of a non-contact conveyance system supporting a continuously running web by blowing gas from a blowing outlet.

(Structure 10) The plasma discharge treatment apparatus of any one of Structures 1 - 9, wherein the facing electrodes are rotatable roll electrodes.

(Structure 11) A method of manufacturing a gas barrier film comprising a continuously conveyed resin film with a curvature and provided thereon, a gas barrier thin layer formed via a plasma CVD method, wherein surface A on the gas barrier thin layer side of the resin film has a curvature radius of at least 75 mm during conveyance, and surface B on an opposite side of the surface A, on which no gas barrier thin layer is formed, has a curvature radius of at least 37.5 mm.

(Structure 12) The method of Structure 11, wherein the gas barrier thin layers are an adhesion layer, a ceramic layer and a protective layer provided in this order from the resin film side.

(Structure 13) The method of Structure 11 or 12, wherein silicon oxide, the ceramic layer is formed from silicon oxide, silicon oxide nitride, silicon nitride, aluminum oxide or a mixture thereof.

(Structure 14) The method of any one of Structures 11 - 13, wherein the plasma CVD method comprises the steps of supplying gas containing a gas barrier thin film forming gas and a discharge gas into a discharge space at atmospheric pressure and approximately atmospheric pressure, applying a high frequency electric field in the discharge space to excite the gas, and exposing the resin film to the excited gas to form the gas barrier thin layer on the resin film.

(Structure 15) The method of manufacturing a gas barrier film of any one of Structures 11 - 14, wherein the resin film has a conveyance tension of not less than 50 N/m and not more than 200 N/m, when the resin film is continuously conveyed.

## EFFECT OF THE INVENTION

The first object according to the foregoing Structures 1 - 10 of the present invention is to provide a manufacturing apparatus by which obtained can be a highly-functional film advantageous over before in view of cost, mass-production and quality, since the production system is simplified so as to use the minimum number of rollers brought into contact with the film forming surface, and the yield is improved because of reduction of scratches and defects on the film forming surface or the surface-modified surface.

Further, the second object according to the foregoing Structures 11 - 15 of the present invention is to provide a method of preparing a gas barrier film exhibiting high gas barrier, together with reduction of surface failure (crack failure) during gas barrier thin layer formation.

## BRIEF DESCRIPTION OF THE DRAWINGS

Fig. 1 is a schematic diagram showing one example of the atmospheric plasma treatment apparatus of the present invention.

Fig. 2 is a schematic diagram showing another example of the atmospheric plasma treatment apparatus of the present invention.

Fig. 3 is a schematic diagram showing one example of a plasma discharge treatment process.

Fig. 4 is a schematic diagram showing one example of a plasma discharge treatment process with a plasma discharge treatment apparatus of the present invention.

Fig. 5 is a schematic diagram showing another example of a plasma discharge treatment process with a plasma discharge treatment apparatus of the present invention.

Fig. 6 is a schematic diagram showing one example of a plasma discharge treatment apparatus of the present invention comprising a rotatable roll electrode and a facing prismatic electrode.

Fig. 7 is a schematic diagram showing an example of a production line of a gas barrier film prepared via a batch method in the present invention.

Fig. 8 is a schematic diagram showing one example of a production line of a gas barrier film fitted with a plurality of thin film forming stations employing an online system.

Fig. 9 is a schematic diagram showing another example of a production line of a gas barrier film fitted with a plurality of thin film forming stations employing an online system.

Fig. 10 is a schematic diagram showing one example of the atmospheric pressure plasma discharge treatment apparatus employing a jet process useful for the present invention.

Fig. 11 is a schematic diagram showing one example of a atmospheric pressure plasma discharge treatment apparatus with a contact conveyance system, employing a process treating a substrate at a space between electrodes facing to each other useful for the present invention.

Fig. 12 is a schematic diagram showing one example of a atmospheric pressure plasma discharge treatment apparatus with a non-contact conveyance system, employing a process treating a substrate at a space between electrodes facing to each other useful for the present invention.

Fig. 13 is a perspective view showing one example of a structure comprising a conductive metal base material of a rotatable roll electrode and coated thereon, a dielectric as shown in Fig. 5 and Fig. 6.

Fig. 14 is a perspective view showing one example of a structure comprising a conductive metal base material of a prismatic electrode and coated thereon, a dielectric.

**EXPLANATION OF NUMERALS**

71 Stock roll
72 Heating member
72' Residual heat zone
73 Cylindrical electrode
74, 74' Electrode
75, 78 Nip roller
76, 79 Partition
100 Discharge section
711 Gas supply opening
712 Exhaust outlet
713 Tension meter
714 EPC sensor
715 Rubber roller
716 Adhesion roller
700 Unwinder (roll-out shaft)
701 Winder (roll-up shaft)
720 Voltage application unit F Substrate
G Reactive gas
G° Gas in a plasma state
G' Gas after treatment
10A, 10B, 10C, 10D, 10E, 10F Roll electrode 10a, 10b, 10c Prismatic electrode
811A, 811B, 811C, 811D Turned-back roller (U-turn roller)
14, 14A, 14B Non-contact conveyance system 200, 210 Nip roller
30, 30A, 30B, 30C Reactive gas supply portion 40, 40A, 40B, 40C Exhaust outlet
80 Power supply
91 First electrode
92 Second electrode
93, 94 Filter
81, 82 Voltage supply unit
100, 100A, 100B, 100C discharge section
2 Stock roll
5 Roll-up roll
AR1 - AR7 Guide roller AR (roller brought into contact with the surface)
BR1 - BR3 Guide roller BR (roller brought into contact with the back surface)
CS1, CS2, CS3, 10 Atmospheric pressure plasma discharge treatment apparatus
11 first electrode
12 Second electrode
21 First power supply
22 Second power supply
300 Plasma discharge treatment apparatus
32 Discharge space
35 Rotatable roll electrode
35a Roll electrode
35A Metal base material
35B Dielectric
36 A group of prismatic fixed electrodes
400 Electric field application unit
41, 410 First power supply
42, 420 Second power supply
43 First filter
44 Second filter
500 Gas supply unit

51 Gas generation unit
52 Gas supply opening
53 Exhaust outlet
600 Electrode temperature adjustment unit

## DESCRIPTION OF THE PREFERRED EMBODIMENTS

The preferred embodiments of the present invention will be explained below, but the present invention is not limited thereto.

A plasma discharge treatment apparatus according to any one of Structures 1 - 6 will be first described.

Preparation of a substrate with a functional thin layer by surface-modifying a substrate rolled out from a stock roll in the form of a rolled-up roll via an atmospheric pressure plasma treatment, or by forming a functional thin layer on the substrate can be applied for various embodiments in order to prepare an anti-glare film, an antireflection film, a gas barrier film and so forth. In this production line, desired rollers such as a dancer roller to adjust tension and an EPC roller to detect the film edge, together with a number of guide rollers, for examples, are installed, and these rollers are frequently brought into contact with the film forming surface of the substrate and the surface-modified surface in order to conduct a preceding treatment of the treated substrate, or to smoothly conduct various additional (and inevitable) processes such as drying and the like up to the roll-up process after treatment in a limited space.

The plasma discharge treatment apparatus according to any one of Structures 1 - 6 of the present invention is a plasma discharge treatment apparatus in which all the rollers except nip rollers are eliminated as rollers brought into contact with the film forming surface and the surface-modified surface in this way, and the foregoing nip rollers are only rollers brought into contact with the film forming surface.

The material quality of a nip roller is not specifically limited, but one in which the surface of a functional thin film prepared on a treated substrate or a substrate is difficult to be scratched is preferable. Hard rubber, plastics and so forth are preferable, and specifically, a roller made of rubber or plastic having a rubber hardness of 60 - 80 in accordance with is preferable.

The atmospheric pressure plasma treatment means that thin film formation or surface modification is conducted on the substrate by introducing a thin film forming gas or a treatment gas into a discharge space formed from the first electrode and the second electrode facing each other under atmospheric pressure or approximately atmospheric pressure, by exciting the thin film forming gas or the treatment gas via application of an electric field, and by exposing the substrate to the excited thin film forming gas.

A noble gas as a discharge gas or an organometallic compound accompanied with this gas is contained in the thin film forming gas, the resulting gas is introduced into the discharge space formed from the first electrode and the second electrode facing each other, high frequency potential is applied between the first electrode and the second electrode to excite the thin film forming gas, and the substrate film is exposed to the excited thin film forming gas, whereby a ceramic thin film made of silicon dioxide is formed on the substrate.

"Under atmospheric pressure or approximately atmospheric pressure" means "under a pressure of 20 - 200 kPa". Further, the pressure between which voltage is applied is preferably a pressure of 70 - 140 kPa. In order to obtain the effects as described in the present invention, the above pressure is preferably 93 - 104 kPa. Thin films exhibiting various properties can be formed on the substrate film by varying the introduced thin film forming gas or the reactive gas under such the pressure condition. Further, surface modification of the substrate film can be simply conducted employing a treatment gas.

The plasma discharge treatment will be described in detail, but the plasma discharge treatment apparatus according to any one of Structures 1 - 6 of the present invention will be specifically described below referring to figures.

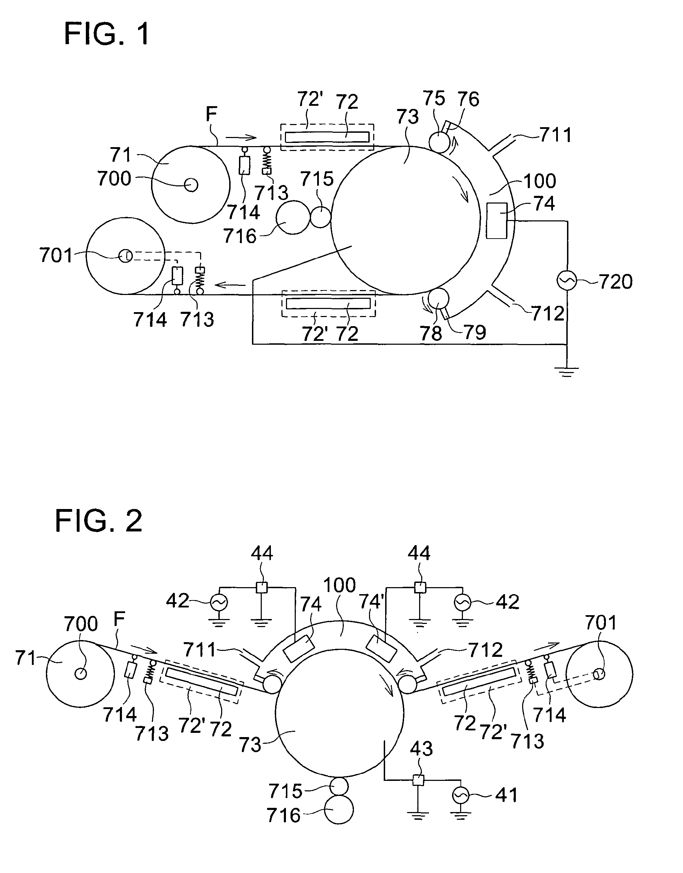

Fig. 1 is a schematic diagram showing one example of the atmospheric plasma treatment apparatus according to any one of Structures 1 - 6 of the present invention.

In an atmospheric plasma discharge treatment apparatus of the present invention, a substrate is transferred from or stock roll 71 wound with a shaft fitted into unwinder 700, and enters discharge section 100 after passing through residual heat zone 72' to heat the substrate film in advance with heating member 72 placed facing against the substrate.

In the preferred embodiment, residual heat zone 72' is provided before introducing the substrate film into the discharge section. It is desired to avoid construction and deformation of the substrate caused by rapid increase of temperature by providing the residual heat zone in advance before introducing the substrate film into the discharge section, since the substrate film is subjected to plasma discharge treatment in discharge section 100, maintaining a temperature at 90 - 200 °C, and preferably at 100 - 150 °C. In addition, stock roll 71 may further be heated, if desired, in order to set the temperature in the residual heat zone (residual heat section) to be a temperature of the substrate film in the discharge section as closely as possible.

As heating member 72 to heat the substrate in the residual heat zone, a plate-like electric heater sandwiched by mica, a ceramic heater or a sheathed heater is preferably employed, placed in a given spacing (0.5 - 5 mm) so as to heat the substrate film via radiation heat before the foregoing discharge section and not to touch it directly, and preferably equipped with a temperature control mechanism.

Discharge section 100 is present between two nip rollers 75 and 78 placed on cylindrical electrode 73, and is formed from the space between cylindrical electrode 73 and electrode 74 facing cylindrical electrode 73 (herein, rectangular-shaped). It is separated by nip roller 75 and partition 76 on the conveyance roll-in side of a substrate as the cylindrical electrode for a back-up roller, and also separated by nip roller 78 and partition 79 on the conveyance roll-our side. Substrate F is transported into the discharge section via rotation of the cylindrical electrode while being in contact with it. Numerals 711 and 712 represent reactive gas supply opening (supply unit) and exhaust gas outlet after treatment (exhaust unit), respectively. High frequency voltage is applied between the foregoing first and second electrodes, that is, between cylindrical electrode 73 and electrode 74 facing cylindrical electrode 73 employing voltage application unit 720 to generate plasma discharge in the discharge section between electrodes while supplying the reactive gas (thin film forming gas or treatment gas) from the reactive gas supply opening, whereby thin film formation is conducted on the surface of a substrate film transported on cylindrical electrode 73, or surface-modifying treatment is conducted. The exhaust gas after treatment is removed from exhaust outlet 712.

Cylindrical electrode 73, prismatic facing electrode 74 or such has a structure in which a dielectric material is coated on a metal base material. That is, ceramics is thermally sprayed on a conductive metal base material as a dielectric for each of electrodes, and the electrode is preferably subjected to sealing treatment employing a sealing material made of an inorganic compound. The coat thickness of the ceramic dielectric material may desirably be 1 mm. As a ceramic material usable for thermal spraying, alumina and silicon nitride are preferably used, but of these, alumina is more preferably usable in view of easy processing. The dielectric layer may be a lining-treated dielectric material in which an inorganic material is formed via lining.

Examples of the conductive metal base material include a metal such as titanium, a titanium alloy, silver, platinum, stainless steel, aluminum or iron; a composite material of iron and ceramics; and a composite material of aluminum and ceramics, but titanium and a titanium alloy are specifically preferable.

In the case of a dielectric material provided on one of the electrodes, the distance between facing electrodes is preferably 0.1 - 20 mm, and more preferably 0.5 - 2 mm in view of even discharge depending on the distance of dielectric-to-dielectric.

Further, a structure in which a medium such as water or silicone oil can be circulated is arranged to be set since the electrode surface temperature is controlled during plasma discharge treatment, and the surface temperature of substrate F is maintained at a predetermine temperature. For example, a metal base material of the prismatic electrode is structured to form a square metallic pipe serving as a jacket, making it possible to adjust temperature during discharge.

As for an atmospheric pressure plasma treatment apparatus of the present invention, high frequency voltage applied between facing electrodes is high frequency voltage having a frequency exceeding 100 kHz, and an electric power (output power density) of at least 1 W/cm$^2$ is supplied to generate plasma via excitation of treatment gas.

In the present invention, the upper limit of frequency of high frequency voltage applied between electrodes is preferably at most 150 MHz, and more preferably at most 15 MHz. Further, the lower limit of frequency of the high frequency voltage is preferably at least 200 kHz, and more preferably at least 800 kHz.

Further, the upper limit of power supplied between electrodes is preferably at most 50 W/cm$^2$, and more preferably at most 20 W/cm$^2$. The lower limit of power supplied is preferably at least 1.2 W/cm$^2$. The discharge surface area (cm$^2$) refers to the surface area of the electrode at which discharge occurs.

The value of voltage applied at the electrode from a high frequency power supply is appropriately determined, but the voltage is roughly 10 V - 10 kV, and the power supply frequency is adjusted in the range of 100 kV - 150 MHz as described above.

Herein, regarding the applied power supply, there are a continuous oscillation mode (called a continuous mode) with a continuous sine wave and a discontinuous oscillation mode (called a pulse mode) carrying ON/OFF discontinuously, and either may be used, but a method supplying the continuous sine wave at least to the second electrode side (the second high frequency electric field) is preferred in obtaining a uniform layer with high quality.

It is necessary in the present invention to employ electrodes capable of maintaining a uniform glow discharge state in an atmospheric pressure plasma treatment apparatus by applying such the voltage.

In the present invention, power supplies to apply voltage to the electrodes are not particularly limited, but examples thereof include a high frequency power supply (3 kHz) manufactured by Shinko Electric Co., Ltd., a high frequency power supply (5 kHz) manufactured by Shinko Electric Co., Ltd., a high frequency power supply (10 kHz) manufactured by Shinko Electric Co., Ltd., a high frequency power supply (15 kHz) manufactured by Kasuga Electric Works, Ltd., a high frequency power supply (10 kHz) manufactured by Shinko Electric Co., Ltd., an impulse high frequency power supply (100 kHz in continuous mode) manufactured by Haiden Laboratory Inc., a high frequency power supply (200 kHz) manufactured by Pearl Kogyo Co., Ltd., a high frequency power supply (800 kHz) manufactured by Pearl Kogyo Co., Ltd., a high frequency power supply (2 MHz) manufactured by Pearl Kogyo Co., Ltd., a high frequency power supply (13.56 MHz) manufactured by Pearl Kogyo Co., Ltd., a high frequency power supply (27 MHz) manufactured by Pearl Kogyo Co., Ltd., a high frequency power supply (150 MHz) manufactured by Pearl Kogyo Co., Ltd. and so forth. Power supplies (100 kHz - 150 MHz) are preferable, power supplies (200 kHz - 150 MHz) are more preferable, and power supplies (800 kHz - 15 MHz) are most preferable.

Next, the surface of a substrate which has been subjected to plasma discharge treatment is only brought into contact with nip roller 78, the substrate is transported out from the discharge section to directly roll it up as a roll by a roll core fitted to winder (roll-up shaft) 701

It is a feature in the plasma discharge treatment apparatus that there is no roller brought into contact with the surface which has been subjected to film formation or surface modification, but a nip roller brought into contact with the foregoing cylindrical electrode. Accordingly, in the case of introduction of rollers to adjust conveyance tension like a dancer roller or such, a group of rollers in this case is possible to introduce rollers brought into contact with the surface which has been subjected to surface modification. Therefore, these are not employed in the present invention.

Accordingly, a nip roller together with a back-up roller as the foregoing cylindrical electrode is preferably formed from an elastic material. The foregoing hard rubber, plastics and so forth are preferable, and specifically, a roller made of rubber or plastic having a rubber hardness of 60 - 80 in accordance with is preferable.

It is preferable in the present invention that the foregoing winder and unwinder are directly torque-controlled.

The torque control of the winder and unwider is controlled so as to keep the conveyance tension of a substrate film constant. For example, the winder torque is controlled so as to keep the tension of the substrate film rolled from the winder or the center of a roll core. The tension is preferably 50 to 500 $\pm$ 10 (N/m), and more preferably about 100 $\pm$ 10 (N/m).

In Fig. 1, 713 represents a tension meter, and it is placed on the support side or at the end portion to measure tension by detecting fine displacement. The tension is controlled to be constant via feed forward of measured information to rotation of a roll-up shaft (feed forward control). The tension meter is preferably a non-contact tension meter, and may be one by which the tension can be measured with no contact of the film by utilizing air pressure with an air-turnber provided by supplying air from a blower in the range of very low pressure and low pressure (a non-contact web tension meter, manufactured by Bellmatic Ltd.). Further, one obtained via conversion of the torque motor output may be employed.

The torque of the winder to keep the tension of a rolled substrate can be controlled by any method, but in the case of winder rotation driven with a motor, for example, the torque of the motor can be controlled by voltage adjustment. Further, it may be controlled by current adjustment, and may also be controlled by varying frequency with an inverter.

The plasma discharge treatment apparatus of the present invention is preferably fitted with at least one of EPC sensors (edge position control sensor). The edge of the substrate film is detected with an air servo sensor and an optical sensor employing an EPC sensor, and then movement of the edge position in the width direction is detected. In Fig. 1, 714 represents this EPC sensor.

Web guiding during conveyance of a long-length substrate film can be conducted appropriately by having the position of winder 101 corrected in the width direction, simply based on information of this sensor.

Further, a web guiding device is preferably used in order to conduct web guiding with accuracy. That is, the conveyance direction is controlled, based on the detected information, and the film end and the center in the width direction are adjusted to be at a given conveyance position. As for the actuator, specifically, web guiding is carried out by moving one or two guide rollers and a flat expander roller with drive from side to side (or up and down) with respect to the linear direction. Further, a set of two small size pinch rollers is placed on either side of the film (each roller is placed on the front and back sides of the film, and placed on the both sides of the film), and these sandwiche and pull the film to conduct web guiding (cloth guiding system). The web guiding principle of these devices means a method in which as to the former technique, the roller is tilted so as to move the film to the right when the film is moving to the left during film running, and as to the latter technique, pinch roller in pairs on the right side are nipped to be pulled to the right. These web guiding devices can be placed.

Further, in the plasma discharge treatment apparatus of the present invention, a cleaning roller is preferably placed being bought into contact with a cylindrical electrode situated on the substrate film touching the electrode.

The cleaning roller is placed outside the region of the foregoing discharge section so as to be brought into contact with the cylindrical electrode. As shown in Fig. 1, rubber roller 715 is employed in the case of the simplest embodiment. Foreign matters such as trash, dirt and dust attached on the cylindrical electrode are transferred onto the rubber roller surface by rotating the rubber roller in accordance with the rotation of the cylindrical electrode while being in contact with it (at constant pressure) to remove the foreign matters. This rubber roller has a JIS hardness of 30 - 70, and is preferably made of a material more elastic than that of the foregoing nip roller.

The foreign matters such as dirt, dust and so forth attached on the rubber roller are further transferred onto adhesion roller 716 whose surface is adhesive, which is rotating so as to be in contact with the rubber roller. This is a roller or such, and a double-stick tape is attached on the rubber roller surface, but material quality is not limited thereof. For example, an adhesion roller produced by Teknek Japan Ltd. is provided as an adhesion roller. After removing the foreign matters having a size of micron meters because of the rubber roller being in contact with a web or such, the rubber roller is constantly kept clean by transferring them into the adhesion roller. The adhesive tape is appropriately replaceable before the foreign matters have not been transferred from the rubber roller.

In a cleaning process, a cleaning roller is not always employed. A cleaning blade may be used. A cleaning process may be conducted employing a cleaning blade in combination, and another method may be utilized.

At the discharge section, no foreign matter get mixed in with the back surface of the substrate (between electrodes) by removing the foreign matter adhering onto the cylindrical electrode surface employing a cleaning roller, whereby the plasma discharge treatment is evenly conducted.

In the above example, after the substrate film rolled out from unwinder 700 is subjected to plasma discharge treatment for film formation and surface modification, the surface-treated substrate film is rolled by winder 701 to terminate the first plasma discharge treatment, but in a preferred embodiment of the present invention, foregoing unwinder 700 becomes a roll-up shaft, and winder 701 becomes a roll-out shaft to make an opposite conveyance direction of the substrate film, whereby surface treatment or film formation can further be conduced on the substrate via plasma discharge treatment.

Therefore, the foregoing unwinder or winder is desired to have a gear mechanism capable of shifting into the reverse rotation.

In this way, an intended treatment or thin film formation can be conducted in order, employing a plasma discharge treatment apparatus of the present invention, since preparation of an adhesion layer, a gas barrier film or a multilayer composed of an adhesion layer and a gas barrier film changes the conveyance direction, select the reactive gas, and the plasma discharge condition is set for every treatment.

The plasma discharge treatment apparatus of the present invention is useful when a plurality of layers are laminated via plasma discharge treatment, or some of the processes such as surface-modifying treatment and so forth need to be continuously treated after film formation. No presence of a guide roller being in contact with the thin film formation surface or the surface-modifying surface, other than the roll-out process and the thin film formation process, or the surface-modifying process and the roll-up process which are continuously conducted, is advantageous to obtain high qualiyy films exhibiting no foreign matter failure caused by scratches on the surface, and pressure.

Next, another example of the plasma discharge treatment apparatus of any one of Claims 1 - 6 in the present invention is shown in Fig. 2. This shows a discharge section having a different structure.

Since the discharge section in this atmospheric plasma discharge treatment apparatus is different from one in foregoing Fig. 1, the discharge section will be described.

The plasma discharge treatment apparatus shown in Fig. 2 is designed to be capable of applying at least two different frequency electric fields, and the electric field superposed by the first and the second high frequency electric fields is applied.

Foregoing second frequency w2 is higher than foregoing first frequency $\omega1$, and the relationship of first high frequency electric field intensity V1, second high frequency electric field intensity V2, and electric field intensity at start of discharge IV meets $V1 \geq IV > V2$ or $V1 > IV \geq V2$, and the power density of the foregoing second high frequency electric field is at least 1 W/cm$^2$.

Discharge can occur even though nitrogen gas as the first discharge gas with a high electric field intensity at a starting point of discharge is used, a high density and stable condition of plasma can be maintained and a thin film formation in high quality can be achieved by employing such the discharge condition.

The electric field intensity at starting point of discharge IV (1/2 Vp-p) is about 3.7 kV/mm when nitrogen gas is provided as the discharge gas. Accordingly, in the above relationship, plasma can be generated by application of the first high frequency electric field $V1 \geq 3.7$ kV/mm and activating nitrogen gas.

The frequency of the first power supply should be less than 200 kHz. Those electric field waves can be either continuous waves or pulse waves and the frequency should be about 1 kHz in the lower limit.

On the other hand, a frequency of the second power supply should be 800 kHz or higher. A good quality thin film with thickness uniformity and good adhesion with strength can be obtained by occurrence of increase in plasma density with frequency of the second power supply and the frequency should be about 200 MHz in the upper limit.

Application of high frequency electric fields through those two power supplies is desired to start discharging the discharge gas having a high electric field intensity at start of discharge generated by the first high frequency electric field, and a dense and good quality thin film can also be prepared by increasing in plasma density with high frequency in the second high frequency electric field and with high power density.

In the atmospheric plasma discharge treatment apparatus in Fig. 2 in the same manner as in the case of Fig. 1, substrate film F is transferred from stock roll 71 wound by a spindle fitted into unwinder 700, and enters discharge section 100 after passing through residual heat zone 72' to heat the substrate film in advance with heating member 72 placed facing against the substrate.

The thin film formation or surface modification is conducted via plasma discharge treatment of substrate F in discharge section 10 formed between cylindrical electrode (first electrode) 73 and prismatic electrode (second electrode) 74 and 74' facing against the cylindrical electrode.

In discharge space 100 between cylindrical electrode 73 and each of facing electrodes (the second electrodes) 74 and 74', the first high frequency electric field with frequency ω1, electric field intensity V1, and current I1 is applied to cylindrical electrode 73, and the second high frequency electric field with frequency w2, electric field intensity V2, and current I2 is applied to facing prismatic electrodes 74 and 74'.

First filter 43 is placed between cylindrical electrode 73 and first power supply 41. It is designed that the current passing through the first electrode from first power supply 41 runs easily with the installation of first filter 43, and the current passing through the first power supply from second power supply 42 does not run easily with grounding the current running through from second power supply 42. Second filter 44 is also placed between facing electrodes (the second electrodes) 74 and 74' and the second power supply 42. It is designed that the current passing through the second electrode from second power supply 42 runs easily with the installation of second filter 44, and the current passing through the second power supply from first power supply 41 does not run easily with grounding the current running through from first power supply 41.

In addition, in the present invention, cylindrical electrode 73 may be set as the second electrode, and fixed facing electrodes 74 and 74' may be set as the first electrode. At any rate, the first electrode is connected to the first power supply, and the second electrode is connected to the second power supply. The first power supply preferably has larger high frequency electric field intensity (V1 > V2) applied than the Second power supply. Frequency of ω1 < ω1 is possible to be utilized.

The current should be I1 < I2. Current I1 of the first high frequency electric field should be 0.3 - 20 mA/cm$^2$. It is preferably 1.0 - 20 mA/cm$^2$. And also, Current I2 of the second high frequency electric field should be 10 - 100 mA/cm$^2$. It is preferably 20 - 100 mA/cm$^2$.

Thin film forming gas G generated by gas generation device (unshown) is introduced into the inside of plasma discharge treatment vessel from gas supply opening 711 by controlling gas flow with an unshown gas flow adjustment unit.

Conveyed substrate F passing through nip roller 75 is transferred into the discharge section formed between cylindrical electrode 73 and each of electrodes 74 and 74'.

Electric field is applied from both cylindrical electrode 73 and each of electrodes 74 and 74', discharge plasma is generated between the electrodes (in the discharge space). Substrate F is rolled while being in contact with cylindrical electrode 73, and is brought into contact with gas in a plasma state to form a thin film.

Herein, two fixed electrodes are placed along with the circumference of the cylindrical electrode as the number of fixed electrodes, but a plurality of fixed electrodes are allowed to be placed. The discharge area of the electrode is represented by the sum of area of the surface facing cylindrical electrode 3 of the total fixed electrodes facing cylindrical electrode 3.

Similarly to Fig. 1, substrate F is rolled up by a roll-up device via nip roller 78.

The exhaust gas which has been subjected to discharge treatment is emitted from exhaust outlet 712.

It is preferable that a medium temperature-adjusted with an electrode temperature adjustment unit is fed to both electrodes via a pipe by a liquid-feed pump to adjust temperature from the inside of the electrode in order to heat or cool the cylindrical electrode and the fixed electrode during film formation. Incidentally, numerals 76 and 79 represent a plasma discharge treatment vessel and a partition blocked from the outside, respectively. Numerals 715 and 716 represent a rubber roller and an adhesion roller, respectively, constituting the cleaning roller, similarly to those in the apparatus shown in Fig. 1.

Cylindrical electrode 3, prismatic electrode 74 or such, similarly to one described before, has a structure in which a dielectric material is coated on a metal base material. Further, a structure capable of circulating a temperature adjustable medium (water, silicone oil or such) is employed in order to maintain a surface temperature of substrate F at a predetermined value by controlling the electrode surface temperature during plasma discharge treatment. For example, the metal base material structure of the prismatic electrode is arranged to be formed from a metal pipe, and to be a jacket to adjust the temperature during discharge.

Ceramics is thermally sprayed on a conductive metal base material as a dielectric for each of electrodes, and the preferable electrode is preferably subjected to a sealing treatment employing a sealing material made of an inorganic compound. The coat thickness of the ceramic dielectric material may desirably be 1 mm. As a ceramic material usable for thermal spraying, alumina and silicon nitride are preferably used, but of these, alumina is more preferably usable in view of easy processing. The dielectric layer may be a lining-treated dielectric material in which an inorganic material is formed via lining.

Examples of the conductive metal base material, a metal such as titanium, a titanium alloy, silver, platinum, stainless steel, aluminum or iron; a composite material of iron and ceramics; and a composite material of aluminum and ceramics, but titanium and a titanium alloy are specifically preferable.

In the case of a dielectric material provided on one of the electrodes, the distance between facing electrodes is preferably 0.1 - 20 mm, and more preferably 0.5 - 2 mm in view of even discharge depending on the distance of dielectric-to- dielectric.

Though the plasma discharge treatment vessel is preferably a glass vessel such as Pyrex ® glass, a metal vessel may be employed when the vessel is insulated from the electrodes. For example, a polyimide resin or such may be attached on the inner surface of a frame made of aluminum or stainless steel, and the metal frame may also be insulated by thermally ceramics-spraying. In Fig. 1, the both side surfaces of both parallel electrodes (near the substrate surface) are preferably covered with the above-described material (up to the area close to the substrate).

Examples of such the first power supply (high frequency power supply) employed in the atmospheric pressure plasma discharge treatment apparatus include the following power supplies.

| Reference Number | Manufacturer | Frequency | Product name |
| --- | --- | --- | --- |
| A1 | Shinko Electric Co., Ltd. | 3 kHz | SPG3-4500 |
| A2 | Shinko Electric Co., Ltd. | 5 kHz | SPG5-4500 |
| A3 | Kasuga Electric Works, Ltd. | 15 kHz | AGI-023 |
| A4 | Shinko Electric Co., Ltd. | 50 kHz | SPG50-4500 |
| A5 | Haiden Laboratory Inc. | 100 kHz | PHF-6k |
| A6 | Pearl Kogyo Co., Ltd. | 200 kHz | CF-2000-200k |
| A7 | Pearl Kogyo Co., Ltd. | 400 kHz | CF-2000-400k |

Any of the above commercially available power supplies can be employed in the present invention.

Examples of the second power supply (high frequency power supply) also include the following power supplies.

| Reference Number | Manufacturer | Frequency | Product name |
| --- | --- | --- | --- |
| B1 | Pearl Kogyo Co., Ltd. | 800 kHz | CF-2000-800k |
| B2 | Pearl Kogyo Co., Ltd. | 2 MHz | CF-2000-2M |
| B3 | Pearl Kogyo Co., Ltd. | 13.56 MHz | CF-5000-13M |
| B4 | Pearl Kogyo Co., Ltd. | 27 MHz | CF-2000-27M |
| B5 | Pearl Kogyo Co., Ltd. | 150 MHz | CF-2000-150M |

Any of the above commercially available power supplies can be employed in the present invention.

In the above power supplies, "*" represents an impulse high frequency power supply (100 kHz in continuous mode) manufactured by Haiden Laboratory Inc., and others are high frequency power supplies capable of applying electric field of only continuous sine wave.

In the present invention, electrodes capable of maintaining a uniform and stable discharge state is preferably employed in the atmospheric pressure plasma discharge treatment apparatus by supplying such an electric field.

In the present invention, the power applied between facing electrodes supplies a power (power density) of at least 1 W/cm$^2$ to the second electrode (the second high frequency electric field), energy is given to the film forming gas by generating plasma via excitation of the discharge gas to form a thin film. The upper limit of power supplied to the second electrode is preferably 50 W/cm$^2$, and more preferably 20 W/cm$^2$. The lower limit of power is preferably 1.2 W/cm$^2$. The discharge area (cm$^2$) refers to the area in the region where discharge is generated between electrodes.

Further, the power density can be enhanced while maintaining the uniformity of the second high frequency electric field, by supplying power (power density) of at least 1 W/cm$^2$ to the first electrode (the first high frequency electric field), whereby more uniform plasma having higher density can be produced, resulting in an improved film forming rate and film quality at the same tome. The power supplied to the first electrode is preferably at least 5 W/cm$^2$. The upper limit of power supplied to the first electrode is preferably 50 W/cm$^2$.

Herein, the waveform of the high frequency electric field is not specifically limited. There are a continuous oscillation mode which is called a continuous mode with a continuous sine wave and a discontinuous oscillation mode which is called a pulse mode carrying out ON/OFF discontinuously, and either may be used, but a method supplying a continuous sine wave at least to the second electrode side (the second high frequency electric field) is preferred to obtain a uniform film with high quality.

In this way, similarly to the apparatus in Fig. 1, a substrate which has been subjected to plasma treatment with two frequencies is transported outside from the discharge section with the treated surface only being in contact with nip roller 78 and web-guided with EPC sensor 714, and torque of winder (roll-up shaft) 701 is controlled via feed forward control so as to keep the conveyance tension constant by tension meter 713 to roll the substrate with the shaft as a roll.

In this way, it is a feature in the plasma treatment apparatus of the present invention that there is no roller brought into contact with the surface subjected to thin film formation or surface-modifying treatment, but a nip roller brought into contact with the foregoing cylindrical electrode.

In the case of a plasma discharge treatment apparatus shown in Fig. 2, different film formation or surface forming treatment can be continuously conducted in the same treating vessel by being arranged to set a supply opening and a exhaust outlet for each thin film forming gas in discharge space formed by an electrode and a cylindrical electrode each with respect to fixed electrodes 74 and 74'. Further, similarly to the plasma discharge treatment apparatus in Fig. 1, the treatment can be conducted in the reverse direction by changing the conveyance direction, and a plurality of films can be laminated by conducting reciprocating thin film formation and surface-modifying treatment, or such the treatment can be conducted in order.

As a mixed gas employed for plasma discharge treatment of the present invention, various gases are usable depending on the intended purpose such as thin film formation or surface-modifying treatment.

As to a plasma discharge treatment, such the reactive gas is mixed with a discharge gas capable of easily becoming a plasma state and sent to the plasma discharge generation apparatus. Nitrogen gas and/or an element of Group 18 of periodic table such as helium, neon, argon, krypton, xenon or radon are used for such the discharge gas. Of these, nitrogen, helium and argon are preferably used.

The above-described discharge gas is mixed with various reactive gases. For example, the reactive gas necessary to form a thin film is mixed, and supplied into the plasma discharge apparatus to form a layer, and to conduct surface modification.

The reactive gas is supplied in a ratio of the discharge gas to whole mixture of the gases of at least 50 %, though the ratio is varied depending on the properties of the layer to be formed.

For example, raw material employed for preparing a ceramic material layer will be described.

In the plasma discharge treatment, metal carbide, metal nitride, metal oxide, metal sulfide, metal halide and a mixture thereof (such as metal oxide-nitride, metal oxide-halide or metal nitride-carbide) can be selectively produced for the ceramic material layer by selecting an organometal compound as the raw material, decomposition gas, decomposition temperature and applied electric power.

For example, silicon oxide is formed by using a silicon compound as the raw material and oxygen as the decomposition gas, and zinc sulfide is formed by using a zinc compound as the raw material and carbon disulfide as the decomposition gas. In the space of plasma, very high actively charged particles or active radicals exist in high density. Therefore, plural steps of chemical reaction are accelerated in very high rate in the plasma space and the elements being in the plasma space is converted to the chemically stable compound within extremely short duration.

The state of the raw material compound may be gas, liquid or solid at room temperature and normal pressure. The gas can be directly introduced into the discharge space and the liquid and solid are used after vaporized by a method such as heating bubbling or applying ultrasonic wave. The raw material compound may be used after diluting with a solvent.

Examples of such the organic compound include silicon compounds such as silane, tetramethoxy silane, tetraethoxy silane, tetrapropoxy silane, tetrabutoxy silane and dimethyldimethoxy silane; alkoxy silanes; tinanium compounds such as titanium methoxide, titanium ethoxide and titanium isopropoxide; zirconium compounds such as zirconium n-propoxide and so forth; aluminum compounds such as aluminum ethoxide, aluminum triisopropoxide and aluminum isopropoxide; boron compounds such as diborane and tetraborane; tin compounds such as tin tetraethyl and tin tetramethyl; and other organic metal compounds such as antimony and zinc.

As the decomposition gas for decomposing the raw material gas containing the metal to form an inorganic compound, a hydrogen gas, a methane gas, an acetylene gas, a carbon monoxide gas, a carbon dioxide gas, a nitrogen gas, an ammonium gas, a nitrogen monoxide gas, a nitrogen oxide gas, a nitrogen dioxide gas, an oxygen gas, steam, a fluorine gas, hydrogen fluoride, trifluoroalcohol, trifluorotoluene, hydrogen sulfide, sulfur dioxide, carbon disulfide or a chlorine gas can be mixed in a reaction gas.

Various kinds of metal carbide, metal nitride, metal oxide, metal halide and metal sulfide can be obtained by suitably selecting a metal element-containing raw material gas and a decomposition gas.

The above-described discharge gas is mixed with the reaction gas, and the resulting gas is supplied into a plasma discharge generation apparatus (plasma generation apparatus) as a mixed gas for film formation to form a film.

Alkoxysilane, for example, TEOS (tetraethoxysilane) is utilized as a reaction gas to obtain a silicon oxide layer, and the silicon oxide layer having various compositions and properties can be obtained via the decomposition gas, the plasma discharge conditions and so forth.

The decomposition gas such as an oxygen gas as a reaction gas without using a metal compound is utilized with a discharge gas to conduct a substrate surface-modifying treatment, and also a silane compound or such having a fluorine atom among organic fluorine compounds is employed to conduct a surface-modifying treatment for hydrophobicity of the substrate surface.

It is also possible that a polymer thin film is formed by containing an organic compound in a thin film formation gas, and conducting a plasma polymerization on a substrate.

As an organic compound used for a plasma polymerization raw material component contained in a thin film formation gas, an organic compound such as a (meth)acrylic compound, an epoxy compound, or a monomer or oligomer of an oxetane compound and so forth is usable. The material of substrate treated by a plasma discharge treatment apparatus of the present invention is not specifically limited, but it is selected depending on a thin film formed on intended usage such as a substrate, a surface-modifying treatment and so forth. For example, when a gas barrier layer is formed on a resin film to make a substrate of an organic EL element transparent, the resin film is preferably transparent.

As the substrate, a long length plastic (resin) film, paper, nonwoven fabric and so forth are listed as usage, but a resin film is preferable. The resin film is not specifically limited.

Specific examples of the usable films are as follows. Homopolymers such as ethylene, polypropylene, butene, or copolymers or polyolefin (PO) resins such as copolymers; amorphous polyolefin resins (APO) such as cyclic polyolefins; polyester resins such as polyethylene terephthalate (PET) and polyethylene 2,6-naphthalate (PEN); polyamide (PA) resins such as nylon 6, nylon 12 and copolymer nylon; polyvinyl alcohol resins such as polyvinyl alcohol (PVA) resins and ethylenevinyl alcohol copolymers (EVOH); polyimide (PI) resins; polyether imide (PEI) resins; polysulfone (PS) resins; polyether sulfone (PES) resins; polyether ether ketone (PEEK) resins; polycarbonate (PC) resins; polyvinyl butyrate (PVB) resins; polyarylate (PAR) resins; fluorine resins such as ethylene-tetrafluoroethylene copolymers (ETFE), ethylene trifluorochloride (PFA), ethylene tetrafluoride-perfluoroalkyl vinyl ether copolymers (FEP), vinylidene fluoride (PVDF), vinyl fluoride (PVF), and perfluoroethylene-perfluoropropylene-perfluorovinyl ether copolymers (EPA). One obtained by laminating or coating at least one of these resins is usable as a resin film.

These may be used singly or as an admixture of two or more thereof. ZEONEX or ZEONOR (produced by Nippon Zeon Corporation, an amorphous cyclopolyolefin film ARTON (produced by JSR Corporation), a polycarbonate film PUREACE (produced by Teijin Limited), and a cellulose triacetate film KONICATAC KC4UX, KC8UX (produced by Konica Minilta Opto, Inc.) available on the market are preferably used.

The above-described resin may also be unstretched or stretched.

The resin film is advantageous in the case of long length type in the form of a roll. The thickness can not be categorically specified, depending on usage of the resulting products or the intermediate media, but the resin film has a thickness of 3 - 400 $\mu$m, preferably a thickness of 10 - 200 $\mu$m, and more preferably a thickness of 6 - 30 $\mu$m in view of a variety of uses such as a gas barrier film applied for conveyance and package, for example.

The thin film such as the foregoing ceramic layer or metal oxide film, for example is formed on the substrate via a plasma discharge treatment apparatus of the present invention, whereby a film with a functional thin film such as a gas barrier film, an anti-reflection layer or a transparent conductive film exhibiting high quality can be effectively obtained. Further, hydrophilic treatment, hydrophobic treatment, surface roughened treatment and surface-modifying treatment are effectively conducted in high quality with a plasma discharge treatment apparatus.

Next, a plasma discharge treatment apparatus of any one of Structures 7 - 10 as an apparatus to accomplish the first objective of the present invention will be described.

In the case of a plasma discharge apparatus of any one of Structures 7 - 10 of the present invention, similarly to the plasma discharge treatment apparatus of any one of Structures 1 - 6, there is no guide roller brought into contact with the thin film forming surface or surface-modified surface, but a nip roller specifically in the film formation process in conveyance of a substrate from a roll-out process to a roll-up process among all the continuous processes of the roll-out process, the thin film forming process (device) or the surface-modifying process (device), and further the roll-up process (device).

In the present invention, thin film formation means that a thin film is formed (or deposited) in a substrate by a dry process employing a atmospheric pressure discharge treatment apparatus of the present invention.

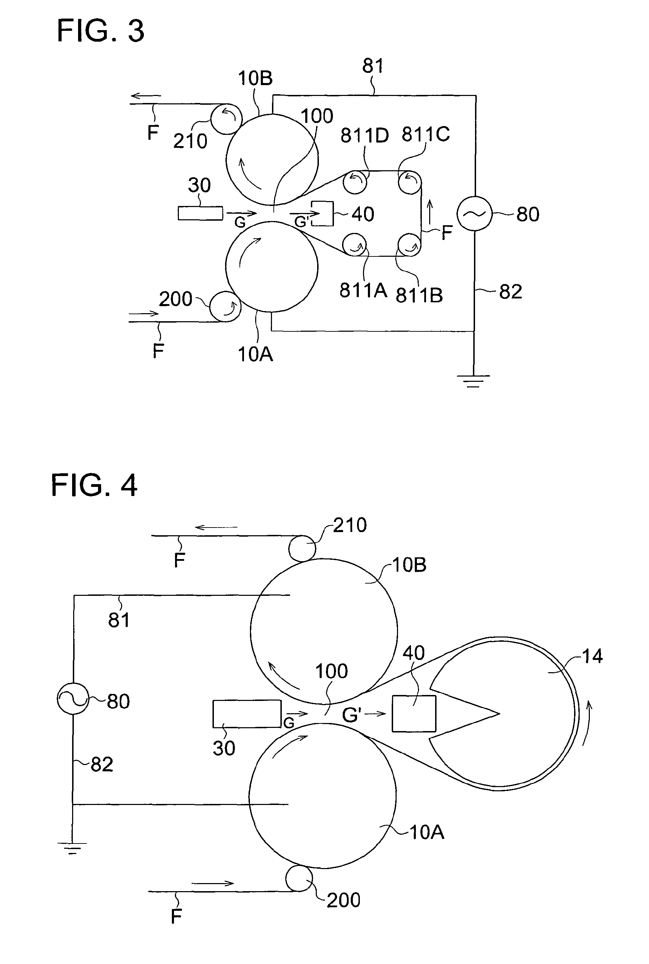

Fig. 3 shows one example of a conventional plasma discharge treatment apparatus disclosed in Japanese Patent O.P.I. Publication No. 2003-171770.

Herein, neither process of rolling out a substrate from a stock roll nor process of rolling it up is shown, but a plasma discharge treatment process blocked from the outside air by a vessel made of glass or such is shown.

Fig. 3 shows is a schematic diagram of a plasma discharge treatment process by which reciprocal treatment of a substrate is conducted employing facing two roll electrodes. Substrate F supplied from the roll-out process or a stock roll is firstly subjected to plasma discharge treatment at discharge section 100 so as to be taken by rotatable roll electrode 10A to be tightly transferred via nip roller 200. Subsequently, substrate F is secondly subjected to plasma discharge treatment at discharge section 100 so as to be taken by rotatable roll electrode 10B to be tightly transferred turn-back rollers (U-turn rollers) 811A - 811D. Reactive gas G supplied from reactive gas supply portion 30, and gas G' after treatment ejected from exhaust outlet 40. Treated substrate F is transferred into the roll-up process via nip roller 210 after transferring the substrate on roll electrode 10B coupled with the rotation. Incidentally, numeral 80 represents a power supply, and numerals 81 and 82 each represent a discharge treatment apparatus.

The above described plasma discharge treatment process is conducted by a plasma discharge treatment apparatus having a pair of roll electrodes for reciprocating treatment of the substrate.

However, in the plasma discharge treatment apparatus, the film forming surface on the substrate or the modified surface of the substrate is to be in contact with some of the rollers such as nip rollers 200 and 210, and turn-back rollers (U-turn rollers) 811A - 811D. In addition, there are some rollers present up to the roll-up process after plasma discharge treatment in order to b;ock the plasma discharge treatment from the outside air.

The plasma discharge treatment apparatus of the present invention is a plasma discharge treatment apparatus in which the number of rollers brought into contact with the film forming surface of a substrate and the modified surface is minimized by removing some of necessary rollers. As the necessary rollers, nip rollers with roll electrodes 200, 210 and so forth as back rollers and rollers such as turn-back rollers (U-turn rollers) touching during the foregoing discharge treatment, though these are not shown are preferably removed.

Next, Fig. 4 shows one example of a plasma discharge treatment apparatus of any one of Structures 7 - 10 of the present invention.

Fig. 4 is a diagram schematically showing a plasma discharge treatment process with a plasma discharge treatment apparatus of the present invention by which a reciprocating treatment of a substrate is conducted employing facing two roll electrodes.

After substrate F supplied from the roll-out process or a stock roll (unshown) enters the plasma discharge treatment process, the substrate is subjected to plasma discharge treatment at discharge section 100 so as to be taken by rotatable roll electrode 10A to be tightly transferred via nip roller 200 as a back-up roller. After the plasma discharge treatment, the transfer direction is changed and turned back with a conveyance device is composed of non-contact conveyance system 14 to support a continuously running web by blowing gas through a blowing outlet from the discharge section. Then, the substrate is tightly transferred into discharge section 100 so as to be taken by rotatable roll electrode 10B this time to conduct plasma discharge treatment a the discharge section.

Reactive gas G supplied from reactive gas supply portion 30, and gas G' after treatment ejected from exhaust outlet 40. Treated substrate F is transferred into the roll-up process via nip roller 210 after transferring the substrate on roll electrode 10B coupled with the rotation. Incidentally, numeral 80 represents a power supply, and numerals 81 and 82 each represent a discharge treatment apparatus.

Herein, the foregoing conveyance device is composed of non-contact conveyance system 14 supporting a continuously running web by blowing gas from a blowing outlet. As the non-contact conveyance system (floater), provided is a roller tabular-roll-shaped with the cross-sectional area of ellipsoid, semi-ellipsoid, elliptic arc, semi-circle, oval or arc in which a semi-ellipsoid cross-sectional area structure air emission section made of SUS-304 and aluminum is provided on the roller surface, the air emission section is wound in appropriate pitch by a SUS-304 wire, a flange fitted with fixed shaft sections is readily provided at both roller ends, and a hole for compressed air supply is provided on one side or both sides of the fixed shaft section. As another method, provided is a roller in which the air emission section is formed from punching metal.

When supplying air, web flotation becomes even along with the outer circumferential surface, and no web comes in contact with the roller surface.

Air is supplied into the inside of a roller by a blower to convey the substrate with no contact by floating it at a pressure of 0.1 -10 kPa (from a very low pressure to a low pressure). Supplied air pressure is determined depending on weight and tension of the floated film. Usually, stepwise selection is made in direct proportion to tension, but after measuring the film tension with a tension meter, the internal pressure is adjusted by the supplied air pressure in accordance with this to control the gap of the roller surface and the substrate surface. Such the roller produced by Bellmatic Ltd. is commercially available.

In the case of this method, turn-back rollers (U-turn rollers) passed through conveyance of the treated substrate during plasma discharge treatment with a conventional discharge treatment apparatus shown in the foregoing Fig. 3 are eliminated (conveyance carried out by these rollers while being in contact with the treated surface of a substrate), whereby pressure failure and scratches of a thin film formed on a substrate and the surface subjected to surface modification can be largely reduced.

Rotatable roll electrodes 10A and 10B each have a structure in which a dielectric material is coated on a metal base material. That is, ceramics is thermally sprayed on a conductive metal base material as a dielectric for each of electrodes, and the electrode is preferably subjected to a sealing treatment employing a sealing material made of an inorganic compound. The coat thickness of the ceramic dielectric material may desirably be 1 mm. As a ceramic material usable for thermal spraying, alumina and silicon nitride are preferably used, but of these, alumina is more preferably usable in view of easy processing. The dielectric layer may be a lining-treated dielectric material in which an inorganic material is formed via lining.

Examples of the conductive metal base material include a metal such as titanium, a titanium alloy, silver, platinum, stainless steel, aluminum or iron; a composite material of iron and ceramics; and a composite material of aluminum and ceramics, but titanium and a titanium alloy are specifically preferable.

The distance between facing electrodes is preferably 0.1 - 20 mm, and more preferably 0.5 - 2 mm in view of even discharge depending on the distance of dielectric-to-dielectric.

Further, a structure capable of circulating a temperature adjustable medium (water, silicone oil or such) is employed in order to maintain a surface temperature of substrate F at a predetermined value by controlling the electrode surface temperature during plasma discharge treatment. For example, the metal base material structure of the prismatic electrode is arranged to be formed from a metal pipe, and to be a jacket to adjust the temperature during discharge.

Omission is made in Fig. 4, but in the preferred embodiment, it is desired to avoid construction and deformation of the substrate caused by rapid increase of temperature by providing the residual heat zone in advance before entering the substrate into the discharge section, since the substrate is subjected to plasma discharge treatment in discharge section 100, maintaining a temperature at 90 - 200 °C, and preferably at 100 - 150 °C. Accordingly, the residual heat zone is preferably provided at the point where sufficient residual heat can be maintained, for example, immediately before a discharge treatment room having discharge section 100, during substrate conveyance.

As a heating member to heat the substrate in the residual heat zone, a plate-like electric heater sandwiched by mica, a ceramic heater or a sheathed heater, for example, is preferably employed, placed in a given spacing (0.5 - 5 mm) so as to heat the substrate film via radiation heat before the foregoing discharge section and not to touch it directly, and preferably equipped with a temperature control mechanism.

In addition, a stock roll may further be heated, if desired, in order to set the temperature in the residual heat zone (residual heat section) to be a temperature of the substrate film in the discharge section as closely as possible.

As for an atmospheric pressure plasma treatment apparatus according to any one of Structures 7 - 10 of the present invention, high frequency voltage applied between facing electrodes is high frequency voltage having a frequency exceeding 100 kHz, and an electric power (output power density) of at least 1 W/cm$^2$ is supplied to generate plasma via excitation of treatment gas.

Further, the upper limit of frequency of high frequency voltage applied between electrodes is preferably at most 150 MHz, and more preferably at most 15 MHz. The lower limit of frequency of the high frequency voltage is preferably at least 200 kHz, and more preferably at least 800 kHz.

Further, the upper limit of power supplied between electrodes is preferably at most 50 W/cm$^2$, and more preferably at most 20 W/cm$^2$. The lower limit of power supplied is preferably at least 1.2 W/cm$^2$. The discharge surface area (cm$^2$) refers to the surface area of the electrode at which discharge occurs.

The value of voltage applied at the electrode from a high frequency power supply is appropriately determined, but the voltage is roughly 10 V - 10 kV, and the power supply frequency is adjusted in the range of 100 kV - 150 MHz as described above.

Herein, regarding the applied power supply, there are a continuous oscillation mode (called a continuous mode) with a continuous sine wave and a discontinuous oscillation mode (called a pulse mode) carrying ON/OFF discontinuously, and either may be used, but a method supplying the continuous sine wave at least to the second electrode side (the second high frequency electric field) is preferred in obtaining a uniform layer with high quality.

According to an atmospheric pressure plasma treatment apparatus of Structures of 7 - 10, it is necessary to employ electrodes capable of maintaining a uniform glow discharge state in an atmospheric pressure plasma treatment apparatus by applying such the voltage.

Power supplies to apply voltage to electrodes are not particularly limited, but examples thereof include a high frequency power supply (3 kHz) manufactured by Shinko Electric Co., Ltd., a high frequency power supply (5 kHz) manufactured by Shinko Electric Co., Ltd., a high frequency power supply (10 kHz) manufactured by Shinko Electric Co., Ltd., a high frequency power supply (15 kHz) manufactured by Kasuga Electric Works, Ltd., a high frequency power supply (10 kHz) manufactured by Shinko Electric Co., Ltd., an impulse high frequency power supply (100 kHz in continuous mode) manufactured by Haiden Laboratory Inc., a high frequency power supply (200 kHz) manufactured by Pearl Kogyo Co., Ltd., a high frequency power supply (800 kHz) manufactured by Pearl Kogyo Co., Ltd., a high frequency power supply (2 MHz) manufactured by Pearl Kogyo Co., Ltd., a high frequency power supply (13.56 MHz) manufactured by Pearl Kogyo Co., Ltd., a high frequency power supply (27 MHz) manufactured by Pearl Kogyo Co., Ltd., a high frequency power supply (150 MHz) manufactured by Pearl Kogyo Co., Ltd. and so forth. Power supplies (100 kHz - 150 MHz) are preferable, power supplies (200 kHz - 150 MHz) are more preferable, and power supplies (800 kHz - 15 MHz) are most preferable.

According to a plasma discharge treatment apparatus of any one of Structures 7 - 10, few rollers brought into contact with the substrate surface which has been subjected to film formation or surface modification are best. Accordingly, in the case of introduction of rollers to adjust conveyance tension like a dancer roller or such, a group of rollers in this case is possible to introduce rollers brought into contact with the surface which has been subjected to surface modification. Therefore, these are not preferably employed in the present invention.

Therefore, in the plasma discharge treatment apparatus of any one of Structures 7 - 10, the winder and unwinder are preferably torque-controlled directly for roll-out and roll-up of the substrate.

The torque control of the winder and unwider is controlled so as to keep the conveyance tension of a substrate constant. For example, the tension of the substrate rolled from the winder is controlled to be constant in an amount of preferably about 50 ± 10 (N/m), and more preferably about 100 ± 10 (N/m).

The tension meter is placed on the roll-up side (or reversely the roll-out side), the support side or at the end portion to measure tension by detecting fine displacement. The tension is controlled to be constant via feed forward of measured information to rotation of a roll-up shaft (feed forward control). The tension meter is preferably a non-contact tension meter, and may be one by which the tension can be measured with no contact of the film by utilizing air pressure with an air-turnber provided by supplying air from a blower in the range of very low pressure and low pressure (a non-contact web tension meter, manufactured by Bellmatic Ltd.). Further, the tension may be controlled via conversion of the torque motor output.

The torque of the winder can be controlled by any method, but in the case of winder rotation driven with a motor, for example, the torque of the motor can be controlled by voltage adjustment.

As described before, as a matter of course, the plasma discharge treatment apparatus of the present invention is preferably fitted with at least one of EPC sensors (edge position control sensor). Further, a web guiding device is preferably used in order to conduct web guiding with accuracy.

Further, the foregoing similar cleaning roller is preferably placed being bought into contact with each roll electrode situated on the substrate touching the roll electrode.

A cleaning roller is not always employed. A cleaning blade may be used. A cleaning process may be conducted employing a cleaning blade in combination, and another method may also be utilized.

In the above apparatus, an unwider serves oppositely as a winder to make the opposite conveyance direction of the substrate, and another surface treatment or film formation can further be conducted on the substrate via plasma discharge treatment. In such the way, the present apparatus capable of conducting plasma discharge treatment in a reciprocating manner has a significant advantage. Therefore, the foregoing unwinder or winder is desired to have a gear mechanism capable of shifting into the reverse rotation.

Next, another example of the plasma discharge treatment apparatus of any one of Claims 7 - 10 will be described. This shows a different plasma discharge treatment process from one shown in Fig. 4 described before.

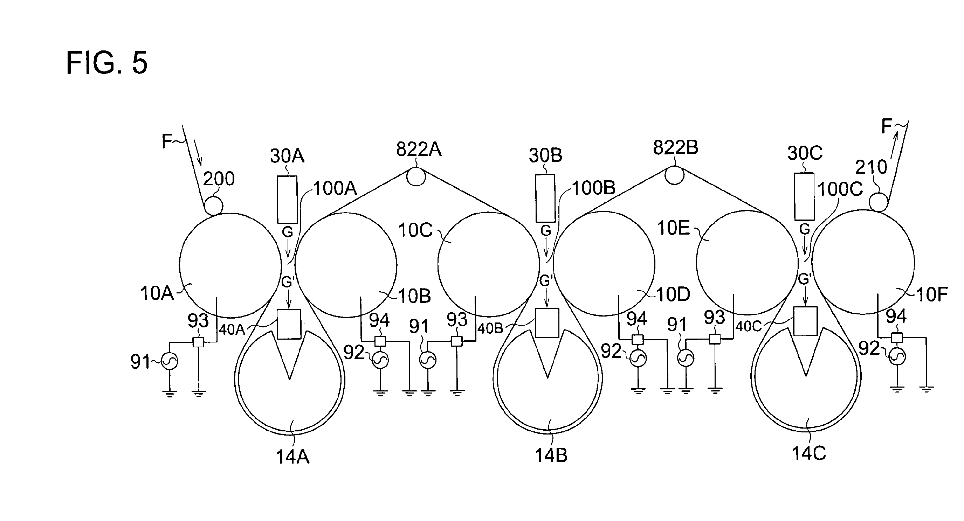

The plasma discharge treatment process shown in Fig. 5 is designed to be capable of applying at least two different frequency electric fields, and the electric field superposed by the first and the second high frequency electric fields is applied.

Foregoing second frequency $\omega 2$ is higher than foregoing first frequency $\omega 1$, and the relationship of first high frequency electric field intensity V1, second high frequency electric field intensity V2, and electric field intensity at start of discharge IV meets V1 $\geq$ IV > V2 or V1 > IV $\geq$ V2, and the power density of the foregoing second high frequency electric field is at least 1 W/CM$^2$.

Discharge can occur even though nitrogen gas as the first discharge gas with a high electric field intensity at a starting point of discharge is used, a high density and stable condition of plasma can be maintained and a thin film formation in high quality can be achieved by employing such the discharge condition.

The electric field intensity at starting point of discharge IV (1/2 Vp-p) is about 3.7 kV/mm when nitrogen gas is provided as the discharge gas. Accordingly, in the above relationship, plasma can be generated by application of the first high frequency electric field V1 $\geq$ 3.7 kV/mm and activating nitrogen gas.

The frequency of the first power supply should be less than 200 kHz. Those electric field waves can be either continuous waves or pulse waves and the frequency should be about 1 kHz in the lower limit.

On the other hand, a frequency of the second power supply should be 800 kHz or higher. A good quality thin film with thickness uniformity and good adhesion with strength can be obtained by occurrence of increase in plasma density with frequency of the second power supply and the frequency should be about 200 MHz in the upper limit.

Application of high frequency electric fields through those two power supplies is desired to start discharging the discharge gas having a high electric field intensity at start of discharge generated by the first high frequency electric field, and a dense and good quality thin film can also be prepared by increasing in plasma density with high frequency in the second high frequency electric field and with high power density.

In the atmospheric plasma discharge treatment apparatus of Fig. 5, similarly to Fig. 4, a roll-out process and a roll-up process are not shown, but substrate F rolled out from a stock roll and conveyed into a discharge treatment process is subjected to plasma discharge treatment at discharge section 100 so as to be taken by rotatable roll electrode 10A to be tightly transferred via nip roller 200. Subsequently, the substrate is further conveyed from discharge section 100A to a conveyance device as non-contact conveyance system 14A to support a continuously running web by blowing gas from a blowing outlet. In this way, after conveying the substrate surface along with the curvature with no contact, it is rolled by rotatable roll electrode 10B, tightly attached, transported, and conveyed to discharge section 100A again to be subjected to plasma discharge treatment at the discharge section for the second time.

Treated substrate F is further transferred via rotation of roll electrode 10B, conveyed while the back surface is brought into contact with guide roller 822A, and subsequently rolled by roll electrode 10C for conveyance. After the substrate is subjected to plasma discharge treatment for the first time in discharge section 100B composed of roll electrodes 10C and 10D, though gas outlet 40B and so forth after treatment are identical, the transfer direction is further turned back by non-contact conveyance system 14B to convey the substrate into duscharge section 100B again, and the substrate is subjected to reciprocating plasma discharge treatment.

In the same way as above, as to an example of Fig. 5, the substrate is conveyed while touching guide roller 822B to be subjected to reciprocating plasma discharge treatment in discharge section 100C formed from roll electrodes 10E and 10F, reactive gas supply portion 30C and gas exhaust outlet 40C after treatment.

After this, treated substrate F passes through nip roller 210 for which rotatable roll electrode 10F is a back-up roller, transferred into the roll-up process via the nip roller needed as a treating room to separate the outside from the plasma discharge treatment process, and rolled by a winder.

Incidentally, as described before, each of roll electrodes 10A, 10B, 10C and 10D has a structure in which a dielectric is coated on a conductive metal base material.

The distance between facing roll electrodes preferably has a dielectric surface-to-dielectric surface distance of 0.1 - 20 mm, and more preferably has a dielectric surface-to-dielectric surface distance of 0.5 - 2 mm in view of conducting of even discharge.

Further, a structure capable of circulating a temperature adjustable medium (water, silicone oil or such) is employed in order to maintain a surface temperature of substrate F at a predetermined value by controlling the electrode surface temperature during plasma discharge treatment. Similarly, it is preferable to be allowed to adjust the temperature during discharge.

At discharge sections 100A - 100C formed between roll electrodes in the plasma discharge apparatus in Fig. 5, reciprocating substrate F is subjected to plasma discharge treatment to form films or to surface-modifying treatment.

For example, in discharge space 100A - discharge space 100C between facing roll electrodes 10A and 10B, 10C and 10D, and 10E and 10F, respectively, the first high frequency electric field with frequency ω1, electric field intensity V1, and current I1 is applied to roll electrode 10A, and the second high frequency electric field with frequency ω2, electric field intensity V2, and current I2 is applied to roll electrode 10B.

In discharge space between roll electrodes 10C and 10D, and roll electrodes 10E and 10F, the first high frequency electric field with frequency ω1, electric field intensity V1, and current I1 is applied to roll electrode 10C and 10E by first power supply 91, and the second high frequency electric field with frequency ω2, electric field intensity V2, and current I2 is applied to facing roll electrodes 10D and 10F by second power supply 92.

First filter 43 is placed between roll electrode (the first electrode) 10A and first power supply 91. It is designed that the current passing through the first electrode from first power supply 91 runs easily with the installation of first filter 93, and the current passing through the first power supply from second power supply 92 does not run easily with grounding the current running through from second power supply 92. Second filter 94 is also placed between facing roll electrode (the second electrode) 10B and second power supply 92. It is designed that the current passing through the second electrode from second power supply 92 runs easily with the installation of second filter 94, and the current passing through the second power supply from first power supply 91 does not run easily with grounding the current running through from first power supply 91.

Similarly in the discharge space between roll electrodes 10C and 10E, and between 10E and 10F, roll electrodes 10C and 10E are used as the first electrode, and roll electrodes 10D and 10F are used as the second electrode. Similarly, the first electrode is connected to first power supply 91 and filter 93, and the second electrode is connected to second power supply 92 and filter 94 to conduct the similar operation.

In addition, in the present invention, each of roll electrodes 10B, 10D 10F may be set as the first electrode. At any rate, the first electrode is connected to the first power supply, and the second electrode is connected to the second power supply. The first power supply preferably has larger high frequency electric field intensity (V1 > V2) applied than the Second power supply. Frequency of ω1 < ω1 is possible to be utilized.

The current should be I1 < I2. Current I1 of the first high frequency electric field should be 0.3 - 20 mA/cm$^2$. It is preferably 1.0 - 20 mA/cm$^2$. And also, Current I2 of the second high frequency electric field should be 10 - 100 mA/cm$^2$. It is preferably 20 - 100 mA/cm$^2$.

Thin film forming gas G generated by gas generation device (unshown) is introduced into discharge sections 100A, 100B and 100C with reactive gas supply portions 30A, 30B and 30C, respectively, by controlling gas flow with an unshown gas flow adjustment unit.

A electric field is applied between facing two rotatable roll electrodes to generate discharge plasma between the electrodes (in the discharge space). Substrate F is rolled by each roll electrode while touching the back surface of the substrate, and is exposed to gas in a plasma state to form a thin film.

The exhaust gas which has been subjected to a discharge treatment is emitted from each of exhaust outlet 40A - 40 B.

The substrate which has been subjected to the plasma discharge treatment with the foregoing apparatus is conveyed with no contact of the surface of the substrate treated by the foregoing non-contact conveyance system during the plasma discharge treatment, and transferred into the roll-up process via nip roller 210 for which roll electrode 10F is a back-up roller

Incidentally, in the apparatus of Fig. 5, three pairs of electrodes are provided, but two pairs of electrodes or plural pairs of electrodes are allowed to be provided.

It is preferable that a medium temperature-adjusted with an electrode temperature adjustment unit is fed to both electrodes via a pipe by a liquid-feed pump to adjust temperature from the inside of the electrode in order to heat or cool each roll electrode during film formation.

As similarly described before, each roll electrode has a structure in which a dielectric is coated on a conductive metal base material. The dielectric and metal base material are in the same manner as described before. Further, a structure capable of circulating a temperature adjustable medium (water, silicone oil or such) is employed in order to maintain a surface temperature of substrate F at a predetermined value by controlling the electrode surface temperature during plasma discharge treatment. It is preferable to be allowed to adjust the temperature during discharge.

An apparatus employing a plasma discharge treatment process comprising a rotatable roll electrode and a prismatic electrode facing the roll electrode, wherein an electric field superposed by the first and the second high frequency electric fields having different frequencies is applied between the electrodes is shown in Fig. 5, but one example of the plasma discharge treatment apparatus according to any one of Structures 7 - 10, which is different from the foregoing apparatus, is also shown.

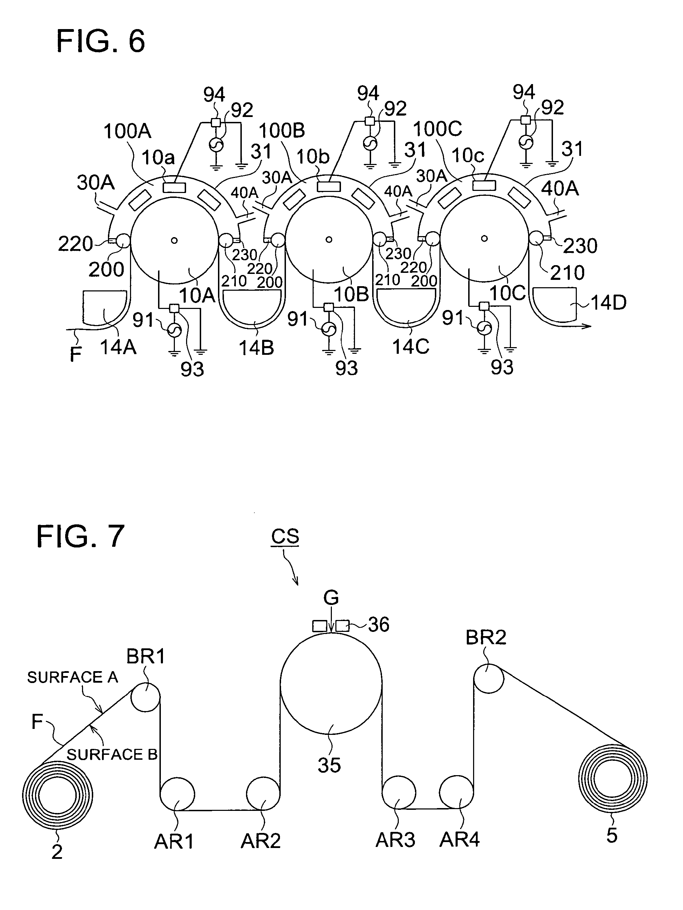

Similarly to Fig. 5, a roll-out process and a roll-up process are not shown in the atmospheric pressure plasma discharge treatment apparatus shown in Fig. 6. Substrate F rolled out from a stock roll substrate in the form of a roll enters discharge treatment room 31 through nip roller 200 and partition 220 via non-contact conveyance system (floater) 14A, is taken by rotatable roll electrode 10A to be tightly transferred, and is subjected to a plasma discharge treatment at discharge section 100A formed between 10A and facing prismatic electrode 10a (reactive gas G supplied from reactive gas supply portion 30A, and gas G' after treatment ejected from exhaust outlet 40A). After this, the substrate is once moved out from the discharge treatment room via nip roller 210 and partition 230, the conveyance direction is subsequently reversed by another non-contact conveyance system (floater) 14B so as not to bring the treated surface into contact with a reversing roller, and the substrate is continuously subjected to the treatment after entering the same discharge treatment room again. This shows that discharge treatment room 31 possessing a rotatable roll electrode and three prismatic electrodes facing each roll electrode, and three successive plasma discharge treatment apparatuses. As a matter of course, the prismatic electrode may be placed singly in each discharge treatment room, or a plurality of prismatic electrodes may also be placed in each discharge treatment room.

At any rate, the surface subjected to the plasma discharge treatment is conveyed along with the curved surface with no-contact by non-contact conveyance systems 14A - 14D supporting a web continuously running through gas squirting-out from the gas outlet, and is subjected to the plasma discharge treatment in three discharge treatment rooms in this case.

Substrate F after treatment is transferred into the roll-up process to be rolled by a winder in non-contact of the discharge treatment surface via the last non-contact conveyance system.

In this apparatus, the non-contact conveyance system is placed immediately before plasma discharge treatment, and is usable as a residual heat device in order to avoid construction and deformation of the substrate caused by rapid increase of temperature in plasma discharge treatment.

Incidentally, roll electrodes 10A, 10B and 10C together with the prismatic electrode as shown in Fig. 6 have a structure in which a dielectric is coated on a conductive metal base material in the same manner as described before.

The distance between the facing roll electrode and the prismatic electrode is preferably 0.1 - 20 mm in view of uniform discharge depending on the distance of dielectric surface-to-dielectric surface, and more preferably 0.5 - 2 mm.

Three fixed electrodes (prismatic electrodes in this case) are placed along with the circumference in this case, but one electrode may be allowed to be placed, or a plurality of electrodes may also be allowed to be placed. The discharge area of the electrode is represented by the sum of the area of the total fixed electrodes facing the rotatable roll electrode. The discharge area can be enlarged by providing a plurality of electrodes.

Further, a structure capable of circulating a temperature adjustable medium (water, silicone oil or such) is employed in order to maintain a surface temperature of substrate F at a predetermined value by controlling the electrode surface temperature during plasma discharge treatment. Similarly, it is preferable to be allowed to adjust the temperature during discharge.

At discharge sections 100A - 100C formed between roll electrodes in the plasma discharge apparatus in Fig. 5, reciprocating substrate F is subjected to plasma discharge treatment to form films or to surface-modifying treatment.

Each of roll electrodes is used as the first electrode, and the prismatic electrode is used as the second electrode. Between roll electrodes 10A and prismatic electrode 10a, the first high frequency electric field with frequency ω1, electric field intensity V1, and current I1 is applied to roll electrode 10A by first power supply 91, and the second high frequency electric field with frequency ω2, electric field intensity V2, and current I2 is applied to facing prismatic electrode 10a by second power supply 92.

First filter 93 is placed between roll electrode (the first electrode) 10A and first power supply 91. It is designed that the current passing through the first electrode from first power supply 91 runs easily with the installation of first filter 93, and the current passing through the first power supply from second power supply 92 does not run easily with grounding the current running through from second power supply 92. Second filter 94 is also placed between facing prismatic electrode (the second electrode) 10a and second power supply 92. It is designed that the current passing through the second electrode from second power supply 92 runs easily with the installation of second filter 94, and the current passing through the second power supply from first power supply 91 does not run easily with grounding the current running through from first power supply 91.

Similarly in the discharge space between roll electrodes 10B and 10b, and between 10C and 10c, roll electrodes 10B and 10C are used as the first electrode, and prismatic electrodes 10b and 10c are used as the second electrode. Similarly, the first electrode is connected to first power supply 91 and filter 93, and the second electrode is connected to second power supply 92 and filter 94 to conduct the similar operation.

Further, similarly to the case of Fig. 5, the first electrode and the second electrode may be used as a prismatic electrode and a rotatable roll electrode, respectively. At any rate, similarly to the case of Fig. 5, it is preferable that the first electrode is connected to the first power supply, the second electrode is connected to the second power supply, the first power supply has a larger high frequency electric field intensity than that of the second power supply (V1 > V2), and the condition of current satisfies I1 < I2. Preferable current values are also the same values as described in the case of Fig. 5.

Examples of such the first power supply (high frequency power supply) employed in the atmospheric pressure plasma discharge treatment apparatus as shown in Figs. 5 and 6 include the following power supplies.

| Reference number | Manufacturer | Frequency | Product name |
| --- | --- | --- | --- |
| A1 | Shinko Electric Co., Ltd. | 3 kHz | SPG3-4500 |
| A2 | Shinko Electric Co., Ltd. | 5 kHz | SPG5-4500 |
| A3 | Kasuga Electric Works, Ltd. | 15 kHz | AGI-023 |
| A4 | Shinko Electric Co., Ltd. | 50 kHz | SPG50-4500 |
| A5 | Haiden Laboratory Inc. | 100 kHz* | PHF-6k |
| A6 | Pearl Kogyo Co., Ltd. | 200 kHz | CF-2000-200k |
| A7 | Pearl Kogyo Co., Ltd. | 400 kHz | CF-2000-400k |

Any of the above commercially available power supplies can be employed in the present invention.

Examples of the second power supply (high frequency power supply) also include the following power supplies.

| Reference number | Manufacturer | Frequency | Product name |
| --- | --- | --- | --- |
| B1 | Pearl Kogyo Co., Ltd. | 800 kHz | CF-2000-800k |
| B2 | Pearl Kogyo Co., Ltd. | 2 MHz | CF-2000-2M |
| B3 | Pearl Kogyo Co., Ltd. | 13.56 MHz | CF-5000-13M |
| B4 | Pearl Kogyo Co., Ltd. | 27 MHz | CF-2000-27M |
| B5 | Pearl Kogyo Co., Ltd. | 150 MHz | CF-2000-150M |

Any of the above commercially available power supplies can be employed in the present invention.

In the above power supplies, "*" represents an impulse high frequency power supply (100 kHz in continuous mode) manufactured by Haiden Laboratory Inc., and others are high frequency power supplies capable of applying electric field of only continuous sine wave.

In the present invention, electrodes capable of maintaining a uniform and stable discharge state is preferably employed in the atmospheric pressure plasma discharge treatment apparatus by supplying such an electric field.

In the present invention, the power applied between facing electrodes supplies a power (power density) of at least 1 $W/cm^2$ to the second electrode (the second high frequency electric field), energy is given to the film forming gas by generating plasma via excitation of the discharge gas to form a thin film. The upper limit of power supplied to the second electrode is preferably 50 $W/cm^2$, and more preferably 20 $W/cm^2$. The lower limit of power is preferably 1.2 $W/cm^2$. The discharge area ($cm^2$) refers to the area in the region where discharge is generated between electrodes.

Further, power density can be improved while uniformity of the second high frequency electric field is maintained, by supplying power (power density) of at least 1 $W/cm^2$ to the first electrode (first high frequency electric field), whereby more uniform plasma with higher density can be produced, resulting in improvement of film forming rate and film quality. Power supplied to the first electrode is preferably at least 5 $W/cm^2$. The upper limit of power supplied to the first electrode is preferably 50 $W/cm^2$.

The waveform of the high frequency electric field is not specifically limited. There are a continuous oscillation mode (called a continuous mode) with a continuous sine wave and a discontinuous oscillation mode (called a pulse mode) carrying ON/OFF discontinuously, and either may be used, but a method supplying the continuous sine wave at least to the second electrode side (the second high frequency electric field) is preferred in obtaining a uniform layer with high quality.

Though the unshown storage vessel to cut off the plasma discharge treatment process shown in Fig. 4 or 5 from the outside, or the storage vessel fitted with a discharge treatment room in Fig. 6 is preferably a glass vessel such as Pyrex ® glass, a metal vessel may be employed in the present invention when the vessel is insulated from the electrodes. For example, a polyimide resin or such may be attached on the inner surface of a frame made of aluminum or stainless steel, and the metal frame may also be insulated by thermally ceramics-spraying. In Fig. 4 or 5, the both side surfaces of both parallel electrodes (near the substrate surface) are preferably covered with the above-described material (up to the area close to the substrate).

As to an apparatus having a plasma discharge treatment process shown in Fig. 5 or Fig. 6, when potential supplied from each power supply is designed to be independently applied to each of roll electrodes and prismatic electrodes, film formation or surface forming treatment can be continuously conducted in the same treating vessel under the different conditions by being arranged to set a supply opening and a exhaust outlet for each different mixed gas in each discharge space. Further, the treatment can be conducted in the reverse direction by changing the conveyance direction of the substrate, and a plurality of films can be laminated by conducting reciprocating thin film formation and surface-modifying treatment, or such the treatment can be conducted in order.

In such the way, in the case of a plasma discharge treatment apparatus of the present invention according to any one of Structures 7 - 10, that is, a plasma discharge treatment apparatus comprising the steps of rolling out substrate F from a stock roll; transferring it from the roll-out step up to introduction of it into a plasma discharge treatment step after conveying it from the roll-out step; conducting the plasma discharge treatment shown in Fig. 4, Fig. 5 or Fig. 6; continuously conveying the treated substrate from the foregoing plasma discharge step to a roll-up step; and rolling up the substrate, failure caused by the substrate surface brought into contact with the guide roller and so forth is possible to be reduced, since minimum required rollers are only in contact with the substrate surface, whose rollers are a nip roller desired in the plasma discharge treatment step via removal of guide rollers brought into contact with treated substrate surface during the plasma discharge treatment step, and others such as a nip roller employed in order to shield air caused by conveyance of a web from the roll-out step to the plasma discharge treatment step, and the similar roller to convey the substrate to the roll-up step.

Accordingly, as described before, the tension control with a dancer roller is not preferable, and no measurement with the foregoing tension meter, but direct torque control of a winder (roll-up shaft) is preferable.

As a mixed gas employed for a plasma discharge treatment apparatus according to any one of Structures 7 - 10, the various gases are usable depending on the intended purpose such as thin film formation or surface-modifying treatment.

As to a plasma discharge treatment, such the reactive gas (raw material gas) is mixed with a discharge gas capable of easily becoming a plasma state and sent to the plasma discharge generation apparatus (discharge section). Nitrogen gas and/or an element of Group 18 of periodic table such as helium, neon, argon, krypton, xenon or radon are used for such the discharge gas. Of these, nitrogen, helium and argon are preferably used.

The above-described discharge gas is mixed with various reactive gases. For example, the reactive gas necessary to form a thin film is mixed, and supplied into the plasma discharge apparatus to form a layer, and to conduct surface modification.

The reactive gas is supplied in a ratio of the discharge gas to whole mixture of the gases of at least 50 %, though the ratio is varied depending on the properties of the layer to be formed.

As to preparation of a ceramic material layer, metal carbide, metal nitride, metal oxide, metal sulfide, metal halide and a mixture thereof (such as metal oxide-nitride, metal oxide-halide, and metal nitride-carbide) can be selectively produced for the ceramic material layer by selecting an organometal compound as the raw material, decomposition gas, decomposition temperature and applying electric power.

For example, silicon oxide is formed by using a silicon compound as the raw material and oxygen as the decomposition gas, and zinc sulfide is formed by using a zinc compound as the raw material and carbon disulfide as the decomposition gas. In the space of plasma, very high actively charged particles or active radicals exist in high density. Therefore, plural steps of chemical reaction are accelerated in very high rate in the plasma space and the elements being in the plasma space is converted to the chemically stable compound within extremely short duration.

Further, the state of the raw material compound may be gas, liquid or solid at room temperature and normal pressure. The gas can be directly introduced into the discharge space and the liquid and solid are used after vaporized by a method such as heating bubbling or applying ultrasonic wave. The raw material compound may be used after diluting with a solvent.

As such the raw material compound, an organometal compound is preferable, and the raw material compound is selected in accordance with the obtained ceramic material layer such as silicon oxide, titanium oxide and so forth, for example.

Examples of such the organic compound include silicon compounds such as silane, tetramethoxy silane, tetraethoxy silane, tetrapropoxy silane, tetrabutoxy silane and dimethyldimethoxy silane; alkoxy silanes; tinanium compounds such as titanium methoxide, titanium ethoxide and titanium isopropoxide; zirconium compounds such as zirconium n-propoxide and so forth; aluminum compounds such as aluminum ethoxide, aluminum triisopropoxide and aluminum isopropoxide; boron compounds such as diborane and tetraborane; tin compounds such as tin tetraethyl and tin tetramethyl; and other organic metal compounds such as antimony and zinc.

As the decomposition gas for decomposing the raw material gas containing the metal to form an inorganic compound, a hydrogen gas, a methane gas, an acetylene gas, a carbon monoxide gas, a carbon dioxide gas, a nitrogen gas, an ammonium gas, a nitrogen monoxide gas, a nitrogen oxide gas, a nitrogen dioxide gas, an oxygen gas, steam, a fluorine gas, hydrogen fluoride, trifluoroalcohol, trifluorotoluene, hydrogen sulfide, sulfur dioxide, carbon disulfide or a chlorine gas can be mixed in a reaction gas.

Various kinds of metal carbide, metal nitride, metal oxide, metal halide and metal sulfide can be obtained by suitably selecting a metal element-containing raw material gas and a decomposition gas.

The above-described discharge gas is mixed with the reaction gas, and the resulting gas is supplied into a plasma discharge generation apparatus (plasma generation apparatus) as a mixed gas for film formation to form a film.

Alkoxysilane, for example, TEOS (tetraethoxysilane) is utilized as a reaction gas to obtain a silicon oxide layer, and the silicon oxide layer having various compositions and properties can be obtained via the decomposition gas, the plasma discharge conditions and so forth.

The decomposition gas such as an oxygen gas as a reaction gas without using a metal compound is utilized with a discharge gas to conduct a substrate surface-modifying treatment, and also a silane compound or such having a fluorine atom among organic fluorine compounds is employed to conduct a surface-modifying treatment for hydrophobicity of the substrate surface.

It is also possible that a polymer thin film is formed by containing an organic compound in a thin film formation gas, and conducting a plasma polymerization on a substrate.

As an organic compound used for a plasma polymerization raw material component contained in a thin film formation gas, an organic compound such as a (meth)acrylic compound, an epoxy compound, or a monomer or oligomer of an oxetane compound and so forth is usable. The material of substrate treated by a plasma discharge treatment apparatus of the present invention is not specifically limited, but it is selected depending on a thin film formed on intended usage such as a substrate, a surface-modifying treatment and so forth. For example, when a gas barrier layer is formed on a resin film to make a substrate of an organic EL element transparent, the resin film is preferably transparent.

As the substrate, a long length plastic (resin) film, paper, nonwoven fabric and so forth are listed as usage, but a resin film is preferable. The resin film is not specifically limited.

Specific examples of the usable films are as follows. Homopolymers such as ethylene, polypropylene, butene, or copolymers or polyolefin (PO) resins such as copolymers; amorphous polyolefin resins (APO) such as cyclic polyolefins; polyester resins such as polyethylene terephthalate (PET) and polyethylene 2,6-naphthalate (PEN); polyamide (PA) resins such as nylon 6, nylon 12 and copolymer nylon; polyvinyl alcohol resins such as polyvinyl alcohol (PVA) resins and ethylenevinyl alcohol copolymers (EVOH); polyimide (PI) resins; polyether imide (PEI) resins; polysulfone (PS) resins; polyether sulfone (PES) resins; polyether ether ketone (PEEK) resins; polycarbonate (PC) resins; polyvinyl butyrate (PVB) resins; polyarylate (PAR) resins; fluorine resins such as ethylene-tetrafluoroethylene copolymers (ETFE), ethylene trifluorochloride (PFA), ethylene tetrafluoride-perfluoroalkyl vinyl ether copolymers (FEP), vinylidene fluoride (PVDF), vinyl fluoride (PVF), and perfluoroethylene-perfluoropropylene-perfluorovinyl ether copolymers (EPA). One obtained by laminating or coating at least one of these resins is usable as a resin film.

These may be used singly or as an admixture of two or more thereof. ZEONEX or ZEONOR (produced by Nippon Zeon Corporation, an amorphous cyclopolyolefin film ARTON (produced by JSR Corporation), a polycarbonate film PUREACE (produced by Teijin Limited), and a cellulose triacetate film KONICATAC KC4UX, KC8UX (produced by Konica Minilta Opto, Inc.) available on the market are preferably used.

The above-described resin may also be unstretched or stretched.

The resin film is advantageous in the case of long length one rolled in the form of a roll. The thickness can not be categorically specified, depending on usage of the resulting products or the intermediate media, but the resin film has a thickness of 3 - 400 μm, preferably a thickness of 10 - 200 μm, and more preferably a thickness of 6 - 30 μm in view of a variety of uses such as a gas barrier film applied for conveyance and package, for example.

The thin film such as the foregoing ceramic layer or metal oxide film, for example is formed on the substrate via a plasma discharge treatment apparatus of the present invention of any one of Structures 7 - 10, whereby a film with a functional thin film such as a gas barrier film, an anti-reflection layer or a transparent conductive film exhibiting high quality can be effectively obtained. Further, hydrophilic treatment, hydrophobic treatment, surface roughened treatment and surface-modifying treatment are effectively conducted in high quality with a plasma discharge treatment apparatus.

Next, when a gas barrier thin layer is formed on a substrate via plasma discharge treatment to prepare a gas barrier film in order to accomplish the second objective of the present invention, a method of manufacturing a gas barrier film according to any one of Structures of 11 - 15, in which crack failure in particular is largely reduced, will be described.

A gas barrier film is prepared on a substrate with a plasma CVD method by forming an adhesion layer, a ceramic layer and a protective layer (hereinafter, the foregoing films formed on the substrate are collectively referred to as a gas barrier layer) by selecting an organometal compound as raw material, decomposition gas, decomposition temperature and applied electric power.

Since these gas barrier layers formed on the substrate include a metal oxide thin film, failure such as cracks and the like tends to be generated during thin film formation. Reduction of cracks generated on the thin film surface as one of the surface failures is accomplished by utilizing a method of manufacturing a gas barrier film according to any one of Structures 11 - 15.

Next, a method of manufacturing a gas barrier film according to any one of Structures 11 - 15 of the present invention will be described in detail.

After considerable effort during intensive studies, the inventors have found out that realized can be a method of manufacturing a gas barrier film exhibiting a high gas barrier property generated by reducing failure (failure caused by cracks) during gas barrier thin layer formation via the method of manufacturing a gas barrier film comprising a continuously conveyed resin film having a curvature and provided thereon, a gas barrier thin layer formed via a plasma CVD method, wherein surface A on the gas barrier thin layer side of the resin film has a curvature radius during conveyance of at least 75 mm, and surface B on an opposite side of the surface A, on which no gas barrier thin layer is formed, has a curvature radius of at least 37.5 mm; and the inventors have accomplished the present invention.

Next, the present invention will be described in detail.

«Method of manufacturing gas barrier film»

It is a feature in the present invention that a method of manufacturing a gas barrier film comprising a continuously conveyed resin film having a curvature and provided thereon, a gas barrier thin layer formed via a plasma CVD method, wherein surface A on the gas barrier thin layer side of the resin film has a curvature radius during conveyance of at least 75 mm, and surface B on an opposite side of the surface A, on which no gas barrier thin layer is formed, has a curvature radius of at least 37.5 mm.

Herein, curvature radius of surface A or surface B means a curvature radius of a curvature surface formed by an outer surface of a gas barrier film.

When continuously conveying a gas barrier film comprising a resin film and provided thereon, a gas barrier thin layer formed via a plasma CVD method, no excessive compression stress is given to the gas barrier thin layer, whereby damage of the resulting thin layer can be effectively prevented by setting a curvature radius to at least 75 mm during conveyance of the surface with regard to surface A on the resulting gas barrier thin layer side of the resin film. Further, no excessive tension stress is given to the resulting gas barrier thin layer, whereby generation of cracks and the like of the resulting thin layer can be prevented by setting a curvature radius to at least 37.5 mm during conveyance of the surface with regard to surface B on the opposite side of the surface A, on which no gas barrier thin layer is formed.

A means to realize the above-described condition specified in the present invention may be employed with a contact conveyance method while being supported with a guide roller, or may be employed with a non-contact conveyance method in which a non-contact conveyance system (called a floater or an air-loop) is provided in a curvature portion, and the floater shape is appropriately selected.

The upper limit of diameter of each guide roller used for the contact method is not specifically limited, but guide roller AR brought into contact with surface A preferably has a diameter of at least 150 mm and at most 2000 mm, and guide roller BR brought into contact with surface B preferably has a diameter of at least 75 mm and at most 1000 mm in view of realization of a large size equipment fitted with a larger roller diameter, or of stable conveyance.

Fig. 7 is a schematic diagram showing an example of a production line of a gas barrier film prepared via a batch method in the present invention.

In Fig. 7, substrate F as a resin film (comprising a polymer layer, if desired) is rolled out from laminated stock roll 2, and transferred into thin film formation station CS equipped with an atmospheric pressure plasma discharge treatment apparatus to form a gas barrier thin layer via guide roller BR1 brought into contact with the back surface of a resin film (surface B), and guide rollers AR1 and AR2 each brought into contact with the surface of the resin film (surface A). Gas G containing a gas barrier thin layer forming compound is fed into a plasma discharge section composed of rotatable roll electrode 35 and prismatic fixed electrode pair 36 to excite the gas, and to form a gas barrier thin layer on resin film F. Subsequently, it is rolled up via guide rollers AR3 and AR4, and guide roller BR2 by roll-up roller 5. Only rotatable roll electrode 35, prismatic fixed electrode 36 and gas G are shown in the atmospheric pressure plasma discharge treatment apparatus for the sake of simplicity, and the description of other necessary sections is omitted. The atmospheric pressure plasma discharge treatment apparatus of the present invention will be described in detail later on.

In this case, guide rollers AR3 and AR4 (guide rollers being in contact with surface A) each through which a resin film comprising a gas barrier thin film passes are designed to have a roll diameter of at least 150 mm, and guide roller BR2 (guide roller being in contact with surface B) is designed to have a roll diameter of at least 75 mm. In this case, roll-up roll 5 is understandably desired to have a diameter of at least 75 mm in the case of the roll-up by setting the surface on which a gas barrier thin layer is formed on the outer side as shown in Fig. 1, and also desired to have a diameter of at least 150 mm in the case of the roll-up by setting the surface on which a gas barrier thin layer is formed on the inner side.

As to the method described above, in the case of a method of manufacturing a gas barrier film comprising a resin film and provided thereon, an adhesion layer, a ceramic layer, a protective layer, roll-up roller 5 is employed again as stock roll 2 after providing an adhesion layer by the above-described method, and a ceramic layer is similarly formed in the second step and is further rolled up to subsequently form a protective layer in the third step in the similar manner. In the case of formation of a multilayer via such the batch method, as to guide rollers AR1 - AR4 (guide rollers being in contact with surface A) through which a resin film comprising a gas barrier thin layer (an adhesion layer or a ceramic layer, for example) passes after the second step, any of the rollers has a diameter of at least 150 mm, and as to guide rollers BR1 and BR2 (guide rollers being in contact with surface B), any of the rollers has a diameter of at least 75 mm.

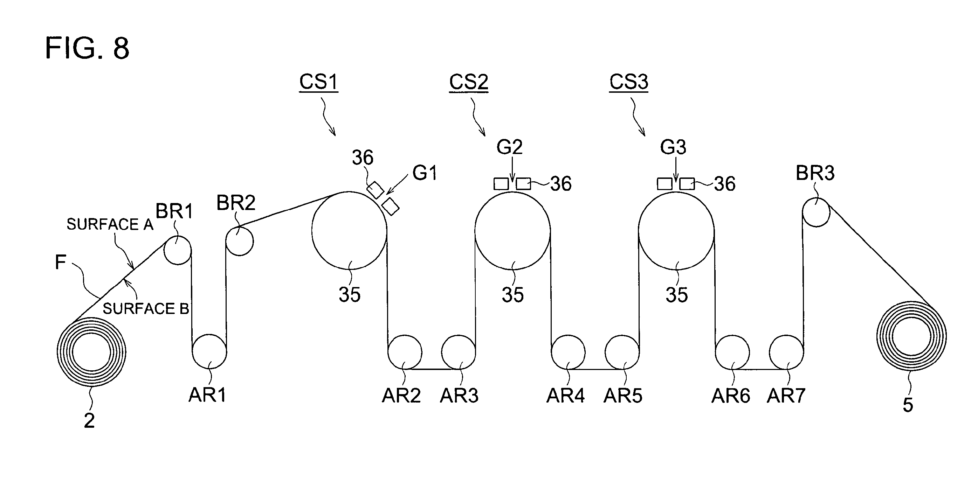

Fig. 8 is a schematic diagram showing one example of a production line of a gas barrier film fitted with a plurality of thin film forming stations employing an online system.

Fig. 8 is similar to Fig. 7 as far as the basic structure is concerned, but Fig. 8 shows that three stations (atmospheric pressure plasma treatment apparatuses) CS1 - CS3 are provided to form the gas barrier thin layer online, for example, an adhesion layer is formed by CS1 employing gas G1, a ceramic layer is formed by CS2 employing gas G2 continuously with no roll-up, and a protective layer is formed by CS3 employing gas G3. In this case, each diameter of guide rollers BR1, BR2 and AR1 brought into contact with substrate F (resin film) with no formation of a gas barrier thin layer is not specifically limited, but each of guide rollers AR2 - AR7 brought into contact with surface A of the resin film comprising a gas barrier thin layer is designed to have a diameter of at least 150 mm, and guide roller BR3 brought into contact with surface B is designed to have a diameter of at least 75 mm.

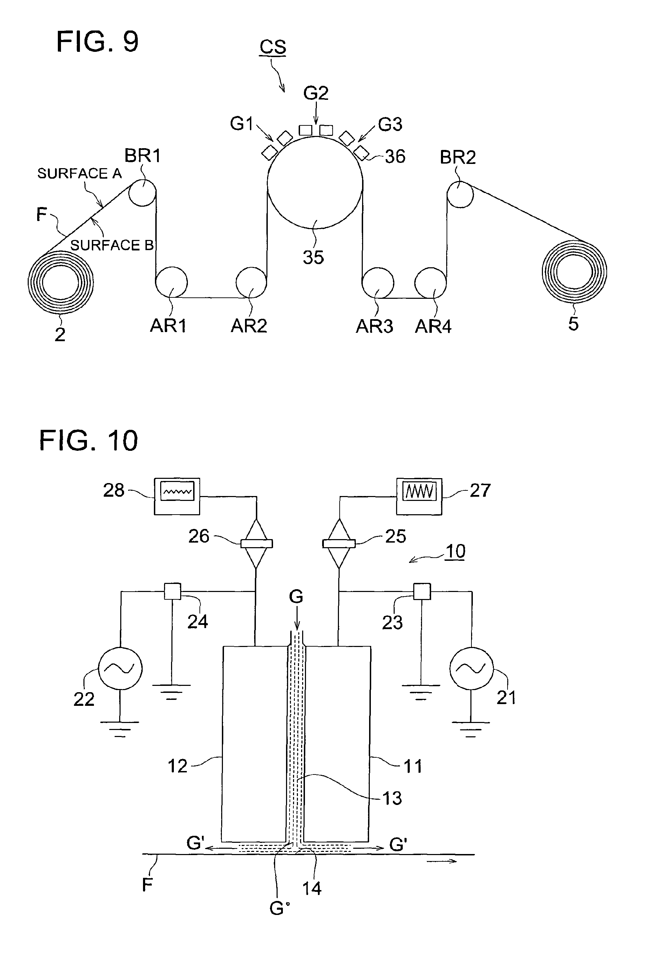

Fig. 9 is a schematic diagram showing another example of a production line of a gas barrier film fitted with a plurality of thin film forming stations employing an online system.

Fig. 9 is similar to Fig. 7 as far as the basic structure is concerned, but it relates to a method of manufacturing a gas barrier film in which a plurality of prismatic fixed electrodes 36 are provided in thin film forming station CS, and each of gases G1 - G3 having a different composition is supplied to continuously form an adhesion layer with gas G1, a ceramic layer with gas G2 and a protective layer with gas G3, for example.

Also in this case, each diameter of guide rollers BR1 and AR1 brought into contact with substrate F (resin film) with no formation of a gas barrier thin layer is not specifically limited, but each of guide rollers AR3 and AR4 brought into contact with surface A of the resin film after forming gas barrier multi-thin layers is designed to have a diameter of at least 150 mm, and guide roller BR2 brought into contact with surface B is designed to have a diameter of at least 75 mm.

Further, in a method of manufacturing a gas barrier film of the present invention, the resin film that is continuously conveyed preferably has a conveyance tension of not less than 50 N/m and not more than 200 N/m, and more preferably has a conveyance tension of not less than 80 N/m and not more than 150 N/m in view of prevention of cracks and failure of the resulting gas barrier thin layer and stable conveyance. In the case of a conveyance tension of at least 50 N/m, stable conveyance can be obtained, whereby an even coating layer can be formed, and in the case of a conveyance tension of at most 200 N/m, no excessive strain can be obtained in a gas barrier thin layer formed on the conveyed resin film, whereby generation of cracks and failure can be prevented.

«Gas barrier thin layer»

Next, the gas barrier thin layer of the present invention will be described in detail.

The gas barrier thin layer of the present invention may be at least one thin layer exhibiting a gas barrier property, but a multilayer structure having at least two gas barrier thin layers is preferable, and the structure comprising an adhesion layer, a ceramic layer and a protective layer provided from the resin film side is also preferable in view of acquisition of a higher degree of water vapor barrier and oxygen barrier.

In the structure having an adhesion layer, a ceramic layer and a protective layer, density of the ceramic layer is preferably higher than that of each of the adhesion layer as a lower film and the protective layer as an upper film. Stress relaxation can be received by further improving flexibility in comparison to the high density ceramic layer exhibiting high gas barrier when making a multilayer structure fitted with a ceramic layer, since each of the adhesion layer and the protective layer becomes a low packing ratio film exhibiting slight flexibility by setting density of each of the adhesion layer and the protective layer lower than that of the ceramic layer. Not only the adhesion layer relaxes stress from outside at the same time, but also adhesion of the ceramic layer to a substrate or the after-mentioned polymer film is improved to upgrade bending resistance. Not only the protective layer further relaxes stress from outside, but also a dense ceramic layer exhibiting high hardness covers a weak property against stress from outside and a breakable property caused by bending or such to provide the post-process suitability as to formation of a transparent conductive layer and so forth in a method of preparing an organic EL element, for example.

Each of the adhesion layer, the ceramic layer and the protective layer of the present invention (collectively also called a gas barrier layer) preferably has a thickness of 0.1 - 5000 nm, and more preferably has a thickness of 1 - 2000 nm, depending on the optimal conditions regarding kinds and constitution of the usable material. In the case of the gas barrier layer thickness thinner than the above-described range, uneven films are obtained since it is difficult to obtain gas barrier. Further, the ceramic layer specifically has a thickness of 0.1 - 5000 nm, and preferably has a thickness of 1 - 1000 nm. In the case of the ceramic layer thickness thicker than the above-described range, cracks caused by external factors such as bending after film formation, stain and so forth tend to be generated in the gas barrier resin substrate, since it is difficult to keep making the gas barrier film to exhibit flexibility.

The foregoing adhesion layer plays a role in stress relaxation, and is a layer to improve adhesion to a substrate at the same time. The adhesion layer preferably has a thickness of 1 - 500 nm, and more preferably 20 - 200 nm.

The protective layer also has a thickness of 1 - 1000 nm, and preferably has a thickness of 100 - 800 nm in order to protect the ceramic layer.

As to the gas barrier layer of the present invention, each of the films is a layer to block permeation of oxygen as well as water vapor, but the composition and so forth are not specifically limited. The gas barrier layer of the present invention such as an adhesion layer, a ceramic layer or a protective layer specifically contains the similar ceramic material, and examples of the ceramic material include metal carbide, metal nitride, metal oxide, metal sulfide, metal halide and a mixture thereof (such as metal oxide-nitride, metal oxide-halide or metal nitride-carbide). Of these, metal oxide, metal oxide-nitride, metal oxide-halide and metal nitride-carbide are preferable. Specific examples thereof include silicon oxide, aluminum oxide, silicon nitride, silicon oxide nitride, aluminum oxide nitride, magnesium oxide, zinc oxide, indium oxide and tin oxide. Of these, silicon oxide, silicon oxide nitride, silicon nitride, aluminum oxide and a mixture thereof are preferable.

A plasma CVD method is employed as a method of forming an adhesion layer, a ceramic layer and a protective layer on a substrate in order, but specifically, the after-mentioned atmospheric pressure or approximately atmospheric pressure plasma CVD method is preferably employed.

The gas barrier layer of the present invention is preferably formed from a plurality of layers each having the identical composition as well as having different density in view of adhesion and stable thin film formation. This depends on variations of properties such as density and so forth by generating difference in a degree of filling ceramic particles and also in a slight amount of mixed impurity particles via the manufacturing condition, or the kind and ratio of usable raw material even for the identical composition.

The adhesion layer and the protective layer of the present invention each have the same composition as that of the ceramic layer, have lower film density than that of the ceramic layer, and have a density of 95% or less, base on the density of the ceramic layer. These layers have low density, and exhibit not so much performance to block water vapor in comparison to the ceramic layer but flexibility. These layers can play a role as a stress relaxation layer, an adhesion layer or a protective layer while being the layer having the identical composition.

In the present invention, a multilayer film composed of gas barrier layers is preferably formed by a atmospheric pressure plasma CVD method. Accordingly, in the present invention, the thin film forming gas containing a raw material gas and a discharge gas is supplied into discharge space under atmospheric pressure or approximately atmospheric pressure to excite the gas via application of high frequency electric field to the discharge space, and a resin substrate on which gas barrier layers are formed are exposed to the foregoing excited gas to preferably form at least one of the adhesion layer, the ceramic layer and the protective layer, or all the layers on a substrate employing the atmospheric pressure or approximately atmospheric pressure plasma CVD method.

"Approximately atmospheric pressure" means a pressure of 20 - 110 kPa, but the foregoing pressure is preferably 93 - 104 kPa in order to obtain the effects as described in the present invention.

As to thin film formation via the atmospheric pressure or approximately atmospheric pressure plasma CVD method as described above, thin film forming gas is mainly composed of a raw material gas to form a thin film, a decomposition gas to obtain a thin film forming compound by decomposing the raw material, and a discharge gas to produce a plasma state.

In the present invention, the adhesion layer, the ceramic layer and the protective layer formed on a substrate preferably have approximately the similar composition. For example, in thin film formation via the foregoing atmospheric pressure or approximately atmospheric pressure plasma CVD method, thin film forming gases each having the identical composition is preferably employed, and the very stable production becomes possible since no impurity is to be mixed because of the foregoing identical composition. Further, a transparent gas barrier film having excellent adhesiveness even when stored under severe conditions, and exhibiting favorable transparency and gas barrier resistance can also be obtained.

As to the gas barrier film of the present invention, a method of forming an adhesion layer, a ceramic layer and a protective layer each composed of a desired structure are not limited, but not only optimal raw material should be selected, but also a raw material gas, a composition ratio of the decomposition gas and the discharge gas, a supply rate of the thin film forming gas into a plasma discharge generation apparatus, an output condition during plasma discharge treatment or such is preferably selected.

Next, the structure elements of the gas barrier film in the present invention will be described.

<Adhesion layer, ceramic layer and protective layer>

Raw material employed for preparation of an adhesion layer, a ceramic layer and a protective layer of the present invention (hereinafter, collectively called gas barrier layers) will be described.

In the plasma CVD method or the atmospheric pressure plasma CVD method, a metal carbide, metal nitride, metal oxide, metal sulfide, metal halide and a mixture thereof (such as metal oxide-nitride, metal oxide-halide, and metal nitride-carbide) can be selectively produced for the gas barrier layer by selecting an organometal compound as the raw material, decomposition gas, decomposition temperature and applying electric power.

For example, silicon oxide is formed by using a silicon compound as the raw material and oxygen as the decomposition gas, and zinc sulfide is formed by using a zinc compound as the raw material and carbon disulfide as the decomposition gas. In the space of plasma, very high actively charged particles or active radicals exist in high density. Therefore, plural steps of chemical reaction are accelerated in very high rate in the plasma space and the elements being in the plasma space is converted to the chemically stable compound within extremely short duration.

The state of the inorganic raw material may be gas, liquid or solid at room temperature as far as the raw material contains a typical metal element or a transition metal element. The gas can be directly introduced into the discharge space and the liquid or solid is used after vaporized by a method such as heating bubbling or applying ultrasonic wave. The raw material may be used after diluting with a solvent. An organic solvent such as methanol, ethanol, n-hexane and a mixture thereof can be used for such the solvent. The influence of the solvent can be almost ignored because the solvent is decomposed into molecular or atomic state by the plasma discharge treatment.

Examples of such the organic compound include a silicon compound such as silane, tetramethoxysilane, tetraethoxysilane, tetra-n-propoxysilane, tetra-isopropoxsilane, tetra-n-butoxysilane, tetra-t-butoxysilane, dimethyldimethoxysilane, dimethyldiethoxysilane, diethyldimethoxysilane, diphenylsimethoxysilane, methyltriethoxysilane, ethyltrimethoxysilane, phenyltriethoxysilane, (3,3,3-trifluoropropyl)trimethoxysilane, hexamethyldisyloxane, bis(dimethylamino)dimethylsilane, bis(dimethylamino)methylvinylsilane, bis(ethylamino)dimethylsilane, N,O-bis(trimethylsilyl)acetoamide, bis(trimethylsilyl)carbodiimide, diethylaminotrimethylsilane, dimethylaminodimethylsilane, hexamethyldisilazane, heaxamethylcyclotrisilazane, heptamethylsilazane, nonamethyltrisilazane, octamethylcyclotetrasilazane, tetrakisdimethyaminosilazane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiine,di-t-butylsilane, 1,3-disilabutane, bis(trimethylsilyl)methane, cyclopentanedienyltrimethylsilane, phenyldimethylsilane, phenyltrimethylsilane, propagyltrimethylsilane, tetramethylsilane, trimethylsilylacetylene, 1-(trimethylsilyl)-1-propine, tris(trimehtylsilyl)methane, tris(trimethylsilyl)silane, vinyltrimethylsilane, hexamethyldisilane, octamethylcyclotetrasiloxane, tetramethylcyclotetrasiloxane, heaxmethylcycrotetrasiloxane and M-silicate 51.

Examples of the titanium compound include titanium methoxide, titanium ethoxide, titanium isopropoxide, titanium tetraisoboroxide, titanium n-butoxide, titanium isopropoxide(bis-2,4-pentanedionate), titanium diisopropoxide(bis-2,4-ethylacetoacetate), titanium di-n-butoxide(bis-2,4-pentanedionate), titanium caetylacetonate and butyl titanate dimer.

Examples of the zirconium compound include zirconium n-propoxide, zirconium n-butoxide, zirconium t-butoxide, zirconium tri-n-butoxide acetylacetonate, zirconium di-n-butoxide bisacetylacetonate, zirconium acetylacetonate, zirconium acetate and zirconium heaxafluoropentanedionate.

Examples of the aluminum compound include aluminum ethoxide, aluminum triisopropoxise, aluminum isopropoxide, aluminum n-butoxide, aluminum s-butoxide, aluminum t-butoxide, aluminum acetylacetonate and triethyldialuminum tri-s-butoxide.

Examples of the boron compound include diborane, boron fluoride, boron chloride, boron bromide, borane-diethyl ether complex, borane-THF complex, borane-dimethyl sulfide complex, borane trifluoride-diethyl ether complex, triethylborane, trimethoxyborane, triethoxyborane, tri(isopropoxy)borane, borazole, trimethylborazole, triethylborazole and triisopropylborazole.

Examples of the tin compound include teraethyltin, tetramethyltin, diaceto-di-n-butyltin, terabutyltin, tetraoctyltin, tetraethoxytin, methyltriethoxytin, diethyldiethoxytin, triisopropylethoxytin, diethyltin, dimethyltin, diisopropyltin, dibutyltin, diethoxytin, dimethoxtin, diisopropoxytin, dibutoxytin, tin dibutylate, tin acetoacetonate, ethyltin acetoacetonate, ethoxytin acetoacetonate, dimethyltin acetoacetonate, tin hydride and tin halide such as tin dichloride and tin tetrachloride.

Examples of other organic metal compounds include antimony ethoxide, arsenic triethoxide, barium 2,2,6,6-tetramethylheptanedionate, beryllium acetylacetonate, bismuth hexafluoropnetanedionate, dimethylcadmium, calcium 2,2,6,6-tetramethylheptanedionate, chromium trifluoropentanedionate, cobalt cetylacetonate, copper hexafluoropentanedionate, magnesium heaxfluoropentane-dionate-dimethyl ether complex, gallium ethoxide, tetraethoxygermanium, hafnium t-butoxide, hafnium ethoxide, indium acetylacetonate, indium 2,6-dimethylamino-heptanedionate, ferrocene, lanthanum isopropoxide, lead acetate, tetraethyllead, neodium acetylacetonate, platinum hexafluoropentanedionate, trimethylcyclopentanedienyl-platinum, rhodium dicarbonylacetylacetonate, strontium 2,2,6,6-tetramethylheptanedionate, tantalum methoxide, tantalum trifluoroethoxide, tellurium ethoxide, tungsten ethoxide, vanadium triisopropoxideoxide, magnesium hexafluorocetylacetonate, zinc acetylacetonate and diethylzinc.

Examples of the decomposition gas for decomposing the raw material gas containing the metal to form an inorganic compound include hydrogen gas, methane gas, acetylene gas, carbon monoxide gas, carbon dioxide gas, nitrogen gas, ammonium gas, nitrogen monoxide gas, nitrogen oxide gas, nitrogen dioxide gas, oxygen gas, steam, fluorine gas, hydrogen fluoride, trifluoroalcohol, trifluorotoluene, hydrogen sulfide, sulfur dioxide, carbon disulfide and chlorine gas.

Various kinds of metal carbide, metal nitride, metal oxide, metal halide and metal sulfide can be obtained by suitably selecting the metal element-containing raw material gas and the decomposition gas.

Such the reactive gas is mixed with a discharge gas capable of easily becoming a plasma state and sent to the plasma discharge generation apparatus. Nitrogen gas and/or an element of Group 18 of periodic table such as helium, neon, argon, krypton, xenon or radon are used for such the discharge gas. Of these, nitrogen, helium and argon are preferably used.

The discharge gas and the reactive gas are mixed to prepare a mixed gas and supplied into the plasma discharge (plasma generating) apparatus to form the layer. The reactive gas is supplied in a ratio of the discharge gas to whole mixture of the gases of at least 50 %, though the ratio is varied depending on the properties of the layer to be formed.

As to the gas barrier layer of the present invention, an inorganic compound contained in the gas barrier layer is preferably at least one selected from silicon oxide, silicon oxide nitride, silicon nitride, aluminum oxide and mixture thereof, but silicon oxide is preferable in view of gas barrier against water vapor, oxygen and so forth, light transparency and atmospheric pressure plasma CVD suitability.

The inorganic compound of the present invention may be combined with the above organic silicon compound as well as oxygen gas or nitrogen gas in a prescribed proportion, and a layer containing at least one of O atoms and N atoms, and Si atoms can be obtained.

In order to obtain a stable gas barrier film exhibiting gas barrier performance unvaried under severe conditions, specifically a ceramic layer among gas barrier layers of the present invention, that is, an adhesion layer, a ceramic layer and a protective layer each having the identical composition, preferably has a compression stress of 0 - 20 Mpa.

The gas barrier layer formed by a plasma CVD method, specifically an atmospheric pressure plasma CVD method, in comparison to a sol-gel method, vacuum evaporation method and a sputtering method can be a layer having small internal stress and distortion.

Accordingly, the ceramic layer formed by this method means a layer having high density together with less internal stress and distortion of the film, and the ceramic layer of the present invention preferably has a compression stress of as low as 0 - 20 Mpa since this means the film has a smooth surface, which is strong against deformation caused by bending and the like.

In the case of very small stress, tensile stress partially tends also to appear, whereby cracks are easily generated in a film, resulting in a film exhibiting no durability, and in the case of very small stress, the film becomes breakable.

«Polymer layer»

In the present invention, a polymer film is preferably formed between the foregoing adhesion layer and the resin film substrate. This is done for the purpose of improving adhesiveness between an adhesion layer specifically among gas barrier layers and the resin film substrate. Further, when Tg of the polymer film higher than that of the resin film substrate is selected, this contributes to improving of adhesion during exposure under severer conditions since expansion and contraction caused by heat can be suppressed.

The polymer film has a thickness of 0.1 - 10 μm, and preferably has a thickness of 0.5 - 10 μm.

A resin coat layer such as an acrylic resin, a polyester resin or a urethane resin is preferable as a polymer resin, and easily formed on a substrate by coating the corresponding resin solution employing a commonly known method such as a roll coat method, a gravure coat method, a dip coat method or a spray coat method.

In the present invention, the polymer layer is preferably formed from a thermosetting resin or an actinic radiation curable resin, and specifically, a resin curable layer is preferably formed from a UV curable resin. In addition, the surface of a resin substrate (film) is preferably subjected to corona discharge treatment or glow discharge treatment before forming the foregoing layer.

The resin curable layer is preferably a layer formed by polymerizing a component containing at least one monomer having an ethylenic unsaturated bond. As the resin layer formed by polymerizing a component containing at least one monomer having an ethylenic unsaturated bond, preferably employed is a layer formed by curing an actinic radiation curable resin or a thermosetting resin, but the actinic radiation curable resin layer is specifically preferable. The actinic radiation curable resin layer herein means a layer in which a resin cured via crosslinking reaction upon exposure of actinic radiation such as UV or electron beam.

The UV curable resin, the electron beam curable resin or such is typically exemplified as an actinic radiation curable resin, but exemplified may be a resin cured via exposure of actinic radiation other than UV and electron beam.

A UV curable type urethane acrylate based resin, a UV curable type polyester acrylate-based resin, a UV curable type epoxy acrylate based resin, a UV curable type polyol acrylate based resin or a UV curable type epoxy resin is exemplified as the UV curable resin, but a UV curable type urethane acrylate based resin, a UV curable type polyester acrylate-based resin, a UV curable type epoxy acrylate based resin and a UV curable type polyol acrylate based resin in which acryl is employed as a principal component are preferable.

Examples thereof include trimethylol propane triacrylate, ditrimethylol propane tetraacrylate, pentaerythritol triacrylate, pentaerythritol tetraacrylate, dipenta erythritol hexaacrylate, alkyl modified dipenta erythritol pentaacrylate and so forth.

The UV curable type acryl urethane based resin can be easily obtained when the product obtained by causing the isocyanate monomer or prepolymer with the polyester polyol is again made to react with the acrylate based monomer containing a hydroxyl group such as 2-hydroxy ethyl acrylate, 2-hydroxy ethyl methacrylate (hereinafter the acrylate alone will be illustrated on the assumption that the acrylate contains methacrylate) and 2-hydroxypropyl acrylate. For example, the substances disclosed in Japanese Patent O.P.I. Publication No. 59-151110 can be used.

The UV curable type polyester acrylate based resin can be obtained easily when 2-hydroxy ethyl acrylate and 2-hydroxy acrylate-based monomer is made to react with polyester polyol. The substances disclosed in Japanese Patent O.P.I. Publication No. 59-151112 can be employed.

The UV curable type epoxy acrylate based resin can be produced, for example, by adding a reactive diluent and a photo reaction initiator to the epoxy acrylate as oligomer so as to cause reaction. The substances listed in Japanese Patent O.P.I. Publication No. 1-105738 can be utilized.

Examples of the photo-reaction initiator include benzoyl, its derivative, acetophenone, benzophenone, hydroxy benzophenone, Michler's ketone, $\alpha$-amyloxime ester, thioxanthone and derivatives thereof. They can be used in combination with a photosensitizer.

The foregoing photo-reaction initiator can be used as a photosensitizer. When using the epoxy acrylate based photo-reaction initiator, a sensitizer such as n-butyl amine, triethylamine and tri-n-butyl phosphine can also be employed.

A general monomer such as methyl acrylate, ethyl acrylate, butyl acrylate, benzyl acrylate, cyclohexyl acrylate, vinyl acetate or styrene can be mentioned as a resin monomer, for example, as a monomer with an unsaturated double bond. Ethylene glycol diacrylate, propylene glycol diacrylate, divinyl benzene, 1,4-cyclohexane diacrylate, 1,4-cyclohexyl dimethyl diacrylate, the foregoing trimethylol propane triacrylate and pentaerythritol tetraacryl ester can be mentioned as a monomer having two or more unsaturated double bonds.

The commercially available products of the UV curable resin that can be used in the present invention is exemplified by Adeca Optomer KR.BY Series: KR-400, KR-410, KR-550, KR-566, KR-567, BY-320B (by Asahi Denka Co., Ltd.); Koei Hard A-101-KK, A-101-WS, C-302, C-401-N, C-501, M-101, M-102, T-102, D-102, NS-101, FT-102Q8, MAG-1-P20, AG-106, M-101-C (by Koei Chemical Co., Ltd.); Seika-Beam PHC2210(S), PHC X-9(K-3), PHC2213, DP-10, DP-20, DP-30, P1,000, P1100, P1200, P1300, P1400, P1500, P1600, SCR900 (by Dainichiseika Color & Chemicals Mfg. Co., Ltd.); KRM7033, KRM7039, KRM7130, KRM7131, UVECRYL29201, UVECRYL29202 (by Daicel-UCB Co., Ltd.); RC-5015, RC-5016, RC-5020, RC-5031, RC-5100, RC-5102, RC-5120, RC-5122, RC-5152, RC-5171, RC-5180, RC-5181 (by Dainippon Ink and Chemicals Incorporated); Aurex No. 340 Clear (by Chugoku Marine Paints, Ltd.); Sanrad H-601, RC-750, RC-700, RC-600, RC-500, RC-611, RC-612 (by Sanyo Chemical Industries, Ltd.); SP-1509, SP-1507 (by Showa Kobunshi Co., Ltd.); RCC-15C (by Grace Japan), Aronix M-6100, M-8030, M-8060 (by Toagosei Co., Ltd.). An appropriate product can be selected for use from among them.

These actinic radiation curable resin layers can be utilized for coating employing a commonly known method.

As a light source to cure a UV curable resin via light curing reaction, the light source can be utilized with no limitation, provided that it is a light source to generate UV radiation, and examples thereof include a low-voltage mercury lamp, an intermediate voltage mercury lamp, a high-voltage mercury lamp, an extra high-voltage mercury lamp, a carbon arc lamp, a metal halide lamp and a xenon lamp. The conditions of irradiation differ according to each of lamps, but the exposure amount of light is 20 - 10000 mJ/cm$^2$, and preferably 50 - 2000 mJ/cm$^2$. The resin can be efficiently formed by using a sensitizer exhibiting absorption maximum in the region through the near-ultraviolet region to the visible light region.

The organic solvent of the UV curable resin layer composition coating solution is appropriately selected from hydrocarbons, alcohols, ketones, esters, glycolethers and other organic solvent, for example. Alternatively, they can also be mixed for use. It is preferred to use the foregoing organic solvent containing at least 5% by weight, more preferably 5 - 80% by weight of propylene glycolmonoalkyl ether (the alkyl group has 1 - 4 carbon atoms) or propylene glycol monoalkylether acetate ester (the alkyl group has 1 - 4 carbon atoms).

As the coating amount of the UV curable resin layer composition coating solution, a wet thickness of 0.1 - 30 $\mu$m is appropriate, and a wet thickness of 0.5 - 15 $\mu$m is preferable. The UV curable resin composition may preferably be exposed to ultraviolet rays during or after the process of coating and drying. The duration of exposure is preferably 0.5 seconds - 5 minutes, and more preferably 3 seconds - 3 minutes in view of curing efficiency and operation efficiency of the UV curable resin.

A plasma polymerizable film formed as a polymer film of the present invention by the foregoing atmospheric pressure plasma CVD method is a preferable polymer film. That is, in the atmospheric pressure plasma CVD method, at least one organic compound is contained in a thin film forming gas, and the organic compound is plasma-polymerized to form a polymer film.

In the atmospheric pressure plasma CVD method, the thin film forming gas is composed of a discharge gas and a raw material compound, and an addition gas may further be employed.

Commonly known organic compounds can be utilized as the organic compound as a raw material component of the present invention. Of these, the organic compound having at least one unsaturated bond or cyclic structure in the molecule is preferably used. Specifically, the monomer or oligomer of a (meth)acryl compound, an epoxy compound or an oxetane compound is preferably employed, but acryl as a principal component such as acryl or a methacryl compound is more preferable.

The useful (meth)acryl compound is not specifically limited. Examples thereof are:

monofunctional acrylic acid esters such as 2-ethylhexylacrylate, 2-hydroxy propyl acrylate, glycerol acrylate, tetrahydrofurfuryl acrylate, phenoxy ethylacrylate, nonylphenoxy ethylacrylate, tetrahydrofurfuryl oxyethylacrylate, tetrahydrofurfuryloxy hexanolide acrylate, acrylate of ε-caprolactone adduct of 1, 3-dioxane alcohol and 1, 3-dioxolaneacrylate; or
methacrylic acid ester wherein acrylate is replaced by methacrylate as exemplified by:

bifunctional acrylic acid esters such as ethylene glycolate diacrylate, triethylene glycol diacrylate, pentaerithritol diacrylate, hydroquinone diacrylate, resorcin diacrylate, hexanediol diacrylate, neopentyl glycolate diacrylate, tripropylene glycolate diacrylate, diacrylate of neopentylglycolate hydroxypivalate, diacrylate of neopentyl glycoladipate, diacrylate of ε-caprolactone adduct of neopentyl glycolate hydroxypivalate, 2-(2-hydroxy-1, 1-dimethylethyl)-5-hydroxymethyl-5-ethyl-1, 3-dioxane diacrylate, tricyclodecane di methylol acrylate, ε-caprolactone adduct of tricyclodecane di methylol acrylate, and diacrylate of diglycidyl ether of 1, 6-hexane diol; or
or methacrylic acid esters wherein acrylates are replaced by methacrylates as exemplified by:

multifunctional acrylic acid ester acids such as trimethylol propane triacrylate, di trimethylol propane tetraacrylate, trimethylol ethane triacrylate, penta erithritol triacrylate, penta erithritol tetraacrylate, dipenta erithritol tetraacrylate, dipenta erithritol pentaacrylate, dipenta erithritol hexaacrylate, ε-caprolactone adduct of dipenta erithritol hexaacrylate, pyrogallol triacrylate, propanoic acid/dipenta erithritol triacrylate, propanoic acid/dipenta erithritol tetraacrylate, hydroxy pivalylaldehyde denatured dimethylol propane triacrylate, or methacrylic acids wherein these acrylates are replaced by methacrylates. Compounds exemplified as the actinic radiation curable resin are also included.

Similarly to the case of the foregoing gas barrier layer, nitrogen, noble gas, air or such is provided as a discharge gas. The noble gas as an element of Group 18 of periodic table is provided. Examples of the discharge gas include helium, neon, argon, krypton, xenon and radon. Of these, in the present invention, nitrogen, helium and argon are preferable as the discharge gas, and nitrogen is more preferable.

As for plasma polymerization, the discharge gas is preferably contained in an amount of 70 - 99.99% by volume, based on the amount of thin film forming gas supplied into discharge space.

In a plasma polymerization method, an addition gas may be introduced into the foregoing raw material gas and discharge gas, and 0.001 - 30% by volume of hydrogen, oxygen, nitrogen oxide, ammonium, hydrocarbons such as methane and so forth, alcohols, organic acids or water as the addition gas may be mixed with respect to the foregoing gas.

«Resin film»

The resin film utilized as substrate with a gas barrier film in the present invention is not specifically limited, provided that it is a resin film capable of holding the foregoing gas barrier layer, and being continuously conveyed.

Specific examples of the usable films are as follows. Homopolymers such as ethylene, polypropylene, butene, or copolymers or polyolefin (PO) resins such as copolymers; amorphous polyolefin resins (APO) such as cyclic polyolefins; polyester resins such as polyethylene terephthalate (PET) and polyethylene 2,6-naphthalate (PEN); polyamide (PA) resins such as nylon 6, nylon 12 and copolymer nylon; polyvinyl alcohol resins such as polyvinyl alcohol (PVA) resins and ethylenevinyl alcohol copolymers (EVOH); polyimide (PI) resins; polyether imide (PEI) resins; polysulfone (PS) resins; polyether sulfone (PES) resins; polyether ether ketone (PEEK) resins; polycarbonate (PC) resins; polyvinyl butyrate (PVB) resins; polyarylate (PAR) resins; fluorine resins such as ethylene-tetrafluoroethylene copolymers (ETFE), ethylene trifluorochloride (PFA), ethylene tetrafluoride-perfluoroalkyl vinyl ether copolymers (FEP), vinylidene fluoride (PVDF), vinyl fluoride (PVF), and perfluoroethylene-perfluoropropylene-perfluorovinyl ether copolymers (EPA).

In addition to the above-described resins, further usable are light-curable resins and the admixture thereof such as a resin composition composed of an acrylate compound containing a radical reactivity unsaturated compound; a resin composition composed of a mercapto compound containing the acrylate compound and a thiol group; and a resin composition in which oligomer such as epoxyacrylate, urethaneacrylate, polyesteracrylate or polyetheracrylate is dissolved in a polyfunctional acrylate monomer. Also usable is a substrate film obtained via lamination with a laminating or coating technique employing at least one of these resins.

These may be used singly or as an admixture of two or more thereof. ZEONEX or ZEONOR (produced by Nippon Zeon Corporation, an amorphous cyclopolyolefin film ARTON (produced by JSR Corporation), a polycarbonate film PUREACE (produced by Teijin Limited), and a cellulose triacetate film KONICATAC KC4UX, KC8UX (produced by Konica Minilta Opto, Inc.) available on the market are preferably used.

Further, the resin film is preferably transparent. A transparent gas barrier film can be prepared because the resin film is transparent, and the gas barrier film formed on the resin film is also transparent, whereby a transparent substrate utilized for an organic EL element and so forth is possible to be prepared.

The above-described resin may also be unstretched or stretched.

The resin film of the present invention is possible to be prepared by a commonly known conventional method. For example, an unstretched substrate which is substantially amorphous with no orientation can be prepared by a quenching process after extruding a dissolved resin material via an annular die or a T die employing an extruder. An unstreached substrate is also oriented in the substrate running direction (vertical axis) or in the direction at right angle to the substrate running direction (horizontal axis) by a commonly known method such as a uniaxially stretching method, a tenter type individual biaxially stretching method, a tenter type simultaneous biaxially stretching method or a tubular type simultaneous biaxially stretching method to produce a stretched substrate. In this case, a stretching magnification is preferably 2 - 10 times in each of the vertical axis direction and the horizontal axis direction, though the magnification can be selected appropriately to fit a resin as a substrate material.

The resin film substrate of the present invention may also be subjected to a surface treatment such as a corona treatment, a flame treatment, a plasma treatment, a glow discharge treatment, a surface roughening treatment or a chemical treatment before forming the foregoing gas barrier layer or polymer layer.

The resin film is advantageous in the case of long length type in the form of a roll. The thickness can not be categorically specified, depending on usage of the resulting gas barrier film, but it is not specifically limited in the case of employing the gas barrier film for packaging usage the resin film, and it has a thickness of 3 - 400 $\mu$m in view of suitability as a packaging material, and preferably has a thickness of 6 - 30 $\mu$m.

The resin film in the form of a film usable in the present invention preferably has a thickness of 10 - 200 $\mu$m, and more preferably has a thickness of 50 - 100 $\mu$m.

The water vapor permeation rate of the gas barrier film in the present invention, measured in accordance with JIS K7129, is preferably at most 0.01 g/m$^2$/day (at 40 °C and 90%RH) in the case of use application in which high water vapor barrier is demanded for organic EL displays and high definition color liquid crystal displays, and more preferably at most 0.001 g/m$^2$/day. Further, the water vapor permeation specified in accordance with JIS K7129 is preferably less than 0.00001 g/m$^2$/day since dark spots are generated, even though almost negligible, and life of the display tends to be shortened in the case of use application for organic EL displays.

«Plasma CVD method»

In the case of a method of producing a gas barrier film of the present invention, it is a feature that a plasma CVD method is utilized for forming a gas barrier thin layer.

The plasma CVD method is also called as plasma assisting chemical vapor deposition method or PECVD method, by which a layer of various inorganic substances exhibiting high coat and adhesion ability can be obtained for any solidshaped body with no large increase of a substrate temperature.

The conventional CVD method (chemical vapor deposition method) is a method in which the evaporated or sublimated organic metal compound adheres to the substrate surface at high temperature, and thermally decomposed to form a thin layer composed of a thermally stable inorganic substance. Such the conventional CVD method is not usable for a layer formed on the plastic substrate since a substrate temperature of at least 500 °C is desired.

In the case of a plasma CVD method, a space in which gas being in a plasma state (plasma space) is generated by applying an electric field in the space near the substrate. The evaporated or sublimated organic metal compound is introduced into the plasma space, decomposed and then blown onto the substrate to form the thin layer composed of an inorganic substance. In the plasma space, the gas is ionized into ions and electrons in a high ratio of several percent, and the electron temperature becomes very high though the gas is kept at low temperature. Therefore, the organic metal compound as a raw material for an inorganic layer can be decomposed by contact of the high temperature electrons and the low temperature ion radicals. Accordingly, the temperature of the substrate can be lowered in the case of preparation of an inorganic substance, whereby the layer can be sufficiently formed on a plastic substrate by this method.

However, the plasma CVD method requires a large-sized apparatus with complicated operation in the case of preparation of a large-size film, because the layer is usually formed in a space at reduced pressure of roughly 0.101 - 10.1 kPa, and an electric field needs to be applied to the gas to ionize the gas in a plasma state. Particularly in the present invention, preferably usable is the atmospheric pressure plasma method to form a gas barrier thin layer on the transparent resin film by exposing the foregoing resin film in the excited gas after supplying the thin film forming gas containing a raw material gas and a discharge gas to form a gas barrier thin layer in the discharge space under the atmospheric pressure or approximately the atmospheric pressure, and exciting the gas via application of high frequency electric field in the discharge space.

Next, the atmospheric pressure plasma method of the present invention will be described.

The thin film forming method disclosed in Japanese Patent O.P.I. Publication No. 10-154598, Japanese Patent O.P.I. Publication No. 2003-49272, and WO02/048428 can be utilized as the atmospheric pressure plasma method to form a multilayer film composed of adhesion layers, ceramic layers or protective layers, or to form the foregoing polymer film via plasma polymerization, but the thin film forming method disclosed in Japanese Patent O.P.I. Publication No. 2004-68143 are preferably employed to form a ceramic layer exhibiting a dense gas barrier property together with small compression stress. In this way, a polymer film prepared via plasma polymerization, and a gas barrier layer such as an adhesion layer, a ceramic layer or a protective layer can be formed on a resin substrate by adjusting the layer forming conditions via selection of the thin film forming gas as described before. A substrate in the form of a web is also rolled out from a stock roll to continuously form these layers.

In the present invention, the above-described discharge plasma treatment is carried out at atmospheric pressure or approximately atmospheric pressure. The atmospheric pressure or approximately atmospheric pressure herein referred to implies a pressure of 20 - 110 kPa. In order to obtain the effects as described in the present invention, the above pressure is preferably 93 - 104 kPa.

As for the discharge condition of the present invention, two different frequency electric fields are applied in the discharge space, and a method of applying an electric field superposed by the first and the second high frequency electric fields is preferable.

Second frequency $\omega2$ is higher than first frequency $\omega1$, and it is preferable that the relationship of first high frequency electric field intensity V1, second high frequency electric field intensity V2, and electric field intensity at start of discharge IV meets V1 $\geq$ IV > V2 or V1 > IV $\geq$ V2, and the power density of the foregoing second high frequency electric field is at least 1 W/cm$^2$.

The high frequency means a frequency of at least 0.5 kHz.

If superposed high frequency electric fields are both composed of sine waves, the resulting component becomes a component superposed by $\omega1$ of the first high frequency electric field and $\omega2$ of the second high frequency electric field which is higher frequency than $\omega1$. The wave form led by $\omega2$ superposed on $\omega1$ becomes a sawtooth wave form.

An electric field intensity at starting point of discharge indicates a minimum electric field intensity by which a discharge can be generated with a discharge space used for a feasible method for thin film preparation (including the structure of electrodes) and also the condition of reactions (including the condition of gases).

In the case of the same discharge space, the electric field intensity at starting point of discharge is subject to an electric field intensity at starting point of discharge for the discharge gas though it undergoes slight changes with kinds of gas introduced into a discharge space, kinds of dielectric substance on electrodes, and a distance between electrodes.

After occurrence of discharge at a possible point suitable for thin film preparation, a high density plasma desired for thin film formation in high quality is presumably generated by applying a high frequency electric field in the discharge space as mentioned above.

What is important here is that such a high frequency electric field is applied in the same discharge space between electrodes facing each other. Not preferable is the method in which two electrodes are placed side by side and different high frequency electric fields are applied in the remote, different discharge spaces respectively as disclosed in Japanese Patent O.P.I. Publication No. 11-16696.

Superposition of continuous waves such as sine waves has be explained, to which, however, the invention is not limited. It is however accepted that both waves can be not only pulse waves, but combined waves of a continuous wave and a pulse wave. It is also accepted that there is the third electric field applied in this system.

The practical method by which the above high frequency electric field is applied in the same discharge space in the invention described above is to use an atmospheric pressure plasma discharge treatment equipment in which the first power supply, by which the first high frequency electric field with $\omega1$ and V1 is applied, is connected to the first electrode which is composed of electrodes facing each other and the second power supply, by which the second high frequency electric field with $\omega2$ and V2 is applied, is also connected to the second electrode.

A gas supply unit for the discharge gas and the thin film forming gas introduced in the discharge space between electrodes facing each other is fitted in the above atmospheric pressure plasma discharge treatment equipment. It is also preferable that there should be a electrode temperature control unit installed in the atmospheric pressure plasma discharge treatment equipment.

The first filter is preferably connected to the first electrode, to the first power supply or between them, and the second filter is preferably connected to the second electrode, to the second power supply or between them. It is designed that the current of the first high frequency electric field passing through the first electrode from the first power supply runs easily with installation of the first filter, and on the contrary, the current of the second high frequency electric field passing through the first power supply from the second power supply does not run easily with grounding the current the second high frequency electric field. In this case, "Current not running easily" means that at most 20% of the current preferably runs, and only at most 10% of the current preferably runs. On the contrary, "current running easily" means that at least 80% of the current preferably runs, and at least 90% of the current preferably runs.

For example, capacitors of several tens of pF to tens of thousands of pF or inductors of a few $\mu$H, matched with the second power supply, can be employed for the first filter. Inductors of larger than 10 $\mu$H, matched with the first power supply, can be used for the second filter. This structure can be used as a filter by grounding via those capacitors and inductors.

The first power supply of the atmospheric pressure plasma discharge treatment apparatus in the present invention preferably has capability of being able to apply higher electric field intensity than that of the second power supply.

Herein, the applied electric field intensity and the discharge starting electric field intensity in the present invention represent the values determined by the methods described below.

The measuring method of applied electric field intensities $V_1$ and $V_2$ (kV/mm):

High frequency voltage probe (P6015A) is placed at each electrode portion, and the output signal of high frequency voltage probe is connected to oscilloscope TDS 3012B (produced by Tektronix Co., Ltd.) to measure electric field intensity at the predetermined point.

The measuring method of intensity of electric field at which discharge is initiated IV (kV/mm):

Discharge gas is supplied to a discharge space between the electrodes, and when electric field intensity applied to the electrodes is increased, electric field intensity at which discharge starts is defined as intensity of discharge starting electric field IV. The measuring device is the same as described above for the measurement of high frequency electric field.

In addition, the measuring position of electric field intensity employing a high frequency voltage probe and an oscilloscope used for the above-described measurement is shown in the after-mentioned Fig. 4.

When discharge conditions specified in the present invention are used, even a gas with high discharge starting electric field intensity such as a nitrogen gas starts discharge, and stable plasma with high density is maintained to form a film at high performance.

When discharge gas is a nitrogen gas, discharge starting electric field intensity IV (1/2Vp-p) is approximately 3.7 kV/mm, and the nitrogen gas can be excited via application of the first applied electric field intensity of V1 $\geq$ 3.7 kV/mm to be in a plasma state.

The frequency of the first power supply is preferably not more than 200 kHz. The electric field waveform may be a pulse wave or a continuous wave. The lower limit of the frequency is preferably about 1 kHz.

The frequency of the second power supply is preferably at least 800 kHz. As the frequency of the second power supply is increased, plasma density becomes higher, resulting a film with higher quality. The upper limit of the frequency is preferably about 200 MHz.

The application of high frequency electric field from two power supplies as described above is necessary in the present invention, in order to start discharge of a discharge gas having a high intensity of discharge starting electric field in the first high frequency electric field. Also, it is important to form a dense and high quality film by increasing plasma density with the high frequency and high power density of the second high frequency electric field.

Further, the power density of the second high frequency electric field can be increased while uniform discharge is maintained by increasing employing the power density of the first high frequency electric field, whereby more uniform plasma with higher density can be produced, resulting in improvement of film forming rate and film quality.

As described above, in an atmospheric pressure plasma discharge treatment apparatus of the present invention, a film is formed on a substrate by; starting discharge between electrodes facing each other; exciting gas introduced between the foregoing facing electrodes in the plasma state; and exposing the substrate left at rest or transported between the foregoing electrodes facing each other to the gas excited in the plasma state. Further, as for another method, there is a jet process type apparatus in which a film is formed on a substrate by; starting discharge between the above-described similar electrodes facing each other; exciting gas introduced between the facing electrodes into the plasma state; jet-blowing the gas excited in the plasma state into the outside of the facing electrodes; and exposing the substrate located close to the facing electrodes (which may be left at rest or transported) to the gas.

Fig. 10 shows a schematic drawing of one example of the atmospheric pressure plasma discharge treatment apparatus employing a jet process useful for the present invention.

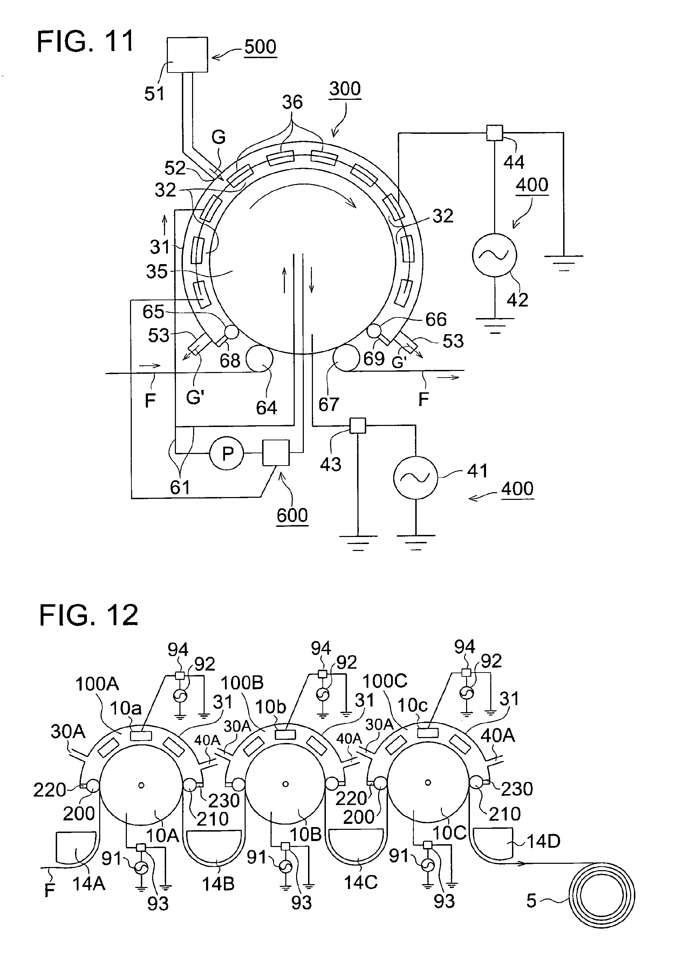

The atmospheric pressure plasma discharge treatment apparatus employing a jet process comprises a plasma discharge treatment apparatus, a voltage application unit comprising two power supplies, a gas supply unit (not illustrated in Fig. 10, but illustrated in Fig. 11) and an electrode temperature control unit.

Atmospheric pressure plasma discharge treatment apparatus 10 comprises first electrode 11 and second electrode 12 facing to each other, in which the first high frequency electric field with frequency ω1, electric field intensity V1 and current I1 from first power supply 21 is applied between facing electrodes from first electrode 11, and the second high frequency electric field with frequency ω2, electric field intensity V2 and current I2 from second power supply 22 is also applied from second electrode 12. First power supply 21 applies high frequency electric field intensity higher than that of second power supply (V1>V2). Further, first frequency ω1 of first power supply 21 is lower than second frequency ω2 of second power supply 22.

First filter 23 is placed between first electrode 11 and first power supply 21. It is designed that the current passing through first electrode 11 from first power supply 21 runs easily, and the current passing through first power supply 21 from second power supply 22 does not run easily with grounding the current running through from second power supply 22.

Further, second filter 24 is placed between second electrode 12 and second power supply 22. It is designed that the current passing through the second electrode from second power supply 22 runs easily, and the current passing through the second power supply from first power supply 21 does not run easily with grounding the current running through from first power supply 21.

Foregoing reactive gas G (thin film forming gas) is introduced into discharge space 13 (between facing electrodes) between first electrode 11 and second electrode 12 through a gas supply unit as illustrated in the after-mentioned Fig. 1, the foregoing high frequency electric field is applied between first electrode 11 and second electrode 12 by first power supply 21 and second power supply 22 to induce discharge and generate gas in the plasma state, the foregoing reactive gas G (thin film forming gas) is jetted under the electrodes and the treatment space formed between the lower surface of the electrodes, and substrate F is charged with gas G° in the plasma state, substrate F conveyed from a stock roll which is not illustrated or from a preceding process is treated at treatment position 14 to form a layer on the substrate. During thin film formation, the electrodes are heated or cooled with a medium passing through a pipe according to an electrode temperature control unit as illustrated in the after-mentioned Fig. 11. It is preferred that temperature during the plasma treatment is properly controlled, since physical properties or composition of the formed layer vary due to the temperature of the substrate. Insulation materials such as distilled water and oil are preferably used for a temperature control medium. It is desired that the electrodes be controlled to have a uniform temperature during the plasma discharge treatment in order to minimize temperature unevenness in the width and longitudinal directions of the substrate.

The measuring device to measure the foregoing applied electric field intensity and the discharge starting electric field intensity, together with the measuring position is shown in Fig. 9. Numerals 25 and 26 are high frequency probes, and numerals 27 and 28 are oscilloscopes.

A plurality of atmospheric pressure plasma discharge treatment apparatuses are placed parallel to the conveyance direction of substrate F, and a thin film with plural layers is possible to be formed at the same location by discharging gas in the same plasma state at the same time, whereby a desired thin film is possible to be formed in a short period of time. A plurality of atmospheric pressure plasma discharge treatment apparatuses are also placed parallel to the conveyance direction of substrate F, and a laminated thin film having different layers is also possible to be formed if gas in a different plasma state is jet-blasted by supplying a different thin film forming gas into each apparatus.

Fig. 11 shows a schematic drawing of one example of the atmospheric pressure plasma discharge treatment apparatus employing a process treating a substrate at a space between electrodes facing to each other useful for the present invention.

The atmospheric pressure plasma discharge treatment apparatus of the present invention comprises plasma discharge treatment apparatus 300, a electric field application unit 400 equipped with two power supplies, gas supply unit 500 and electrode temperature control unit 600.

Substrate F is subjected to plasma discharge treatment at discharge space 32 (referred to also as "between facing electrodes") between a roll rotatable electrode (the first electrode) 35 and a group of fixed prismatic electrodes (the second electrode) 36 to form a layer on the substrate.

In discharge space 32 formed between roll-rotatable electrode 35 and a group of fixed electrodes 36, the first high frequency electric field with frequency ω1, electric field intensity V1 and current I1 is applied to roll-rotatable electrode 35 by first power supply 41, and the second high frequency electric field with frequency ω2, electric field intensity V2, and current I2 is applied to a group of fixed electrodes 36 by second power supply 42.

First filter 43 is placed between roll-rotatable electrode 35 and first power supply 41. It is designed that the current passing through the first electrode from first power supply 41 runs easily with the installation of first filter 43, and the current passing through the first power supply from second power supply 42 does not run easily with grounding the current running through from second power supply 42. Second filter 94 is also placed between a group of fixed electrodes 36 and second power supply 42. It is designed that the current passing through the second electrode from second power supply 42 runs easily with the installation of second filter 44, and the current passing through the second power supply from first power supply 41 does not run easily with grounding the current running through from first power supply 41.

In addition, in the present invention, roll-rotatable electrodes 35 may be set as the second electrode, and a group of prismatic fixed electrodes 36 may be set as the first electrode. At any rate, the first electrode is connected to the first power supply, and the second electrode is connected to the second power supply. The first power supply preferably has larger high frequency electric field intensity (V1 > V2) applied than the Second power supply. Frequency of $\omega1 < \omega1$ is possible to be utilized.

The current should be I1 < I2. Current I1 of the first high frequency electric field should be 0.3 - 20 mA/cm$^2$. It is preferably 1.0 - 20 mA/cm$^2$. And also, Current I2 of the second high frequency electric field should be 10 - 100 mA/cm$^2$. It is preferably 20 - 100 mA/cm$^2$.

Thin film forming gas G generated by gas generation device 51 in gas supply device 500 is introduced into the inside of plasma discharge treatment vessel 31 from gas supply opening 52 by controlling gas flow with an unshown gas flow adjustment unit.

Substrate F is conveyed in the arrow direction from a preceding process or from a stock roll which is not illustrated, passed through guide roller 64 and through nip roller 65, which removes air accompanied with the substrate, and transported to a space between a group of prismatic fixed electrodes 36 and rotatable roll electrode 35. In this case, guide roller 67 is arranged to have a diameter of at least 150 mm.

Electric field is applied from both rotatable roll electrode 35 and a group of prismatic fixed electrodes 36 during conveyance to generate plasma at discharge space 32 between the opposed electrodes. Substrate F is exposed to gas in a plasma state to form a layer on the substrate, while transported so that the substrate is in contact with the surface of rotatable roll electrode 35.

In addition, a plurality of prismatic fixed electrodes are placed along with the circumference larger than that of the above-described roll electrode, and the discharge area of the electrode is represented by the sum of the area facing rotatable roll electrode 35 of the total prismatic fixed electrodes facing rotatable roll electrode 35.

Substrate F is rolled up by an unshown roll-up device, or transferred into the next step. In this case, guide roller 67 is arranged to have a diameter of at least 150 mm.

Exhaust gas G' which has been subjected to discharge treatment is emitted from exhaust outlet 53.

It is preferable that a medium temperature-adjusted with electrode temperature adjustment unit 600 is fed to both electrodes via pipe 61 by liquid-feed pump P to adjust temperature from the inside of the electrode in order to heat or cool rotatable roll electrode 35 and a group of fixed electrodes 36 during film formation. Incidentally, numerals 68 and 69 represent a plasma discharge treatment vessel and a partition blocked from the outside, respectively.

One example of a non-contact conveyance type plasma discharge treatment apparatus employing a plasma discharge treatment process comprising a rotatable roll electrode and a prismatic electrode facing the roll electrode, wherein an electric field superposed by the first and the second high frequency electric fields having different frequencies is applied between the electrodes is shown in Fig. 12.

Substrate F rolled out from a stock roll substrate in the form of a roll enters discharge treatment room 31 through nip roller 200 and partition 220 via non-contact conveyance system 14A, is taken by rotatable roll electrode 10A to be tightly transferred, and is subjected to a plasma discharge treatment at discharge section 100A formed between 10A and facing prismatic electrode 10a (reactive gas G supplied from reactive gas supply portion 30A, and gas G' after treatment ejected from exhaust outlet 40A). After this, the substrate is once moved out from the discharge treatment room via nip roller 210 and partition 230, the conveyance direction is subsequently reversed by another non-contact conveyance system 14B so as not to bring the treated surface into contact with a reversing roller, and the substrate is continuously subjected to the treatment after entering the same discharge treatment room again. This shows that discharge treatment room 31 possessing a rotatable roll electrode and three prismatic electrodes facing each roll electrode, and three successive plasma discharge treatment apparatuses. As a matter of course, the prismatic electrode may be placed singly in each discharge treatment room, or a plurality of prismatic electrodes may also be placed in each discharge treatment room.

At any rate, the surface subjected to the plasma discharge treatment is conveyed along with the curved surface with no-contact by non-contact conveyance systems 14A - 14D supporting a web continuously running through gas squirting out from the gas outlet, and is subjected to the plasma discharge treatment in three discharge treatment rooms in this case.

Substrate F after treatment is transferred into the roll-up process to be rolled by a winder in non-contact of the discharge treatment surface via the last non-contact conveyance system.

In this apparatus, the non-contact conveyance system is placed immediately before plasma discharge treatment, and is usable as a residual heat device in order to avoid construction and deformation of the substrate caused by rapid increase of temperature in plasma discharge treatment.

Incidentally, roll electrodes 10A, 10B and 10C together with the prismatic electrode as shown in Fig. 6 have a structure in which a dielectric is coated on a conductive metal base material in the same manner as described before.

The distance between the facing roll electrode and the prismatic electrode is preferably 0.1 - 20 mm in view of uniform discharge depending on the distance of dielectric surface-to-dielectric surface, and more preferably 0.5 - 2 mm.

Three fixed electrodes (prismatic electrodes in this case) are placed along with the circumference in this case, but one electrode may be allowed to be placed, or a plurality of electrodes may also be allowed to be placed. The discharge area of the electrode is represented by the sum of the area of the total fixed electrodes facing the rotatable roll electrode. The discharge area can be enlarged by providing a plurality of electrodes.

Further, a structure capable of circulating a temperature adjustable medium (water, silicone oil or such) is employed in order to maintain a surface temperature of substrate F at a predetermined value by controlling the electrode surface temperature during plasma discharge treatment. Similarly, it is preferable to be allowed to adjust the temperature during discharge.

At discharge sections 100A - 100C formed between roll electrodes in the plasma discharge apparatus in Fig. 12, reciprocating substrate F is subjected to plasma discharge treatment to form films or to surface-modifying treatment.

Each of roll electrodes is used as the first electrode, and the prismatic electrode is used as the second electrode. Between roll electrodes 10A and prismatic electrode 10a, the first high frequency electric field with frequency ω1, electric field intensity V1, and current I1 is applied to roll electrode 10A by first power supply 91, and the second high frequency electric field with frequency ω2, electric field intensity V2, and current I2 is applied to facing prismatic electrode 10a by second power supply 92.

First filter 93 is placed between roll electrode (the first electrode) 10A and first power supply 91. It is designed that the current passing through the first electrode from first power supply 91 runs easily with the installation of first filter 93, and the current passing through the first power supply from second power supply 92 does not run easily with grounding the current running through from second power supply 92. Second filter 94 is also placed between facing prismatic electrode (the second electrode) 10a and second power supply 92. It is designed that the current passing through the second electrode from second power supply 92 runs easily with the installation of second filter 94, and the current passing through the second power supply from first power supply 91 does not run easily with grounding the current running through from first power supply 91.

Similarly in the discharge space between roll electrodes 10B and 10b, and between 10C and 10c, roll electrodes 10B and 10C are used as the first electrode, and prismatic electrodes 10b and 10c are used as the second electrode. Similarly, the first electrode is connected to first power supply 91 and filter 93, and the second electrode is connected to second power supply 92 and filter 94 to conduct the similar operation.

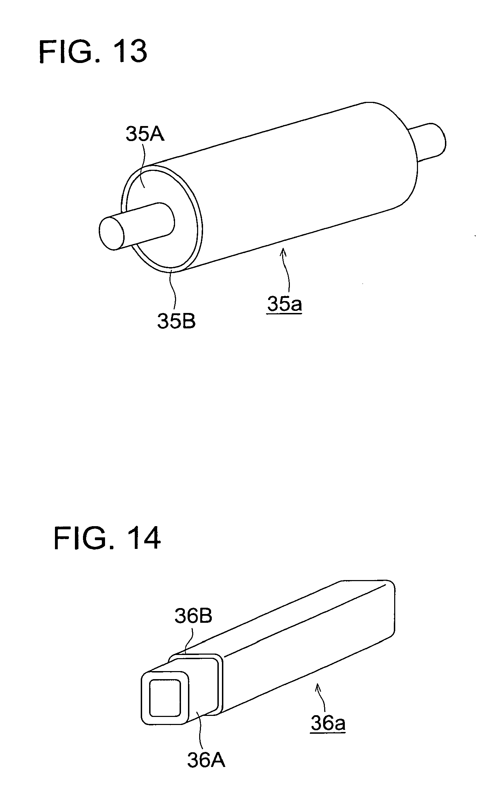

Fig. 13 is a perspective view showing one example of a structure comprising a conductive metal base material of a rotatable roll electrode and coated thereon, a dielectric as shown in Fig. 11 and Fig. 12.

In Fig. 13, roll electrode 35a possesses metal base material 35A and coated thereon, dielectric 35B. A structure capable of circulating a temperature adjustable medium (water, silicone oil or such) is also employed in order to maintain a surface temperature of substrate F at a predetermined value by controlling the electrode surface temperature during plasma discharge treatment.

Fig. 14 is a perspective view showing one example of a structure comprising a conductive metal base material of a prismatic electrode and coated thereon, a dielectric.

In Fig. 14, prismatic electrode 36a has the same coated dielectric 36B as shown in Fig. 12 with respect to conductive metal base material 36A, and the electrode is structured to form a metal pipe serving as a jacket, making it possible to adjust temperature during discharge.

Prismatic electrode 36a shown in Fig. 14 may be a cylindrical electrode, but the prismatic electrode is preferable in the present invention since the prismatic electrode produces an effect of enlarging the discharge range (discharge area) in comparison to the cylindrical electrode.

In Figs. 13 and 14, each of roll electrode 35a and prismatic electrode 36a is subjected to a sealing treatment employing a sealing material made of an inorganic compound, after thermally spraying ceramics as dielectric 35B or 36B on conductive metal base material 35A or 36A. The coat thickness of the ceramic dielectric material may desirably be 1 mm. As a ceramic material usable for thermal spraying, alumina and silicon nitride are preferably used, but of these, alumina is more preferably usable in view of easy processing. The dielectric layer may be a lining-treated dielectric material in which an inorganic material is formed via lining.

Examples of conductive metal base material 35A and conductive metal base material 35B include a metal such as titanium, a titanium alloy, silver, platinum, stainless steel, aluminum or iron; a composite material of iron and ceramics; and a composite material of aluminum and ceramics, but titanium and a titanium alloy are specifically preferable.

The distance between the first electrodes and the second electrode means the shortest distance between the dielectric surface and the conductive metal base material surface of the other electrode when a dielectric is provided on one electrode, and it means the shortest distance of dielectric surface-to-dielectric surface when dielectrics are provided on both electrodes. The distance between electrodes is determined in consideration with the thickness of dielectric provided on a conductive metal base material, applied electric field intensity and intended use of plasma, but the distance between electrodes in any case is preferably 0.1 - 20 mm, and more preferably 0.5 - 2 mm in view of even discharge.

The conductive metal base material and the dielectric useful for the present invention will be described in detail later on.

Though plasma discharge treatment vessel 31 is preferably a glass vessel such as Pyrex ® glass, a metal vessel may be employed when the vessel is insulated from the electrodes. For example, a polyimide resin or such may be attached on the inner surface of a frame made of aluminum or stainless steel, and the metal frame may also be insulated by thermally ceramics-spraying. In Fig. 13, for example, the both side surfaces of both parallel electrodes (near the substrate surface) are preferably covered with the above-described material (up to the area close to the substrate).

Examples of the first power supply (high frequency power supply) employed in the atmospheric pressure plasma discharge treatment apparatus of the present invention include the following power supplies.

| Reference number | Manufacturer | Frequency | Product name |
|---|---|---|---|
| A1 | Shinko Electric Co., Ltd. | 3 kHz | SPG3-4500 |
| A2 | Shinko Electric Co., Ltd. | 5 kHz | SPG5-4500 |
| A3 | Kasuga Electric Works, Ltd. | 15 kHz | AGI-023 |
| A4 | Shinko Electric Co., Ltd. | 50 kHz | SPG50-4500 |
| A5 | Haiden Laboratory Inc. | 100 kHz* | PHF-6k |
| A6 | Pearl Kogyo Co., Ltd. | 200 kHz | CF-2000-200k |
| A7 | Pearl Kogyo Co., Ltd. | 400 kHz | CF-2000-400k |

Any of the above commercially available power supplies can be employed in the present invention.

Examples of the second power supply (high frequency power supply) also include the following power supplies.

| Reference number | Manufacturer | Frequency | Product name |
|---|---|---|---|
| B1 | Pearl Kogyo Co., Ltd. | 800 kHz | CF-2000-800k |
| B2 | Pearl Kogyo Co., Ltd. | 2 MHz | CF-2000-2M |
| B3 | Pearl Kogyo Co., Ltd. | 13.56 MHz | CF-5000-13M |
| B4 | Pearl Kogyo Co., Ltd. | 27 MHz | CF-2000-27M |
| B5 | Pearl Kogyo Co., Ltd. | 150 MHz | CF-2000-150M |

Any of the above commercially available power supplies can be employed in the present invention.

A power supply indicated by * among the above power supplies means an impulse high frequency power source (100 kHz in continuous mode) manufactured by Haiden Laboratory Inc. Others are high frequency power supplies capable of applying only continuous sine wave.

In the present invention, it is preferable that electrodes, by which a uniform and stable condition of discharge can be maintained, are employed in an atmospheric pressure plasma discharge treatment apparatus.

In the present invention, a power density of at least 1 $W/cm^2$ is supplied between facing electrodes to the second electrode (the second high frequency electric field) and thin films are prepared by generating plasma with an excited discharge gas and by giving energy to a thin film forming gas. The upper limit of power density provided to the second electrode (the second high frequency electric field) should be 50 $W/cm^2$ and it is preferably 20 $W/cm^2$. The lower limit is preferably 1.2 $W/cm^2$. In addition, discharge area ($cm^2$) means the sum of area in the range where discharge takes place between electrodes.

Further, power density can be improved while uniformity of the second high frequency electric field is maintained, by supplying power (power density) of at least 1 $W/cm^2$ to the first electrode (first high frequency electric field), whereby more uniform plasma with higher density can be produced, resulting in improvement of film forming rate and film quality. Power supplied to the first electrode is preferably at least 5 $W/cm^2$. The upper limit of power supplied to the first electrode is preferably 50 $W/cm^2$.

Herein, the waveform of the high frequency electric field is not specifically limited. There are a continuous oscillation mode (called a continuous mode) with a continuous sine wave and a discontinuous oscillation mode (called a pulse mode) carrying ON/OFF discontinuously, and either may be used, but a method supplying the continuous sine wave at least to the second electrode side (the second high frequency electric field) is preferred in obtaining a uniform layer with high quality.

The electrode used for a thin film formation method employing such the atmospheric pressure plasma must be durable against heavy-duty conditions in both structure and performance. Such the electrode should have a dielectric coated on a metal base material.

As for an electrode coated with a dielectric, various metal base materials and dielectrics should be matched in properties and one of the properties is in combination of the metall base material and the dielectric with at most 10 x $10^{-6}$/°C which is a difference in coefficient of linear thermal expansion between the foregoing materials. The difference of at most 8 x $10^{-6}$/°C is preferable, that of at most 5 x $10^{-6}$/°C is more preferable, and that of at most 2 x $10^{-6}$/°C is still more preferable. Incidentally, the coefficient of linear thermal expansion is one of the commonly known physical properties specified to materials.

The combination of a conductive metal base material and a dielectric accompanied with the difference in coefficient of linear thermal expansion being within the range stated above is listed as follows.

    1: Pure titanium or titanium alloy as a metal base material and coated ceramics thermally sprayed as a dielectric
    2: Pure titanium or titanium alloy as a metal base material and glass lining material as a dielectric
    3: Stainless steel as a metal base material and coated ceramics thermally sprayed as a dielectric
    4: Stainless steel as a metallic base material and glass lining material as a dielectric
    5: Composite material of ceramics and iron as a metal base material and coated ceramics thermally sprayed as a dielectric
    6: Composite material of ceramics and iron as a metal base material and glass lining material as a dielectric
    7: Composite material of ceramics and aluminum as a metal base material and coated ceramics thermally sprayed as a dielectric
    8: Composite material of ceramics and aluminum as a metal base material and glass lining material as a dielectric
    From the aspect of the difference in coefficient of linear thermal expansion, the above item 1 or 2 and items 5 - 8 are preferable. Item 1 is specifically preferable.

In the present invention, titanium or titanium alloy as a metal base material are specifically useful because of the foregoing properties. Titanium or titanium alloy as a metal base material and the above materials as a dielectric can withstand heavy duty use for long duration with no degradation of an electrode in use caused by cracks, peeling, and fall-off.

A metal base material used for an electrode useful for the present invention is a titanium metal or a titanium alloy containing at least 70% by weight of titanium. Titanium metal or titanium alloy containing at least 70% by weight of titanium can be used with no problem, but the content of at least 80% by weight of titanium is preferable. Titanium metal or titanium alloy useful for the present invention such as industrial pure titanium, corrosion-resistant titanium, high-strength titanium and so forth, which are commercially available, can be used. TIA, TIB, TIC, TID, and so forth as industrial pure titanium can be given and any one of them containing at least 99% by weight of titanium contains a very small amount of iron atoms, carbon atoms, nitrogen atoms, oxygen atoms, hydrogen atoms, and so forth, respectively. T15PB as corrosion-resistant titanium alloy containing not only the foregoing atoms but also lead atoms can be preferably used and it contains at least 98% by weight of titanium. T64, T325, T525, TA3, and so forth as titanium alloy containing atoms mentioned above excluding lead atoms, vanadium and tin can be preferably used and the titanium content is at least 85% by weight of titanium. Those titanium metals or titanium alloys have the coefficient of thermal expansion that is smaller than that of stainless steel (for example, AISI316) by about a half thereof and they can withstand heavy duty use for long duration at high temperature since a combination with the after-mentioned dielectric deposited on titanium metal or titanium alloy as a metal base material is well matched.

As for properties demanded for the dielectric, on the one hand, they should be specifically made of inorganic compounds with relative permittivity of 6 - 45, and there are also ceramics such as alumina and silicon nitride or glass lining materials such as silica glass and borate glass employed as the dielectric. The after-mentioned ceramics thermally sprayed and glass lining materials among those are preferably used. Pareticularly, dielectrics prepared by thermally spraying alumina are preferably used.

In one of the specifications concerning endurance against a large power described above, the percentage of porosity of a dielectric should be not more than 10% by volume. It should be not more than 8% volume preferably. It is specifically preferable that it should be between 0 and 5% by volume. In addition, the percentage of porosity of dielectric can be measured by a BTE absorption technique or a mercury porosimeter. As seen in the after-mentioned example, the percentage of porosity is measured with a fragment of the dielectric coated by a metal base material by a mercury porosimeter (Shimadzu Corporation). A high durability can be achieved by decreasing the percentage of porosity of the dielectric. A high density and high adherence ceramic thermal spray film obtained by the after-mentioned atmospheric pressure plasma thermal spray method and so forth can be introduced as the dielectrics with such a lower percentage of porosity. A sealing treatment should take place in order to decrease further percentage of porosity.

The atmospheric pressure plasma thermal spray method mentioned above is a technique by which films can be formed by thermally spraying fine particles in molten or semi-molten state to the metal base material as a coated object after fine ceramic particles, wires, and so forth are cast into a plasma heat source. The plasma heat source means a high temperature plasma gas by which electrons are emitted in further energizing after molecular gas is heated up to high temperature and dissociated into atoms. This plasma gas injection velocity is large and high density films having large strength in adherence can be obtained in occurrence of higher velocity collision of thermally sprayed materials to the metal base material in comparison to conventional electric arc spraying and flame spraying techniques. A thermal spray technique by which thermal shield films are formed onto materials exposed in high temperature, described in detail refers to Japanese Patent Publication No. 2000-301655. By this technique, the percentage of porosity of the coated dielectric (ceramic thermal spray film), described above, can be obtained.

As for another preferable specification concerning endurance against a large power, the thickness of dielectric is 0.5 - 2 mm. The variation in thickness should be not more than 5%. Not more than 3% is preferable and not more than 3% is more preferable.

A sealing treatment with an inorganic compound processed further on a thermal spray ceramic layer, described above, should take place in order to decrease further percentage of porosity of the dielectric. Metal oxides in the foregoing inorganic compounds can be preferably used and specifically those containing silicon oxide ($SiO_x$) as a principal component can be preferably used.

It is preferable that inorganic compounds used for a sealing treatment should be cured via sol-gel reaction. In the case of inorganic compounds used for a sealing treatment which are metal oxides as a principal component, metal alkoxide and so forth as sealing liquids are coated on the foregoing ceramic thermal spray film and are cured via the sol-gel reaction. In the case of an inorganic compound which is silica as a principal component, alkoxysilane as a sealing liquid should be employed.

Energy treatments should take place for accelerating sol-gel reaction. There are thermal curing (preferably not more than 200 °C), ultraviolet ray exposure and so forth for those treatments. As for the sealing treatment, the electrode being dense in structure with no degradation can be obtained via occurrence of further mineralization if the sealing liquid is diluted and processes of coating and curing are successively repeated a couple of times.

When a sealing treatment for curing through sol-gel reactions is conducted after metallic alkoxide for a dielectric coat electrode as sealing liquids is coated on a ceramic thermal spray film, the content of metal oxide after curing should be at least 60 mol%. In the case of using alkoxysilane as metallic alkoxide of a sealing liquid, the content of $SiO_x$ after curing (x is at most 2) should be at least 60 mol%. The content of $SiO_x$ after curing can be measured by X-ray photoelectron spectroscopy with analysis of the layer fault of dielectric.

As for an electrode according to the thin film formation method of the present invention, it is preferably adjusted that the maximum height of surface roughness, specified by JIS B 0601, on the side keeping in contact with at least the base material of the electrode may be at most 10 $\mu$m in order to have a positive effect described in the present invention. The maximum height of surface roughness of at most 8 $\mu$m is preferable and at most 7 is particularly preferable. By a polishing finish of the surface of dielectric on the electrode, the thickness of dielectric and the gap between electrodes can be kept constant, discharge conditions can be stabilized, the strain and crazing from a thermal shrinkage difference and a residual stress can also be eliminated, and a high degree of accuracy and durability can be largely improved. It is preferable that the polishing finish of the surface of dielectric is conducted to the dielectric situated on the side having contact with at least the base material. In addition, a center line surface roughness (Ra), specified by JIS B 0601, should be less than 0.5 $\mu$m. Less than 0.1 $\mu$m is particularly preferable.

As for the dielectric coat electrode of the present invention, a heat resistant temperature in another preferable specification concerning endurance against a large power should be at least 100 °C. The upper limit of heat resistant temperature is 500 °C, though a heat resistant temperature of at least 120 °C is preferable and at least 150 °C is particularly preferable. Heat resistant temperature means the highest temperature endurable for normal discharge conditions with no insulation breakdown against voltage used for the atmospheric pressure plasma treatment. Such a heat resistant temperature can be achieved by appropriately combining devices such as an introduction of the ceramic thermal spray mentioned above, application of the dielectric prepared by the glass lining with layers having a different amount of foams contained in quantity, and a selection of materials within the range of a difference in coefficient of linear thermal expansion between the metal base material and the dielectric.

«Application field of gas barrier film»

The gas barrier film exhibiting high barrier of water vapor and oxygen in the present invention can be utilized as various sealing materials and films.

The gas barrier film of the present invention can be employed for a display device such as an organic EL element, for example. When it is employed for the organic EL element, this gas barrier film is designed to be used as a substrate so as to take light out from this side, since the gas barrier film of the present invention is transparent. That is, for example, a transparent conductive thin film formed from ITO or such is provided on this gas barrier film as a transparent electrode to use it as a resin substrate for the organic EL element. An organic EL material layer comprising an anodic transparent ITO conductive film provided on a substrate and placed thereon, an emission layer is formed, a cathode made of a metal layer is further provided to form the organic EL element, and the foregoing gas barrier film substrate adheres to the periphery after placing a sealing material on the resulting to be able to seal the organic EL element layer by sealing the foregoing element, whereby influence to the element by gases such as humidity of the external air, oxygen and so forth can be removed.

There is also a problem such that the organic EL emission device exhibits low light-removing efficiency. Accordingly, a structure to improve light-removing is desired to be formed at the same time when the gas barrier film is used as a film substrate.

Accordingly, the gas barrier film of the present invention preferably has a roughened surface structure on the substrate surface to undergo diffraction and diffusion of light in order to improve light-removing efficiency from the organic EL element, when the gas barrier film is used as a resin substrate for the organic EL element.

The gas barrier film of the present invention can also be applied to a sealing film.

In the organic EL manufacturing process, a transparent conductive film is formed on a ceramic layer, and an organic EL material layer formed from an organic EL element and a metal layer as a cathode are laminated on the resulting as an anode. Further, another gas barrier film is placed on the resulting, and attached for sealing via adhesion. As another sealing material (sealing film) described above, utilized can be a gas barrier film comprising a ceramic layer having a dense structure of the present invention.

The organic EL material in which the gas barrier film of the present invention is used is utilized as various emission sources and lighting devices for home lighting and interior lighting in addition to display devices and displays, and also as a kind of lamp such as an exposure light source for back lighting of a liquid crystal display device and such. Others are a light source of back lighting of watch, an advertising display, traffic lighting or optical recording media, a light source of an electrophotographic copier, a light source of optical communication processing, and a light source of an optical sensor. The foregoing display apparatus is further applied to such an extent that it is utilized for a wide range of usage of home appliances.

## EXAMPLE

Example 1

Examples in which gas barrier films were prepared employing a plasma discharge treatment apparatus of the present invention according to any one of Structures 1 - 6.

The treatment was carried out employing the plasma discharge treatment apparatus shown in Fig. 2, and a thin film was formed on a substrate by introducing raw material and electric power into each electrode section.

A dielectric of a thickness of 1 mm was coated on facing electrodes via a thermally sprayed ceramic treatment. The spacing between electrodes was also set to 1 mm. A metal base material on which a dielectric was coated was prepared in accordance to the stainless jacket specification having a cooling function with cooling water, and the plasma discharge treatment was conducted while controlling electrode temperature with cooling water during discharging. Power supplies used here were a high frequency power supply (80 kHz) manufactured by Oyo Electric Co., Ltd., and a high frequency power supply (13.56 MHz) manufactured by Pearl Kogyo Co., Ltd.

A cylindrical electrode having a diameter of 50 mm and a width of 500 mm, and a facing prismatic electrode having a discharge area of 500 cm$^2$ were also employed. Further, a nip roller made of silicone rubber (JIS hardness 70) having a width of 75 mm was used.

An optical type of EPC sensor SLH20 manufactured by Nireco Corporation was employed.

A PEN film fitted with an acrylic clear hard coat layer (a thickness of 150 $\mu$m, a width of 500 mm, and a roll of 150 m) was used as a substrate film, an adhesion layer/ a ceramic layer/ a protective layer were formed on the substrate in this order to prepare a thin film. As the thickness of each layer, the adhesion layer has a thickness of 10 nm, the ceramic layer has a thickness of 50 nm, and the protective layer has a thickness of 50 nm. Temperature of the substrate film maintained during film formation was also set to 120 °C.

After roll-up of the substrate, a role of the winder and unwinder was changed to reverse the conveyance direction of the substrate, and to reciprocate it. The plasma discharge treatment was carried out three times by adjusting the conveyance speed so as to give a desired thickness of each layer by changing each of preparation conditions as described below to laminate an adhesion layer, a ceramic layer and a protective layer in this order on a substrate film.

The forming conditions of each layer (power of a power supply on the high frequency side, and thin film forming gas) are as follows.

<Ceramic layer>

Discharge gas: N$_2$ gas

Reactive gas 1: 5% of oxygen gas, based on the total gas

Reactive gas 2: 0.1% of tetraethoxysilane (TEOS), based on the total gas

Power of power supply on the low frequency side: 10 W/cm$^2$ at 80 kHz

Power of power supply on the low frequency side: Change of 13.56 MHz at 10 W/cm$^2$

<Adhesion layer>

Discharge gas: N$_2$ gas

Reactive gas 1: 1% of hydrogen gas, based on the total gas

Reactive gas 2: 0.5% of tetraethoxysilane (TEOS), based on the total gas

Power of power supply on the low frequency side: 10 W/cm$^2$ at 80 kHz

Power of power supply on the low frequency side: 5 W/cm$^2$ at 13.56 MHz

<Protective layer>

Discharge gas: N$_2$ gas

Reactive gas 1: 1% of hydrogen gas, based on the total gas

Reactive gas 2: 0.5% of tetraethoxysilane (TEOS), based on the total gas

Power of power supply on the low frequency side: 10 W/cm$^2$ at 80 kHz

Power of power supply on the low frequency side: 5 W/cm$^2$ at 13.56 MHz

After preparation of the resulting gas barrier film, as to samples at 10 m, 70 m and 140 m after starting of plasma discharge, scratches on the sample surface were visually observed, but generation of few scratches on the surface and failure caused by foreign matter were observed in the samples, whereby the uniform surface was obtained.

Further, gas barrier performance was evaluated employing an oxygen permeation analyzer OX-TRAN2 / 21·L type and a water vapor permeation analyzer PERMATRAN-W3/33G type, manufactured by Mocon Inc., and a water vapor barrier of approximately 10$^{-6}$(g/m$^2$/day) and uniform gas barrier layers were obtained for each sample since an oxygen barrier of approximately 10$^{-4}$(ml/m$^2$/day) were measured.

Example 2

Examples in which gas barrier films were prepared employing a plasma discharge treatment apparatus of the present invention according to any one of Structures 7 - 10.

Thin layers were formed on a substrate in order as described below by introducing each raw material and power into each electrode section with a plasma discharge treatment apparatus shown in Fig. 5.

A dielectric of a thickness of 1 mm was coated on facing roll electrodes via a thermally sprayed ceramic treatment. The spacing between electrodes was also set to 1 mm. A metal base material on which a dielectric was coated was prepared in accordance to the stainless jacket specification having a cooling function with cooling water, and the plasma discharge treatment was conducted while controlling electrode temperature with cooling water during discharging. Power supplies used here were a high frequency power supply (80 kHz) manufactured by Oyo Electric Co., Ltd., and a high frequency power supply (13.56 MHz) manufactured by Pearl Kogyo Co., Ltd.

A roll electrode having a diameter of 50 mm and a width of 500 mm. Further, nip rollers 20 and 21 made of silicone rubber (JIS hardness 70) having a width of 100 mm was used.

The non-contact conveyance system is in the form of a cylinder having a cross-sectional area of 7/8 arc (a diameter of 500 mm), an air emission section on the surface is wound in appropriate pitch by a SUS-304 wire, a roll having a hole for compressed air supply is used for fixed shaft sections at both roller ends, the pressure value of compressed air was measured with a substrate tension meter, air was supplied so as to give an applied pressure of approximately 1 kPa, and a gap of the substrate surface and the roll surface was adjusted to be 5 mm. Thus, web flotation becomes even along with the outer circumferential surface, and no web comes in contact with the roller surface during conveyance.

The substrate after film formation was wound up by a winder after coming out from a discharge treatment room via a room separating the discharge treatment room from external air.

An EPC sensor for web guiding was also used for a plasma discharge treatment apparatus. An optical type of EPC sensor SLH20 manufactured by Nireco Corporation was employed, and torque was directly controlled by a roll-up shaft. Output of a torque motor was directly monitored to measure tension.

A PEN film fitted with an acrylic clear hard coat layer (a thickness of 150 μm, a width of 500 mm, and a roll of 150 m) was used as a substrate, and this substrate was set onto a roll-out shaft to roll out the substrate from a stock roll. In the plasma discharge treatment apparatus including plasma discharge treatment processes each shown in Fig.

5, an adhesion layer/ a ceramic layer/ a protective layer were formed on the substrate in this order employing each of discharge sections 100A, 100B and 100C to prepare a multilayered thin film. The conditions were adjusted in such a way that as the thickness of each layer, the adhesion layer has a thickness of 10 nm, the ceramic layer has a thickness of 50 nm, and the protective layer has a thickness of 50 nm. Temperature of the substrate film maintained during film formation was also set to 120 °C.

Film forming conditions of each layer (power of power supply on the high frequency side and thin film forming gas) are described below.

<Ceramic layer>

Discharge gas: $N_2$ gas
Reactive gas 1: 5% of oxygen gas, based on the total gas
Reactive gas 2: 0.1% of tetraethoxysilane (TEOS), based on the total gas
Power of power supply on the low frequency side: 10 W/cm$^2$ at 80 kHz
Power of power supply on the low frequency side: Change of 13.56 MHz at 10 W/cm$^2$

<Adhesion layer>

Discharge gas: $N_2$ gas
Reactive gas 1: 1% of hydrogen gas, based on the total gas
Reactive gas 2: 0.5% of tetraethoxysilane (TEOS), based on the total gas
Power of power supply on the low frequency side: 10 W/cm$^2$ at 80 kHz
Power of power supply on the low frequency side: 5 W/cm$^2$ at 13.56 MHz

<Protective layer>

Discharge gas: $N_2$ gas
Reactive gas 1: 1% of hydrogen gas, based on the total gas
Reactive gas 2: 0.5% of tetraethoxysilane (TEOS), based on the total gas
Power of power supply on the low frequency side: 10 W/cm$^2$ at 80 kHz
Power of power supply on the low frequency side: 5 W/cm$^2$ at 13.56 MHz

After preparation of the resulting gas barrier film, as to samples at 10 m, 70 m and 140 m after starting of plasma discharge, scratches on the sample surface were visually observed, but generation of few scratches on the surface and failure caused by foreign matter were observed in the samples, whereby the uniform surface was obtained.

Further, gas barrier performance was evaluated employing an oxygen permeation analyzer OX-TRAN2/21.L type and a water vapor permeation analyzer PERMATRAN-W3/33G type, manufactured by Mocon Inc., and a water vapor barrier of approximately $10^{-6}$(g/m$^2$/day) and uniform gas barrier layers were obtained for each sample since an oxygen barrier of approximately $10^{-4}$(ml/m$^2$/day) were measured.

The present invention according to any one of structures 11 - 15 will be specifically described referring to Examples 3 - 5.

Example 3

«Preparation of resin film»

A prepared actinic radiation curable resin layer coating solution having the following composition was coated on a PEC (polyethylene naphthalate) film (a width of 50 cm and a thickness of 125 μm) Q65, produced by Teijin DuPont Films Japan Ltd. as a resin substrate, employing a micro-gravure coater, so as to give a thickness of 6 μm after curing. After the solvent is vaporized and dried, a polymer film comprising an acrylic curable layer was formed by curing via a UV exposure of 0.2 J/cm$^2$ employing a high-pressure mercury lamp.

(Actinic radiation curable resin layer coating solution)

| | |
|---|---|
| Dipenta erythritol hexaacrylate monomer | 60 parts by weight |
| Dipenta erythritol hexaacrylate dimmer | 20 parts by weight |

(continued)

| Dipenta erythritol hexaacrylate trimer | 20 parts by weight |
| Dimethoxybenzophenone photoreaction Initiator | 4 parts by weight |
| Methylethyl ketone | 75 parts by weight |
| Propylene glycol monomethylether | 75 parts by weight |

«Preparation of gas barrier film»

[Preparation of sample 1]

A 50 nm thick adhesion film, a 30 nm thick ceramic film and a 200 nm thick protective film were formed in this order on a resin film comprising a polymer layer being the above-described resulting acrylic curable layer under the following conditions to obtain sample 1 as a gas barrier film via manufacturing method No. 1.

In preparation of sample 1, an adhesion film, a ceramic film and a protective film were continuously formed employing three atmospheric pressure plasma discharge treatment apparatuses shown in Fig. 8. In this case, employed are conveyance guide rollers AR1 - AR7 brought into contact with the resin film front surface (surface A) which have a diameter of 70 mm, and the surface of the core metal was covered with a resin. Also employed are conveyance guide rollers BR1 - BR3 brought into contact with the resin film back surface (surface B) which have a diameter of 40 mm, and the surface of the core metal was also covered with a resin. In addition, the conveyance tension was controlled at 90 N/m.

Atmospheric plasma discharge treatment apparatuses CS1 - CS3 shown in Fig. 11 were operated under the following conditions.

(Formation of adhesion layer: CS1)

<Adhesion layer; thin film forming gas composition>

| Discharge gas: Nitrogen gas | 94.85% by volume |
| Reactive gas: Hexamethyldisiloxane | 0.15% by volume |
| Addition gas: Oxygen gas | 5.0% by volume |

<Adhesion layer film formation condition>

On the first electrode side:

Power supply type: 100 kHz (continuous mode) PHF-6k, manufactured by Haiden Laboratory Inc.
Frequency: 100 kHz
Power density: 10 W/cm$^2$ (at a voltage Vp of 7 kV) Electrode temperature: 120 °C

On the second electrode side:

Power supply type: 13.56 MHz CF-5000-13M, manufactured by Pearl Kogyo Co., Ltd.
Frequency: 13.56 MHz
Power density: 5 W/cm$^2$ (at a voltage Vp of 1 kV)
Electrode temperature: 90 °C

(Formation of ceramic layer: CS2)

<Ceramic layer; thin film forming gas composition>

| Discharge gas: Nitrogen gas | 94.99% by volume |

(continued)

| | |
|---|---|
| Reactive gas: Tetraethoxysilane | 0.01% by volume |
| Addition gas: Oxygen gas | 5.0% by volume |

<Ceramic layer film formation condition>

On the first electrode side:

Power supply type: 100 kHz (continuous mode) PHF-6k, manufactured by Haiden Laboratory Inc.
Frequency: 100 kHz
Power density: 10 W/cm$^2$ (at a voltage Vp of 7 kV) Electrode temperature: 120 °C

On the second electrode side:

Power supply type: 13.56 MHz CF-5000-13M, manufactured by Pearl Kogyo Co., Ltd.
Frequency: 13.56 MHz
Power density: 10 W/cm$^2$ (at a voltage Vp of 2 kV) Electrode temperature: 90 °C

(Formation of protective layer: CS3)

<Protective layer; thin film forming gas composition>

| | |
|---|---|
| Discharge gas: Nitrogen gas | 94.5% by volume |
| Reactive gas: Hexamethyldisiloxane | 0.5% by volume |
| Addition gas: Oxygen gas | 5.0% by volume |

<Protective layer film formation condition>

On the first electrode side:

Power supply type: 100 kHz (continuous mode) PHF-6k, manufactured by Haiden Laboratory Inc.
Frequency: 100 kHz
Power density: 10 W/cm$^2$ (at a voltage Vp of 7 kV)
Electrode temperature: 120 °C

On the second electrode side:

Power supply type: 13.56 MHz CF-5000-13M, manufactured by Pearl Kogyo Co., Ltd.
Frequency: 13.56 MHz
Power density: 5 W/cm$^2$ (at a voltage Vp of 1 kV)
Electrode temperature: 90 °C

[Preparation of samples 2 - 12]

Samples 2 - 12 (preparation method Nos. 2 - 12) were prepared similarly to the above-described sample 1, except that guide roller AR brought into contact with front surface (surface A) and guide roller BR brought into contact with back surface (surface B) were changed as shown in Table 1.

«Evaluation of gas barrier film»

Each sample prepared above was evaluated as described below.

[Measurement of water vapor permeation rate]

The water vapor permeation rate of each sample was measured in accordance with JIS K 7129 (1992) employing a water vapor permeation analyzer PERMATRON-W 3/33 MG module (g/m$^2$/day at 40 °C and 90%RH), manufactured by Mocon Inc.

[Measurement of oxygen permeation rate]

The oxygen permeation rate of each sample was measured in accordance with JIS K 7126 (1987) employing an oxygen permeation analyzer OX-TRAN 2/21 ML module {ml/m$^2$/day/atm at 22 °C and 0%RH(Dry)}, manufactured by Mocon Inc.

[Evaluation of uniformity of thin film]

Each sample described above was cut into a sample size of 50 cm in width and 10 cm in length to measure film thicknesses at 100 random portions of the film employing a thin-film measurement system, manufactured by FILMETRICS, Inc., and film thickness variability coefficient was determined in accordance with the following equation by obtaining maximum film thickness MAX, minimum film thickness MIN and average film thickness AVE. This value was designated as uniformity of thin film.

```
Film thickness variability coefficient = {(Maximum film
thickness MAX - Minimum film thickness MIN)/ Average film
thickness AVE} x 100(%)
```

Results obtained via the above-described equation are shown in Table 1.

Table 1

| Preparation method No. | Minimum curvature radius of conveyed substrate (mm) | | Convey-ance tension (N/m) | Evaluation of gas barrier | | Uniformity of thin film (%) | Re-marks |
|---|---|---|---|---|---|---|---|
| | Surface A (front surface) | Surface B (back surface) | | Water vapor permea-tion (g/m$^2$/ day) | Oxygen permea-tion (ml/m$^2$/ day/atm) | | |
| 1 | 35 | 30 | 90 | 0.97 | 0.68 | 1.1 | Comp. |
| 2 | 35 | 37.5 | 90 | 0.55 | 0.48 | 1.0 | Comp. |
| 3 | 62.5 | 20 | 90 | 0.36 | 0.31 | 1.0 | Comp. |
| 4 | 62.5 | 30 | 90 | 0.21 | 0.19 | 1.0 | Comp. |
| 5 | 62.5 | 37.5 | 90 | 0.19 | 0.17 | 0.9 | Comp. |
| 6 | 75 | 20 | 90 | 0.33 | 0.26 | 1.0 | Comp. |
| 7 | 75 | 30 | 90 | 0.19 | 0.16 | 0.9 | Comp. |
| 8 | 75 | 37.5 | 90 | 0.07 | 0.05 | 0.9 | Inv. |
| 9 | 100 | 50 | 90 | 0.03 | 0.03 | 0.9 | Inv. |
| 10 | 125 | 62.5 | 90 | 0.03 | 0.02 | 0.9 | Inv. |
| 11 | 175 | 75 | 90 | 0.03 | 0.02 | 0.9 | Inv. |

(continued)

| Preparation method No. | Minimum curvature radius of conveyed substrate (mm) | | Convey-ance tension (N/m) | Evaluation of gas barrier | | Uniformity of thin film (%) | Re-marks |
|---|---|---|---|---|---|---|---|
| | Surface A (front surface) | Surface B (back surface) | | Water vapor permea-tion (g/m²/ day) | Oxygen permea-tion (ml/m²/ day/atm) | | |
| 12 | 250 | 100 | 90 | 0.03 | 0.02 | 0.9 | Inv. |
| Comp.: Comparative example<br>Inv.: Present invention | | | | | | | |

As is clear from the results described in Table 1, it is to be understood that samples prepared by a method with the condition under which the curvature radius of surface A and surface B each of the continuously conveyed sample is specified by the present invention exhibit excellent gas barrier together with a low water vapor permeation rate and a low oxygen permeation rate in comparison to those of Comparative examples.

Example 4

Samples 13 - 20 (preparation method Nos. 13 - 20) were prepared similarly to sample 9 (preparation method No. 9) described in Example 3, except that conveyance tension of the resin film was changed as shown in Table 2.
Next, similarly to the method described in Example 1, the water vapor permeation rate and the oxygen permeation rate were measured, and the uniformity of thin film was evaluated. The results are shown in Table 2.

Table 2

| Preparation method No. | Minimum curvature radius of conveyed substrate (mm) | | Convey-ance tension (N/m) | Evaluation of gas barrier | | Uniformity of thin film (%) | Remarks |
|---|---|---|---|---|---|---|---|
| | Surface A (front surface) | Surface B (back surface) | | Water vapor permeation (g/m²/ day) | Oxygen permeation (ml/m²/day/atm) | | |
| 13 | 100 | 50 | 40 | 0.04 | 0.04 | 1.5 | Inv. |
| 14 | 100 | 50 | 80 | 0.03 | 0.02 | 1.0 | Inv. |
| 15 | 100 | 50 | 120 | 0.02 | 0.02 | 0.9 | Inv. |
| 16 | 100 | 50 | 160 | 0.03 | 0.03 | 0.9 | Inv. |
| 17 | 100 | 50 | 200 | 0.03 | 0.03 | 0.9 | Inv. |
| 18 | 100 | 50 | 240 | 0.04 | 0.04 | 0.9 | Inv. |
| 19 | 100 | 50 | 280 | 0.05 | 0.06 | 0.9 | Inv. |
| 20 | 100 | 50 | 320 | 0.07 | 0.08 | 0.9 | Inv. |
| Inv.: Present invention | | | | | | | |

As is clear from the results described in Table 2, it is to be understood that gas barrier films prepared by adjusting the conveyance tension within the range of approximately 50 - 200 N/m exhibit excellent uniformity of thin film together with a low water vapor permeation rate and a low oxygen permeation rate.

Example 5

Each sample was prepared similarly to preparation of each sample described in Example 3, except that a contact conveyance system atmospheric pressure plasma discharge treatment apparatus was replaced by a non-contact conveyance system atmospheric pressure plasma discharge treatment apparatus described in Fig. 12, and a curvature radius of the non-contact conveyance system was changed in the same condition as in Example 3. Similarly to the method described in Example 3, a water vapor permeation rate and an oxygen permeation rate and uniformity of the coated film were evaluated. As the result, it was confirmed that samples prepared by a method with the condition under which the curvature radius of surface A and surface B each of the continuously conveyed sample is specified by the present invention exhibited excellent gas barrier together with a low water vapor permeation rate and a low oxygen permeation rate in comparison to those of Comparative examples.

**Claims**

1. A plasma discharge treatment apparatus by which a surface of a continuously conveyed substrate is plasma-discharge-treated at atmospheric pressure or approximately atmospheric pressure,
comprising a pair of facing electrodes and a discharge section formed between the facing electrodes,
the plasma discharge treatment apparatus also comprising a turned-back conveyance device by which after the substrate passes through the discharge section while the substrate is brought into contact with one electrode of the facing electrodes to conduct plasma discharge treatment in the discharge section, the substrate is conveyed into the discharge section again while the substrate is brought into contact with the other electrode of the facing electrodes to conduct plasma discharge treatment; a device of supplying a reactive gas into a space sandwiched by the substrate passing through the discharge section in a reciprocating manner at atmospheric pressure or approximately atmospheric pressure; a device of emitting an exhaust gas after treatment; and a device of applying a voltage between the facing electrodes to generate plasma discharge,
wherein the turned-back conveyance device is composed of a non-contact conveyance system supporting a continuously running web by blowing gas from a blowing outlet.

2. A plasma discharge treatment apparatus by which a surface of a continuously conveyed substrate is plasma-discharge-treated at atmospheric pressure or approximately atmospheric pressure,
comprising a plurality of pairs of facing electrodes and a plurality of discharge sections each formed between the facing electrodes each,
the plasma discharge treatment apparatus also comprising a plurality of turned-back conveyance devices each by which after the substrate passes through each of the discharge sections while the substrate is brought into contact with one electrode of the facing electrodes each to conduct plasma discharge treatment in a plurality of the discharge sections, the substrate is conveyed into each of the discharge sections again while the substrate is brought into contact with the other electrode of the facing electrodes each to conduct plasma discharge treatment; each device of supplying a reactive gas into a space sandwiched by the substrate passing through each of the discharge sections in a reciprocating manner at atmospheric pressure or approximately atmospheric pressure; each device of emitting an exhaust gas after treatment; and each device of applying a voltage between the facing electrodes each to generate plasma discharge,
wherein each of the turned-back conveyance devices is composed of a non-contact conveyance system supporting a continuously running web by blowing gas from a blowing outlet.

3. A plasma discharge treatment apparatus by which a surface of a continuously conveyed substrate is plasma-discharge-treated at atmospheric pressure or approximately atmospheric pressure,
equipped with a pair of facing electrodes and a discharge section formed between the facing electrodes,
the plasma discharge treatment apparatus also comprising a turned-back conveyance device by which after the substrate passes through the discharge section while the substrate is brought into contact with one electrode of the facing electrodes to conduct plasma discharge treatment in the discharge section, the substrate is conveyed into the discharge section again while the substrate is brought into contact with the other electrode of the facing electrodes to conduct plasma discharge treatment; a device of supplying a reactive gas into a space sandwiched by the substrate passing through the discharge section in a reciprocating manner at atmospheric pressure or approximately atmospheric pressure; a device of emitting an exhaust gas after treatment; and a device of applying a voltage between the facing electrodes to generate plasma discharge,
wherein the turned-back conveyance device is composed of a non-contact conveyance system supporting a continuously running web by blowing gas from a blowing outlet.

4. The plasma discharge treatment apparatus of any one of Claims 1 - 3,
wherein the facing electrodes are rotatable roll electrodes.

# FIG. 1

# FIG. 2

# FIG. 3

# FIG. 4

FIG. 5

EP 2 278 047 A1

## FIG. 6

## FIG. 7

FIG. 8

## FIG. 9

## FIG. 10

FIG. 11

FIG. 12

## FIG. 13

35A

35B

35a

## FIG. 14

36B

36A

36a

Europäisches
Patentamt

European
Patent Office

Office européen
des brevets

# EUROPEAN SEARCH REPORT

**Application Number**

EP 10 16 6425

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2003/072891 A1 (MURAKAMI TAKASHI [JP] ET AL) 17 April 2003 (2003-04-17)<br>* figures 1,2 *<br>* paragraph [0008] *<br>* paragraph [0044] *<br>* paragraph [0109] - paragraph [0110] *<br>* paragraph [0114] *<br>----- | 1-4 | INV.<br>C23C16/54<br>C23C16/50<br>H01J37/32<br>B65H23/24 |
| Y | US 4 182 472 A (PEEKNA ANDRES [US]) 8 January 1980 (1980-01-08)<br>* abstract *<br>* figures 1,2 *<br>* column 1, line 57 - column 4, line 21 *<br>----- | 1-4 | |
| A | WO 02/44635 A2 (MEGTEC SYS INC [US]) 6 June 2002 (2002-06-06)<br>* abstract *<br>* page 3, line 11 - page 5, line 27 *<br>* figure 1 *<br>----- | 1-4 | |
| A | EP 0 249 414 A2 (FORD JOHN WILLIAM [GB]; DYER MAURICE JOHN [GB]) 16 December 1987 (1987-12-16)<br>* abstract *<br>* figures 1,2 *<br>* column 3, line 51 - column 5, line 20 *<br>----- | 1-4 | TECHNICAL FIELDS SEARCHED (IPC)<br><br>H01J<br>C23C<br>B65H |

The present search report has been drawn up for all claims

| Place of search | Date of completion of the search | Examiner |
|---|---|---|
| The Hague | 20 December 2010 | Hochstrasser, M |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 10 16 6425

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2010

| Patent document cited in search report | | | Publication date | Patent family member(s) | | | Publication date |
|---|---|---|---|---|---|---|---|
| US 2003072891 | A1 | | 17-04-2003 | CN | 1407131 | A | 02-04-2003 |
| | | | | CN | 1680620 | A | 12-10-2005 |
| | | | | JP | 2002322558 | A | 08-11-2002 |
| | | | | KR | 20020082760 | A | 31-10-2002 |
| | | | | TW | 581819 | B | 01-04-2004 |
| | | | | US | 2005281960 | A1 | 22-12-2005 |
| US 4182472 | A | | 08-01-1980 | CA | 1078423 | A1 | 27-05-1980 |
| | | | | DE | 2925985 | A1 | 24-01-1980 |
| | | | | FR | 2430908 | A1 | 08-02-1980 |
| | | | | GB | 2025346 | A | 23-01-1980 |
| | | | | IT | 1120475 | B | 26-03-1986 |
| | | | | JP | 1209038 | C | 29-05-1984 |
| | | | | JP | 55011500 | A | 26-01-1980 |
| | | | | JP | 58039746 | B | 01-09-1983 |
| | | | | SE | 439473 | B | 17-06-1985 |
| | | | | SE | 7905015 | A | 14-01-1980 |
| WO 0244635 | A2 | | 06-06-2002 | AU | 9509401 | A | 11-06-2002 |
| | | | | CA | 2428854 | A1 | 06-06-2002 |
| | | | | EP | 1337798 | A2 | 27-08-2003 |
| | | | | JP | 2004514630 | T | 20-05-2004 |
| | | | | MX | PA03004739 | A | 19-08-2003 |
| | | | | US | 6505792 | B1 | 14-01-2003 |
| EP 0249414 | A2 | | 16-12-1987 | GB | 2194918 | A | 23-03-1988 |
| | | | | US | 4824002 | A | 25-04-1989 |

**EP 2 278 047 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2251429 A
- JP 2003171770 A
- JP 53012953 A
- JP 58217344 A
- US 6268695 B
- JP 59151110 A
- JP 59151112 A
- JP 1105738 A
- JP 10154598 A
- JP 2003049272 A
- WO 02048428 A
- JP 2004068143 A
- JP 11016696 A
- JP 2000301655 A